(19) Europäisches Patentamt / European Patent Office / Office européen des brevets

(11) **EP 4 272 122 B1**

(12) **EUROPEAN PATENT SPECIFICATION**

(45) Date of publication and mention
of the grant of the patent:
**28.05.2025   Bulletin 2025/22**

(21) Application number: **21722058.1**

(22) Date of filing: **07.04.2021**

(51) International Patent Classification (IPC):
*G06N 3/04* (2023.01)          *G06N 3/063* (2023.01)
*G11C 11/54* (2006.01)        *G06N 3/044* (2023.01)
*G06N 3/045* (2023.01)        *G06N 3/048* (2023.01)
*G06N 3/065* (2023.01)        *G11C 16/04* (2006.01)
*G11C 16/10* (2006.01)        *G11C 16/26* (2006.01)
*H03M 1/46* (2006.01)          *H03M 1/54* (2006.01)
*H03M 3/00* (2006.01)

(52) Cooperative Patent Classification (CPC):
**G11C 11/54; G06N 3/044; G06N 3/045;
G06N 3/048; G06N 3/065; G11C 16/10;**
G11C 16/04; G11C 16/26; H03M 1/46; H03M 1/54;
H03M 3/458

(86) International application number:
**PCT/US2021/026284**

(87) International publication number:
**WO 2022/146468 (07.07.2022 Gazette 2022/27)**

(54) **DIGITAL OUTPUT MECHANISMS FOR ANALOG NEURAL MEMORY IN A DEEP LEARNING ARTIFICIAL NEURAL NETWORK**

DIGITALE AUSGABEMECHANISMEN FÜR ANALOGEN NEURONALEN SPEICHER IN EINEM KÜNSTLICHEN NEURONALEN TIEFENLERNNETZ

MÉCANISMES DE SORTIE NUMÉRIQUE POUR UNE MÉMOIRE NEURONALE ANALOGIQUE DANS UN RÉSEAU NEURONAL ARTIFICIEL À APPRENTISSAGE PROFOND

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.01.2021   US 202163133270 P
31.03.2021   US 202117219352**

(43) Date of publication of application:
**08.11.2023   Bulletin 2023/45**

(60) Divisional application:
**25162162.9 / 4 542 863**

(73) Proprietor: **Silicon Storage Technology, Inc.**
**San Jose, CA 95134 (US)**

(72) Inventors:
• **TRAN, Hieu Van**
 **San Jose, California 95135 (US)**
• **VU, Thuan**
 **San Jose, California 95138 (US)**
• **TRINH, Stephen**
 **San Jose, California 95148 (US)**
• **HONG, Stanley**
 **San Jose, California 95131 (US)**
• **LE, Nghia**
 **Ho Chin Minh (VN)**
• **LE, Toan**
 **Ho Chin Minh (VN)**
• **PHAM, Hien**
 **Ho Chi Minh (VN)**

(74) Representative: **Betten & Resch**
**Patent- und Rechtsanwälte PartGmbB**
**Maximiliansplatz 14**
**80333 München (DE)**

(56) References cited:
**US-A1- 2005 220 185     US-A1- 2020 233 482**
**US-A1- 2020 349 421**

**(Cont. next page)**

- JIANG HONGWU ET AL: "MINT: Mixed-Precision RRAM-Based IN-Memory Training Architecture", 2019 IEEE INTERNATIONAL SYMPOSIUM ON CIRCUITS AND SYSTEMS (ISCAS), IEEE, 12 October 2020 (2020-10-12), pages 1 - 5, XP033933554, ISSN: 2158-1525, ISBN: 978-1-7281-3320-1, [retrieved on 20200828], DOI: 10.1109/ISCAS45731.2020.9181020

## Description

### PRIORITY CLAIMS

This application claims priority to U.S. Provisional Patent Application No. 63/133,270, filed on January 1, 2021, and titled, "Input and Digital Output Mechanisms for Analog Neural Memory in a Deep Learning Artificial Neural Network," and, U.S. Patent Application No. 17/219,352, filed on March 31, 2021, and titled, "Digital Output Mechanisms for Analog Neural Memory in a Deep Learning Artificial Neural Network."

### FIELD OF THE INVENTION

Numerous embodiments are disclosed of output mechanisms for reading or verifying a non-volatile memory cell within a vector-by-matrix multiplication (VMM) array in an artificial neural network.

US 20200233482 A1 discloses that numerous embodiments of power management techniques are disclosed for various operations involving one or more vector-by-matrix multiplication (VMM) arrays within an artificial neural network.

US 20200349421 A1 discloses that configurable input blocks and output blocks and physical layouts are disclosed for analog neural memory systems that utilize non-volatile memory cells. An input block can be configured to support different numbers of arrays arranged in a horizontal direction, and an output block can be configured to support different numbers of arrays arranged in a vertical direction. Adjustable components are disclosed for use in the configurable input blocks and output blocks.

JIANG HONGWUET AL: "MINT: Mixed-Precision RRAM-Based IN-Memory Training Architecture", 2019 IEEE INTERNATIONAL SYMPOSIUM ON CIRCUITS AND SYSTEMS (ISCAS), IEEE, 12 October 2020 (2020-10-12), pages 1-5, ISSN: 2158-1525, DOI:10.1109/ ISCAS45731.2020.91810201SBN: 978-1-7281-3320-1 discloses VMM arrays.

US 2005/220185 A1 discloses adaptive interconnect architectures.

### BACKGROUND OF THE INVENTION

Artificial neural networks mimic biological neural networks (the central nervous systems of animals, in particular the brain) and are used to estimate or approximate functions that can depend on a large number of inputs and are generally unknown. Artificial neural networks generally include layers of interconnected "neurons" which exchange messages between each other.

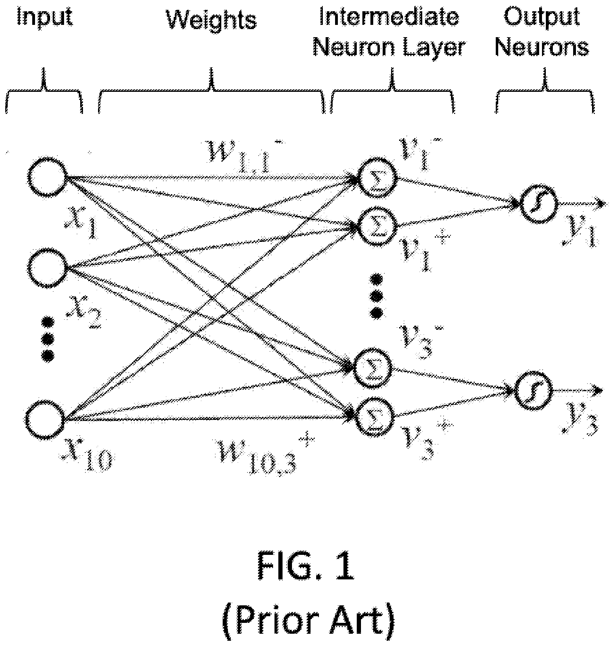

Figure 1 illustrates an artificial neural network, where the circles represent the inputs or layers of neurons. The connections (called synapses) are represented by arrows and have numeric weights that can be tuned based on experience. This makes neural networks adaptive to inputs and capable of learning. Typically, neural networks include a layer of multiple inputs. There are typically one or more intermediate layers of neurons, and an output layer of neurons that provide the output of the neural network. The neurons at each level individually or collectively make a decision based on the received data from the synapses.

One of the major challenges in the development of artificial neural networks for high-performance information processing is a lack of adequate hardware technology. Indeed, practical neural networks rely on a very large number of synapses, enabling high connectivity between neurons, i.e. a very high computational parallelism. In principle, such complexity can be achieved with digital supercomputers or specialized graphics processing unit clusters. However, in addition to high cost, these approaches also suffer from mediocre energy efficiency as compared to biological networks, which consume much less energy primarily because they perform low-precision analog computation. CMOS analog circuits have been used for artificial neural networks, but most CMOS-implemented synapses have been too bulky given the high number of neurons and synapses.

Applicant previously disclosed an artificial (analog) neural network that utilizes one or more non-volatile memory arrays as the synapses in U.S. Patent Application No. 15/594,439. The non-volatile memory arrays operate as an analog neuromorphic memory. The neural network device includes a first plurality of synapses configured to receive a first plurality of inputs and to generate therefrom a first plurality of outputs, and a first plurality of neurons configured to receive the first plurality of outputs. The first plurality of synapses includes a plurality of memory cells, wherein each of the memory cells includes spaced apart source and drain regions formed in a semiconductor substrate with a channel region extending there between, a floating gate disposed over and insulated from a first portion of the channel region and a non-floating gate disposed over and insulated from a second portion of the channel region. Each of the plurality of memory cells is configured to store a weight value corresponding to a number of electrons on the floating gate. The plurality of memory cells is configured to multiply the first plurality of inputs by the stored weight values to generate the first plurality of outputs.

Each non-volatile memory cells used in the analog neuromorphic memory system must be erased and programmed to hold a very specific and precise amount of charge, i.e., the number of electrons, in the floating gate. For example, each floating gate must hold one of N different values, where N is the number of different weights that can be indicated by each cell. Examples of N include 16, 32, 64, 128, and 256.

Because the outputs of one VMM often will need to be applied to another VMM, it is desirable in VMM systems to be able to convert an output of a VMM into bits and to apply input bits to another VMM. A challenge then emerges as to how to best implement the bit coding mechanism for the VMM system.

What is needed are improved input and output blocks for a VMM for performing programming, verifying, and reading.

## SUMMARY OF THE INVENTION

The invention is defined by the features of independent claims. Preferred embodiments are set out in the dependent claims.

## BRIEF DESCRIPTION OF THE DRAWINGS

Figure 1 is a diagram that illustrates an artificial neural network.

Figure 2 depicts a prior art split gate flash memory cell.

Figure 3 depicts another prior art split gate flash memory cell.

Figure 4 depicts another prior art split gate flash memory cell.

Figure 5 depicts another prior art split gate flash memory cell.

Figure 6 is a diagram illustrating the different levels of an exemplary artificial neural network utilizing one or more non-volatile memory arrays.

Figure 7 is a block diagram illustrating a vector-by-matrix multiplication system.

Figure 8 is a block diagram illustrates an exemplary artificial neural network utilizing one or more vector-by-matrix multiplication systems.

Figure 9 depicts another embodiment of a vector-by-matrix multiplication system.

Figure 10 depicts another embodiment of a vector-by-matrix multiplication system.

Figure 11 depicts another embodiment of a vector-by-matrix multiplication system.

Figure 12 depicts another embodiment of a vector-by-matrix multiplication system.

Figure 13 depicts another embodiment of a vector-by-matrix multiplication system.

Figure 14 depicts a prior art long short-term memory system.

Figure 15 depicts an exemplary cell for use in a long short-term memory system.

Figure 16 depicts an embodiment of the exemplary cell of Figure 15.

Figure 17 depicts another embodiment of the exemplary cell of Figure 15.

Figure 18 depicts a prior art gated recurrent unit system.

Figure 19 depicts an exemplary cell for use in a gated recurrent unit system.

Figure 20 depicts an embodiment of the exemplary cell of Figure 19.

Figure 21 depicts another embodiment of the exemplary cell of Figure 19.

Figure 22A depicts an embodiment of a method of programming a non-volatile memory cell.

Figure 22B depicts another embodiment of a method of programming a non-volatile memory cell.

Figure 23 depicts an embodiment of a coarse programming method.

Figure 24 depicts exemplary pulses used in the programming of a non-volatile memory cell.

Figure 25 depicts exemplary pulses used in the programming of a non-volatile memory cell.

Figure 26A and 26B depicts calibration algorithms for the programming of a non-volatile memory cell that adjusts the programming parameters based on slope characteristics of the cell.

Figure 27 depicts a circuit used in the calibration algorithm of Figure 26.

Figure 28 depicts a calibration algorithm for the programming of a non-volatile memory cell.

Figure 29 depicts a circuit used in the calibration algorithm of Figure 28.

Figure 30 depicts an exemplary progression of voltages applied to the control gate of a non-volatile memory cell during a programming operation.

Figure 31 depicts an exemplary progression of voltages applied to the control gate of a non-volatile memory cell during a programming operation.

Figure 32 depicts a system for applying programming voltages during the programming of a non-volatile memory cell within a vector-by-multiplication matrix system.

Figure 33 depicts a charge summer circuit.

Figure 34 depicts a current summer circuit.

Figure 35 depicts a digital summer circuit.

Figure 36A depicts an embodiment of an integrating analog-to-digital converter for a neuron output.

Figure 36B depicts a graph showing the voltage output over time of the integrating analog-to-digital converter of Figure 36A.

Figure 36C depicts another embodiment of an integrating analog-to-digital converter for a neuron output.

Figure 36D depicts a graph showing the voltage output over time of the integrating analog-to-digital converter of Figure 36C.

Figure 36E depicts another embodiment of an integrating analog-to-digital converter for a neuron output.

Figure 36F depicts another embodiment of an integrating analog-to-digital converter for a neuron output.

Figures 37A and 37B depict a successive approximation analog-to-digital converter for a neuron output.

Figure 38 depicts an embodiment of a sigma delta analog-to-digital converter.

Figure 39 depicts an output block.

Figure 40 depicts another embodiment of a vector-by-matrix multiplication system.

Figure 41 depicts another embodiment of a vector-by-matrix multiplication system.

Figure 42 depicts another embodiment of a vector-by-matrix multiplication system.

Figure 43 depicts a block diagram of a vector-by-matrix multiplication system

Figure 44 depicts a digital summer.

Figure 45 depicts an output block.

Figure 46 depicts an embodiment of a current-to-voltage converter.

Figure 47 depicts another embodiment of a current-to-voltage converter.

Figure 48 depicts another embodiment of a current-to-voltage converter.

Figure 49A depicts another embodiment of a current-to-voltage converter.

Figure 49B depicts an embodiment of a loss-less variable resistor.

Figure 50 depicts another embodiment of a current-to-voltage converter.

Figure 51 depicts another embodiment of a current-to-voltage converter.

Figure 52A, 52B, and 52C depicts embodiments of a hybrid serial converter.

**DETAILED DESCRIPTION OF THE INVENTION**

The artificial neural networks of the present invention utilize a combination of CMOS technology and non-volatile memory arrays.

Non-Volatile Memory Cells

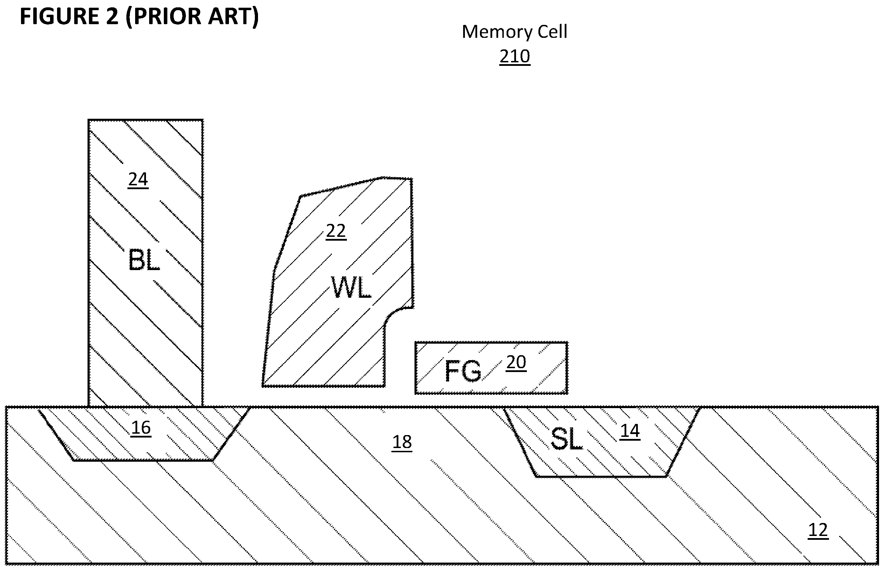

Digital non-volatile memories are well known. For example, U.S. Patent 5,029,130 ("the '130 patent"), discloses an array of split gate non-volatile memory cells, which are a type of flash memory cells. Such a memory cell 210 is shown in Figure 2. Each memory cell 210 includes source region 14 and drain region 16 formed in semiconductor substrate 12, with channel region 18 there between. Floating gate 20 is formed over and insulated from (and controls the conductivity of) a first portion of the channel region 18, and over a portion of the source region 14. Word line terminal 22 (which is typically coupled to a word line) has a first portion that is disposed over and insulated from (and controls the conductivity of) a second portion of the channel region 18, and a second portion that extends up and over the floating gate 20. The floating gate 20 and word line terminal 22 are insulated from the substrate 12 by a gate oxide. Bitline 24 is coupled to drain region 16.

Memory cell 210 is erased (where electrons are removed from the floating gate) by placing a high positive voltage on the word line terminal 22, which causes electrons on the floating gate 20 to tunnel through the intermediate insulation from the floating gate 20 to the word line terminal 22 via Fowler-Nordheim (FN) tunneling.

Memory cell 210 is programmed by source side injection (SSI) with hot electrons (where electrons are placed on the floating gate) by placing a positive voltage on the word line terminal 22, and a positive voltage on the source region 14. Electron current will flow from the drain region 16 towards the source region 14. The electrons will accelerate and become heated when they reach the gap between the word line terminal 22 and the floating gate 20. Some of the heated electrons will be injected through the gate oxide onto the floating gate 20 due to the attractive electrostatic force from the floating gate 20.

Memory cell 210 is read by placing positive read voltages on the drain region 16 and word line terminal 22 (which turns on the portion of the channel region 18 under the word line terminal). If the floating gate 20 is positively charged (i.e. erased of electrons), then the portion of the channel region 18 under the floating gate 20 is turned on as well, and current will flow across the channel region 18, which is sensed as the erased or "1" state. If the floating gate 20 is negatively charged (i.e. programmed with electrons), then the portion of the channel region under the floating gate 20 is mostly or entirely turned off, and current will not flow (or there will be little flow) across the channel region 18, which is sensed as the programmed or "0" state.

Table No. 1 depicts typical voltage and current ranges that can be applied to the terminals of memory cell 110 for performing read, erase, and program operations:

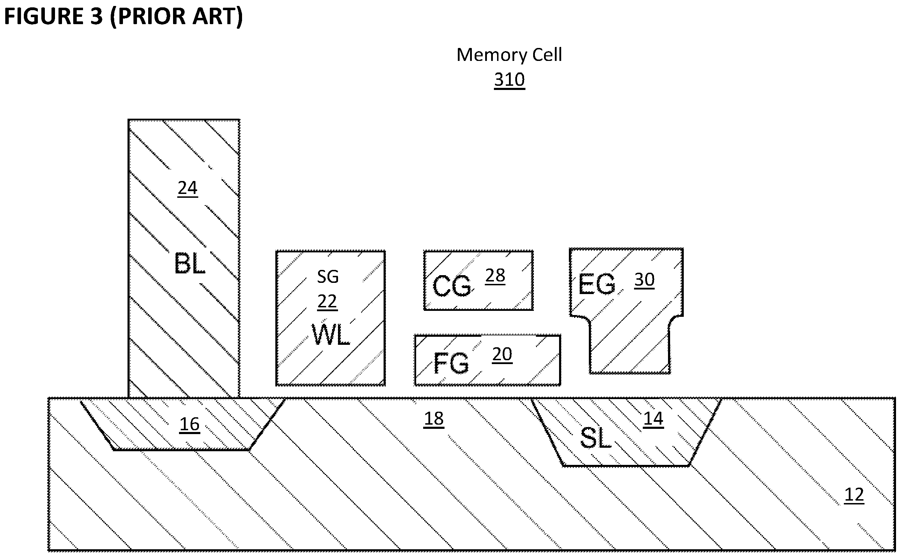

**Table No. 1: Operation of Flash Memory Cell 210 of Figure 3**

|  | WL | BL | SL |
|---|---|---|---|
| Read | 2-3V | 0.6-2V | 0V |
| Erase | ~11-13V | 0V | 0V |
| Program | 1-2V | 10.5-3μA | 9-10V |

Other split gate memory cell configurations, which are other types of flash memory cells, are known. For example, Figure 3 depicts a four-gate memory cell 310 comprising source region 14, drain region 16, floating gate 20 over a first portion of channel region 18, a select gate 22 (typically coupled to a word line, WL) over a second portion of the channel region 18, a control gate 28 over the floating gate 20, and an erase gate 30 over the source region 14. This configuration is described in U.S. Patent 6,747,310. Here, all gates are non-floating gates except floating gate 20, meaning that they are electrically connected or connectable to a voltage source. Programming is performed by heated electrons from the channel region 18 injecting themselves onto the floating gate 20. Erasing is performed by electrons tunneling from the floating gate 20 to the erase gate 30.

Table No. 2 depicts typical voltage and current ranges that can be applied to the terminals of memory cell 310 for performing read, erase, and program operations:

**Table No. 2: Operation of Flash Memory Cell 310 of Figure 3**

|  | WL/SG | BL | CG | EG | SL |
|---|---|---|---|---|---|
| Read | 1.0-2V | 0.6-2V | 0-2.6V | 0-2.6V | 0V |
| Erase | -0.5V/0V | 0V | 0V/-8V | 8-12V | 0V |
| Program | 1V | 0.1-1μA | 8-11V | 4.5-9V | 4.5-5V |

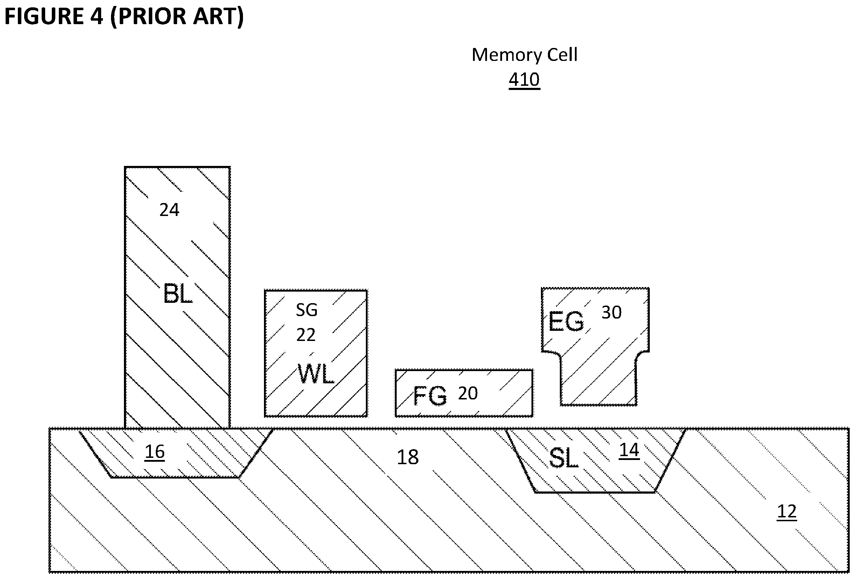

Figure 4 depicts a three-gate memory cell 410, which is another type of flash memory cell. Memory cell 410 is identical to the memory cell 310 of Figure 3 except that memory cell 410 does not have a separate control gate. The erase operation (whereby erasing occurs through use of the erase gate) and read operation are similar to that of the Figure 3 except there is no control gate bias applied. The programming operation also is done without the control gate bias, and as a result, a higher voltage must be applied on the source line during a program operation to compensate for a lack of control gate bias.

Table No. 3 depicts typical voltage and current ranges that can be applied to the terminals of memory cell 410 for performing read, erase, and program operations:

**Table No. 3: Operation of Flash Memory Cell 410 of Figure 4**

|  | WL/SG | BL | EG | SL |
|---|---|---|---|---|
| Read | 0.7-2.2V | 0.6-2V | 0-2.6V | 0V |
| Erase | -0.5V/0V | 0V | 11.5V | 0V |
| Program | 1V | 0.2-3μA | 4.5V | 7-9V |

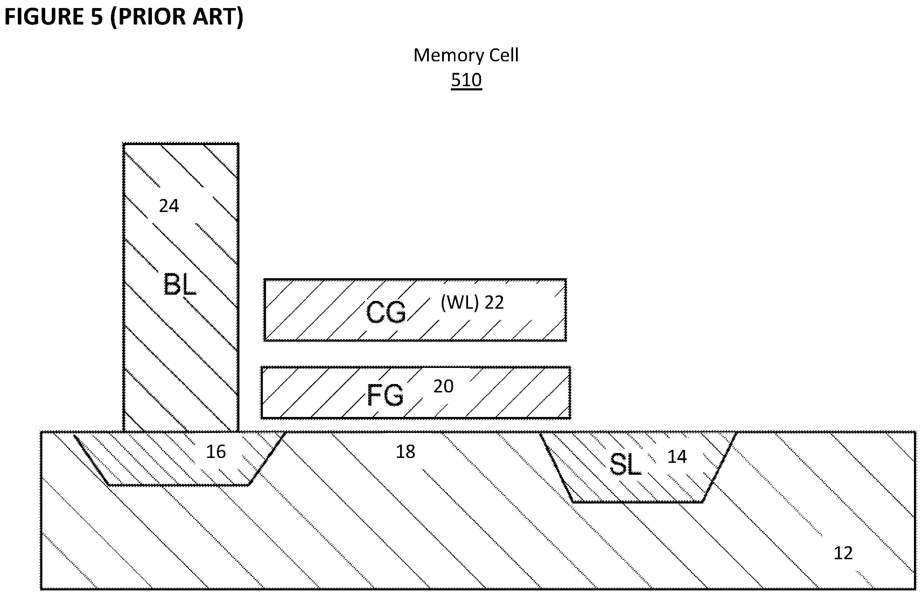

Figure 5 depicts stacked gate memory cell 510, which is another type of flash memory cell. Memory cell 510 is similar to memory cell 210 of Figure 2, except that floating gate 20 extends over the entire channel region 18, and control gate 22 (which here will be coupled to a word line) extends over floating gate 20, separated by an insulating layer (not shown). The erase is done by FN tunneling of electrons from FG to substrate, programming is by channel hot electron (CHE) injection at region between the channel 18 and the drain region 16, by the electrons flowing from the source region 14 towards to drain region 16 and read operation which is similar to that for memory cell 210 with a higher control gate voltage.

Table No. 4 depicts typical voltage ranges that can be applied to the terminals of memory cell 510 and substrate 12 for performing read, erase, and program operations:

7

**Table No. 4: Operation of Flash Memory Cell 510 of Figure 5**

|  | CG | BL | SL | Substrate |
|---|---|---|---|---|
| Read | 2-5V | 0.6 - 2V | 0V | 0V |
| Erase | -8 to -10V/0V | FLT | FLT | 8-10V / 15-20V |
| Program | 8-12V | 3-5V | 0V | 0V |

The methods and means described herein may apply to other non-volatile memory technologies such as FINFET split gate flash or stack gate flash memory, NAND flash, SONOS (silicon-oxide-nitride-oxide-silicon, charge trap in nitride), MONOS (metal-oxide-nitride-oxide-silicon, metal charge trap in nitride), ReRAM (resistive ram), PCM (phase change memory), MRAM (magnetic ram), FeRAM (ferroelectric ram), CT (charge trap) memory, CN (carbon-tube) memory, OTP (bi-level or multi-level one time programmable), and CeRAM (correlated electron ram), without limitation.

In order to utilize the memory arrays comprising one of the types of non-volatile memory cells described above in an artificial neural network, two modifications are made. First, the lines are configured so that each memory cell can be individually programmed, erased, and read without adversely affecting the memory state of other memory cells in the array, as further explained below. Second, continuous (analog) programming of the memory cells is provided.

Specifically, the memory state (i.e. charge on the floating gate) of each memory cell in the array can be continuously changed from a fully erased state to a fully programmed state, independently and with minimal disturbance of other memory cells. In another embodiment, the memory state (*i.e.,* charge on the floating gate) of each memory cell in the array can be continuously changed from a fully programmed state to a fully erased state, and vice-versa, independently and with minimal disturbance of other memory cells. This means the cell storage is analog or at the very least can store one of many discrete values (such as 16 or 64 different values), which allows for very precise and individual tuning of all the cells in the memory array, and which makes the memory array ideal for storing and making fine tuning adjustments to the synapsis weights of the neural network.

Neural Networks Employing Non-Volatile Memory Cell Arrays

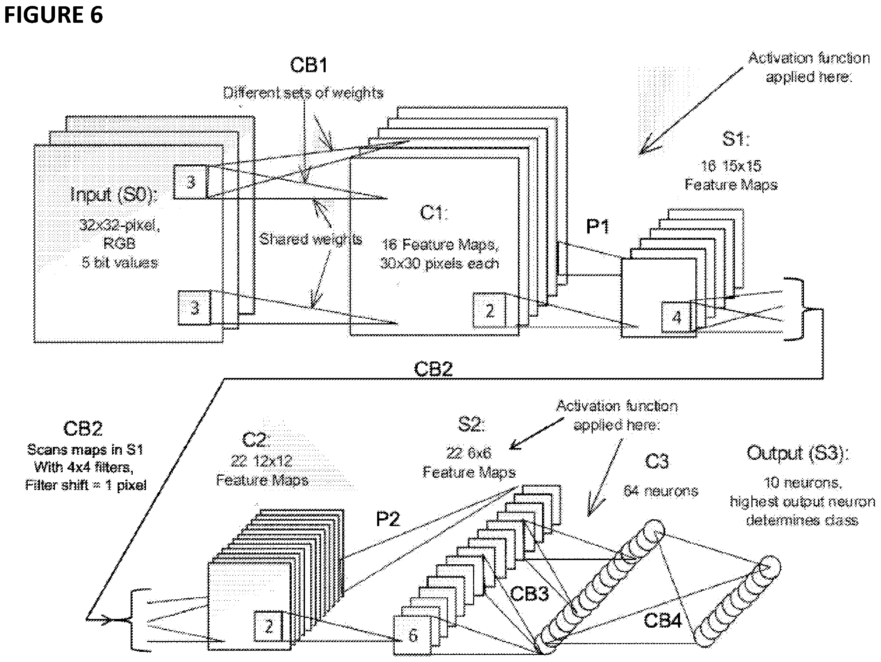

Figure 6 conceptually illustrates a non-limiting example of a neural network utilizing a non-volatile memory array of the present embodiments. This example uses the non-volatile memory array neural network for a facial recognition application, but any other appropriate application could be implemented using a non-volatile memory array based neural network.

S0 is the input layer, which for this example is a 32x32 pixel RGB image with 5 bit precision (i.e. three 32x32 pixel arrays, one for each color R, G and B, each pixel being 5 bit precision). The synapses CB1 going from input layer S0 to layer C1 apply different sets of weights in some instances and shared weights in other instances, and scan the input image with 3x3 pixel overlapping filters (kernel), shifting the filter by 1 pixel (or more than 1 pixel as dictated by the model). Specifically, values for 9 pixels in a 3x3 portion of the image (i.e., referred to as a filter or kernel) are provided to the synapses CB1, where these 9 input values are multiplied by the appropriate weights and, after summing the outputs of that multiplication, a single output value is determined and provided by a first synapse of CB1 for generating a pixel of one of the feature maps of layer C1. The 3x3 filter is then shifted one pixel to the right within input layer S0 (i.e., adding the column of three pixels on the right, and dropping the column of three pixels on the left), whereby the 9 pixel values in this newly positioned filter are provided to the synapses CB1, where they are multiplied by the same weights and a second single output value is determined by the associated synapse. This process is continued until the 3x3 filter scans across the entire 32x32 pixel image of input layer S0, for all three colors and for all bits (precision values). The process is then repeated using different sets of weights to generate a different feature map of layer C1, until all the features maps of layer C1 have been calculated.

In layer C1, in the present example, there are 16 feature maps, with 30x30 pixels each. Each pixel is a new feature pixel extracted from multiplying the inputs and kernel, and therefore each feature map is a two dimensional array, and thus in this example layer C1 constitutes 16 layers of two dimensional arrays (keeping in mind that the layers and arrays referenced herein are logical relationships, not necessarily physical relationships - i.e., the arrays are not necessarily oriented in physical two dimensional arrays). Each of the 16 feature maps in layer C1 is generated by one of sixteen different sets of synapse weights applied to the filter scans. The C1 feature maps could all be directed to different aspects of the same image feature, such as boundary identification. For example, the first map (generated using a first weight set, shared for all scans used to generate this first map) could identify circular edges, the second map (generated using a second weight set different from the first weight set) could identify rectangular edges, or the aspect ratio of certain features, and so on.

An activation function P1 (pooling) is applied before going from layer C1 to layer S1, which pools values from consecutive, non-overlapping 2x2 regions in each feature map. The purpose of the pooling function P1 is to average out the nearby location (or a max function can also be used), to reduce the dependence of the edge location for example and to reduce the data size before going to the next stage. At layer S1, there are 16 15x15 feature maps (i.e., sixteen different arrays of 15x15 pixels each). The synapses CB2 going from layer S1 to layer C2 scan maps in layer S1 with 4x4 filters, with a filter shift of 1 pixel. At layer C2, there are 22 12x12 feature maps. An activation function P2 (pooling) is applied before going from layer C2 to layer S2, which pools values from consecutive non-overlapping 2x2 regions in each feature map. At layer S2, there are 22 6x6 feature maps. An activation function (pooling) is applied at the synapses CB3 going from layer S2 to layer C3, where every neuron in layer C3 connects to every map in layer S2 via a respective synapse of CB3. At layer C3, there are 64 neurons. The synapses CB4 going from layer C3 to the output layer S3 fully connects C3 to S3, i.e. every neuron in layer C3 is connected to every neuron in layer S3. The output at S3 includes 10 neurons, where the highest output neuron determines the class. This output could, for example, be indicative of an identification or classification of the contents of the original image.

Each layer of synapses is implemented using an array, or a portion of an array, of non-volatile memory cells.

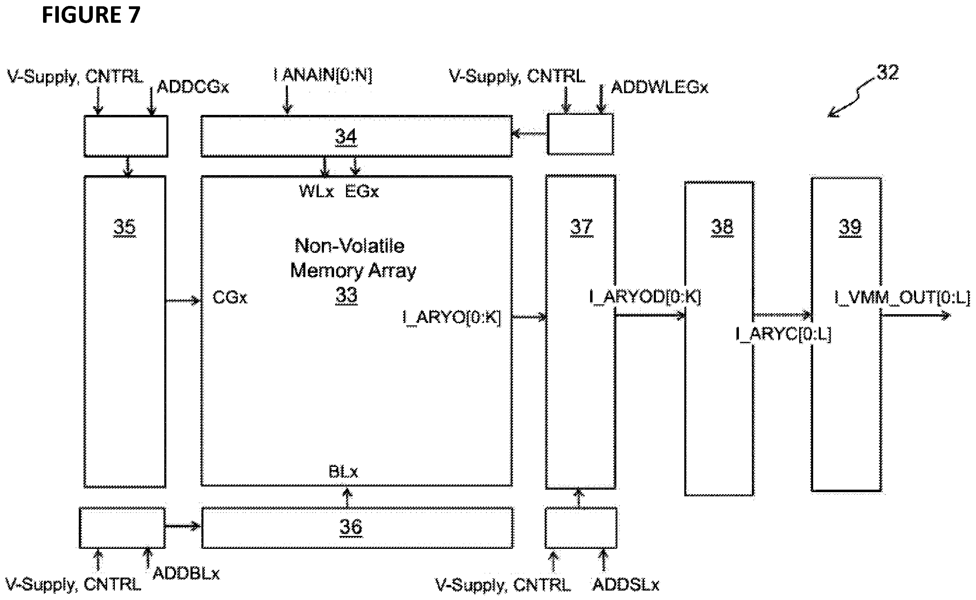

Figure 7 is a block diagram of an array that can be used for that purpose. Vector-by-matrix multiplication (VMM) array 32 includes non-volatile memory cells and is utilized as the synapses (such as CB1, CB2, CB3, and CB4 in Figure 6) between one layer and the next layer. Specifically, VMM array 32 includes an array of non-volatile memory cells 33, erase gate and word line gate decoder 34, control gate decoder 35, bit line decoder 36 and source line decoder 37, which decode the respective inputs for the non-volatile memory cell array 33. Input to VMM array 32 can be from the erase gate and wordline gate decoder 34 or from the control gate decoder 35. Source line decoder 37 in this example also decodes the output of the non-volatile memory cell array 33. Alternatively, bit line decoder 36 can decode the output of the non-volatile memory cell array 33.

Non-volatile memory cell array 33 serves two purposes. First, it stores the weights that will be used by the VMM array 32. Second, the non-volatile memory cell array 33 effectively multiplies the inputs by the weights stored in the non-volatile memory cell array 33 and adds them up per output line (source line or bit line) to produce the output, which will be the input to the next layer or input to the final layer. By performing the multiplication and addition function, the non-volatile memory cell array 33 negates the need for separate multiplication and addition logic circuits and is also power efficient due to its in-situ memory computation.

The output of non-volatile memory cell array 33 is supplied to a differential summer (such as a summing op-amp or a summing current mirror) 38, which sums up the outputs of the non-volatile memory cell array 33 to create a single value for that convolution. The differential summer 38 is arranged to perform summation of positive weight and negative weight.

The summed-up output values of differential summer 38 are then supplied to an activation function circuit 39, which rectifies the output. The activation function circuit 39 may provide sigmoid, tanh, or ReLU functions. The rectified output values of activation function circuit 39 become an element of a feature map as the next layer (e.g. C1 in Figure 6), and are then applied to the next synapse to produce the next feature map layer or final layer. Therefore, in this example, non-volatile memory cell array 33 constitutes a plurality of synapses (which receive their inputs from the prior layer of neurons or from an input layer such as an image database), and summing op-amp 38 and activation function circuit 39 constitute a plurality of neurons.

The input to VMM array 32 in Figure 7 (WLx, EGx, CGx, and optionally BLx and SLx) can be analog level, binary level, or digital bits (in which case a DAC is provided to convert digital bits to appropriate input analog level) and the output can be analog level, binary level, or digital bits (in which case an output ADC is provided to convert output analog level into digital bits).

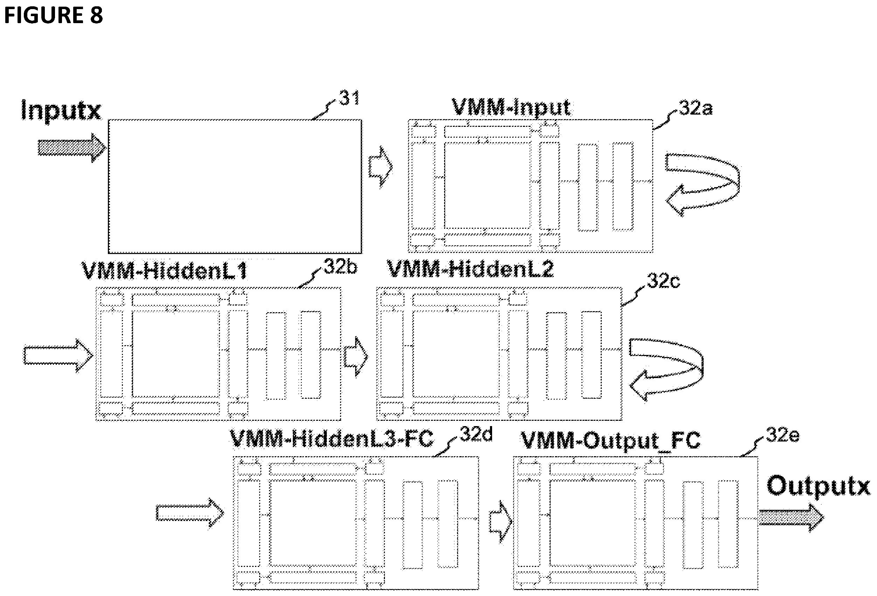

Figure 8 is a block diagram depicting the usage of numerous layers of VMM arrays 32, here labeled as VMM arrays 32a, 32b, 32c, 32d, and 32e. As shown in Figure 8, the input, denoted Inputx, is converted from digital to analog by a digital-to-analog converter 31 and provided to input VMM array 32a. The converted analog inputs could be voltage or current. The input D/A conversion for the first layer could be done by using a function or a LUT (look up table) that maps the inputs Inputx to appropriate analog levels for the matrix multiplier of input VMM array 32a. The input conversion could also be done by an analog to analog (A/A) converter to convert an external analog input to a mapped analog input to the input VMM array 32a.

The output generated by input VMM array 32a is provided as an input to the next VMM array (hidden level 1) 32b, which in turn generates an output that is provided as an input to the next VMM array (hidden level 2) 32c, and so on. The various layers of VMM array 32 function as different layers of synapses and neurons of a convolutional neural network (CNN). Each VMM array 32a, 32b, 32c, 32d, and 32e can be a stand-alone, physical non-volatile memory array, or multiple VMM arrays could utilize different portions of the same physical non-volatile memory array, or multiple VMM arrays could utilize overlapping portions of the same physical non-volatile memory array. The example shown in Figure 8 contains five layers (32a,32b,32c,32d,32e): one input layer (32a), two hidden layers (32b,32c), and two fully connected layers (32d,32e). One of ordinary skill in the art will appreciate that this is merely exemplary and that a system instead could comprise more than two hidden layers and more than two fully connected layers.

Vector-by-Matrix Multiplication (VMM) Arrays

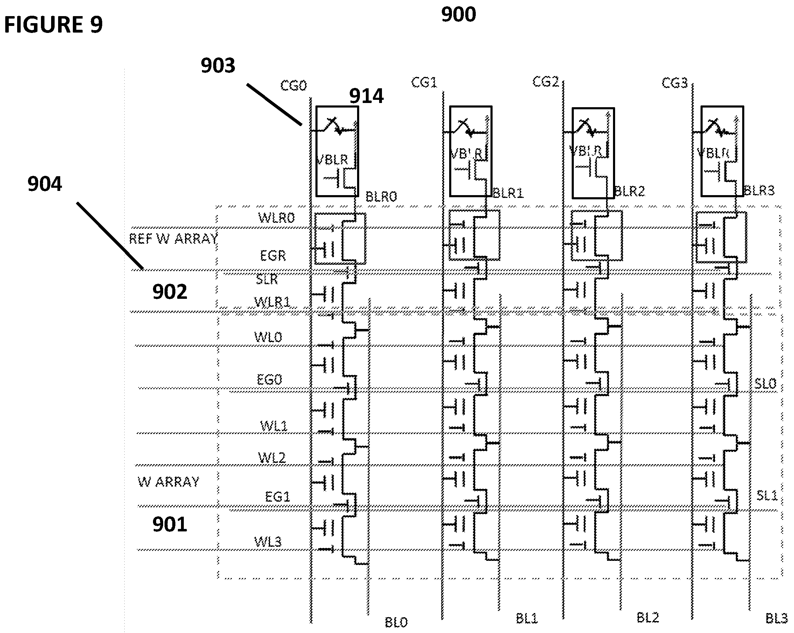

Figure 9 depicts neuron VMM array 900, which is particularly suited for memory cells 310 as shown in Figure 3 and is utilized as the synapses and parts of neurons between an input layer and the next layer. VMM array 900 comprises memory array 901 of non-volatile memory cells and reference array 902 (at the top of the array) of non-volatile reference memory cells. Alternatively, another reference array can be placed at the bottom.

In VMM array 900, control gate lines, such as control gate line 903, run in a vertical direction (hence reference array 902 in the row direction is orthogonal to control gate line 903), and erase gate lines, such as erase gate line 904, run in a horizontal direction. Here, the inputs to VMM array 900 are provided on the control gate lines (CGO, CG1, CG2, CG3), and the output of VMM array 900 emerges on the source lines (SLO, SL1). In one embodiment, only even rows are used, and in another embodiment, only odd rows are used. The current placed on each source line (SLO, SL1, respectively) performs a summing function of all the currents from the memory cells connected to that particular source line.

As described herein for neural networks, the non-volatile memory cells of VMM array 900, i.e. the memory cells 310 of VMM array 900, are preferably configured to operate in a sub-threshold region.

The non-volatile reference memory cells and the non-volatile memory cells described herein are biased in weak inversion (sub threshold region):

$$Ids = Io * e^{(Vg- Vth)/nVt} = w * Io * e^{(Vg)/nVt},$$

where

$$w = e^{(- Vth)/nVt}$$

where Ids is the drain to source current; Vg is gate voltage on the memory cell; Vth is threshold voltage of the memory cell; Vt is thermal voltage = k*T/q with k being the Boltzmann constant, T the temperature in Kelvin, and q the electronic charge; n is a slope factor = 1 + (Cdep/Cox) with Cdep = capacitance of the depletion layer, and Cox capacitance of the gate oxide layer; Io is the memory cell current at gate voltage equal to threshold voltage, Io is proportional to $(Wt/L)*u*Cox* (n-1) * Vt^2$ where u is carrier mobility and Wt and L are width and length, respectively, of the memory cell.

For an I-to-V log converter using a memory cell (such as a reference memory cell or a peripheral memory cell) or a transistor to convert input current into an input voltage:

$$Vg= n*Vt*log [Ids/wp*Io]$$

where, wp is w of a reference or peripheral memory cell.

For a memory array used as a vector matrix multiplier VMM array with the current input, the output current is:

$$Iout = wa * Io * e^{(Vg)/nVt},$$

namely

$$Iout = (wa/wp) * Iin = W * Iin$$

$$W = e^{(Vthp - Vtha)/nVt}$$

Here, wa = w of each memory cell in the memory array.

Vthp is effective threshold voltage of the peripheral memory cell and Vtha is effective threshold voltage of the main (data) memory cell. Note that the threshold voltage of a transistor is a function of substrate body bias voltage and the substrate body bias voltage, denoted Vsb, can be modulated to compensate for various conditions, on such temperature. The threshold voltage Vth can be expressed as:

$$Vth = Vth0 + gamma (SQRT |Vsb - 2*\varphi F) - SQRT |2* \varphi F|)$$

Where Vth0 is threshold voltage with zero substrate bias, $\varphi F$ is a surface potential, and gamma is a body effect parameter.

A wordline or control gate can be used as the input for the memory cell for the input voltage.

Alternatively, the flash memory cells of VMM arrays described herein can be configured to operate in the linear region:

$$Ids = beta* (Vgs-Vth)*Vds \; ; \; beta = u*Cox*Wt/L$$

$$W = \alpha \; (Vgs-Vth)$$

meaning weight W in the linear region is proportional to (Vgs-Vth)

A wordline or control gate or bitline or sourceline can be used as the input for the memory cell operated in the linear region. The bitline or sourceline can be used as the output for the memory cell.

For an I-to-V linear converter, a memory cell (such as a reference memory cell or a peripheral memory cell) or a transistor operating in the linear region can be used to linearly convert an input/output current into an input/output voltage.

Alternatively, the memory cells of VMM arrays described herein can be configured to operate in the saturation region:

$$Ids = \tfrac{1}{2} * beta* (Vgs-Vth)^2 \; ; \; beta = u*Cox*Wt/L$$

$W\alpha \, (Vgs-Vth)^2$, meaning weight W is proportional to $(Vgs-Vth)^2$

A wordline, control gate, or erase gate can be used as the input for the memory cell operated in the saturation region. The bitline or sourceline can be used as the output for the output neuron.

Alternatively, the memory cells of VMM arrays described herein can be used in all regions or a combination thereof (sub threshold, linear, or saturation) for each layer or multi layers of a neural network.

Other embodiments for VMM array 32 of Figure 7 are described in U.S. Patent Application No. Application No. 15/826,345. As described in that application. a sourceline or a bitline can be used as the neuron output (current summation output).

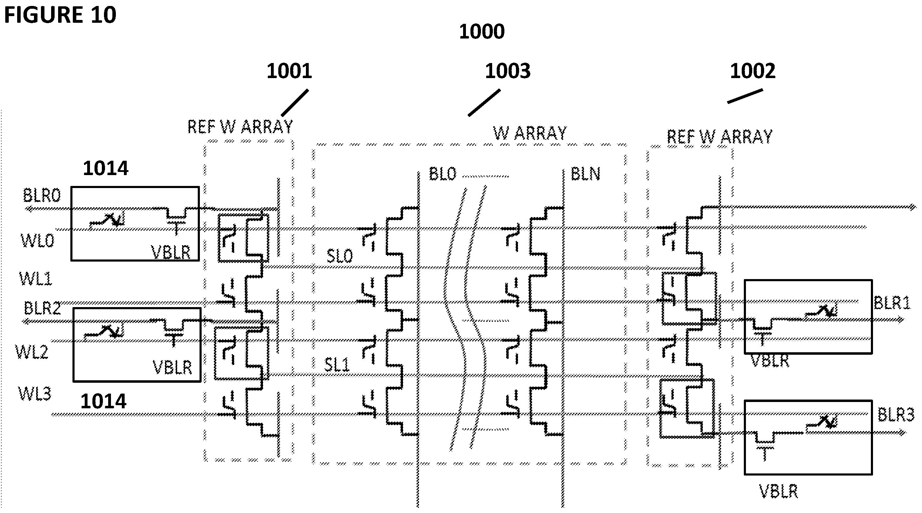

Figure 10 depicts neuron VMM array 1000, which is particularly suited for memory cells 210 as shown in Figure 2 and is utilized as the synapses between an input layer and the next layer. VMM array 1000 comprises a memory array 1003 of non-volatile memory cells, reference array 1001 of first non-volatile reference memory cells, and reference array 1002 of second non-volatile reference memory cells. Reference arrays 1001 and 1002, arranged in the column direction of the array, serve to convert current inputs flowing into terminals BLR0, BLR1, BLR2, and BLR3 into voltage inputs WL0, WL1, WL2, and WL3. In effect, the first and second non-volatile reference memory cells are diode-connected through multiplexors 1014 (only partially depicted) with current inputs flowing into them. The reference cells are tuned (e.g., programmed) to target reference levels. The target reference levels are provided by a reference mini-array matrix (not shown).

Memory array 1003 serves two purposes. First, it stores the weights that will be used by the VMM array 1000 on respective memory cells thereof. Second, memory array 1003 effectively multiplies the inputs (i.e. current inputs provided in terminals BLR0, BLR1, BLR2, and BLR3, which reference arrays 1001 and 1002 convert into the input voltages to supply to wordlines WL0, WL1, WL2, and WL3) by the weights stored in the memory array 1003 and then adds all the results (memory cell currents) to produce the output on the respective bit lines (BL0 - BLN), which will be the input to the next layer or input to the final layer. By performing the multiplication and addition function, memory array 1003 negates the need for separate multiplication and addition logic circuits and is also power efficient. Here, the voltage inputs are provided on the word lines WL0, WL1, WL2, and WL3, and the output emerges on the respective bit lines BL0 - BLN during a read (inference) operation. The current placed on each of the bit lines BL0 - BLN performs a summing function of the currents from all non-volatile memory cells connected to that particular bitline.

Table No. 5 depicts operating voltages and currents for VMM array 1000. The columns in the table indicate the voltages placed on word lines for selected cells, word lines for unselected cells, bit lines for selected cells, bit lines for unselected cells, source lines for selected cells, and source lines for unselected cells. The rows indicate the operations of read, erase, and program.

**Table No. 5: Operation of VMM Array 1000 of Figure 10:**

|  | WL | WL -unsel | BL | BL -unsel | SL | SL -unsel |
|---|---|---|---|---|---|---|
| **Read** | 1-3.5V | -0.5V/0V | 0.6-2V (Ineuron) | 0.6V-2V/0V | 0V | 0V |
| **Erase** | ~5-13V | 0V | 0V | 0V | 0V | 0V |
| **Program** | 1-2V | -0.5V/0V | 0.1-3 uA | Vinh ~2.5V | 4-10V | 0-1V/FLT |

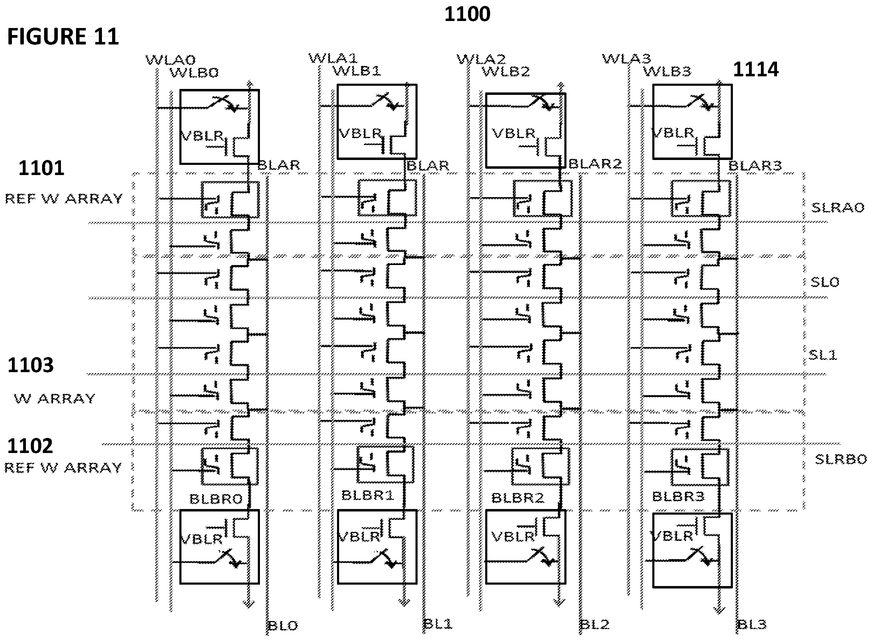

Figure 11 depicts neuron VMM array 1100, which is particularly suited for memory cells 210 as shown in Figure 2 and is utilized as the synapses and parts of neurons between an input layer and the next layer. VMM array 1100 comprises a memory array 1103 of non-volatile memory cells, reference array 1101 of first non-volatile reference memory cells, and reference array 1102 of second non-volatile reference memory cells. Reference arrays 1101 and 1102 run in row direction of the VMM array 1100. VMM array is similar to VMM 1000 except that in VMM array 1100, the word lines run in the vertical direction. Here, the inputs are provided on the word lines (WLA0, WLB0, WLA1, WLB2, WLA2, WLB2, WLA3, WLB3), and the output emerges on the source line (SLO, SL1) during a read operation. The current placed on each source line performs a summing function of all the currents from the memory cells connected to that particular source line.

Table No. 6 depicts operating voltages and currents for VMM array 1100. The columns in the table indicate the voltages placed on word lines for selected cells, word lines for unselected cells, bit lines for selected cells, bit lines for unselected cells, source lines for selected cells, and source lines for unselected cells. The rows indicate the operations of read, erase, and program.

**Table No. 6: Operation of VMM Array 1100 of Figure 11**

|  | WL | WL -unsel | BL | BL -unsel | SL | SL -unsel |
|---|---|---|---|---|---|---|
| **Read** | 1-3.5V | -0.5V/0V | 0.6-2V | 0.6V-2V/0V | ~0.3-1V (Ineuron) | 0V |
| **Erase** | ~5-13V | 0V | 0V | 0V | 0V | SL-inhibit (~4-8V) |
| **Program** | 1-2V | -0.5V/0V | 0.1-3 uA | Vinh ~2.5V | 4-10V | 0-1V/FLT |

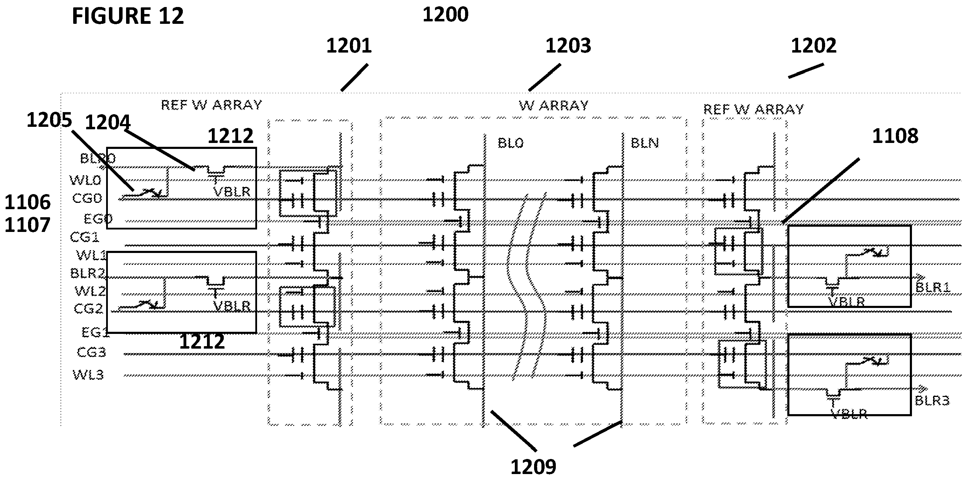

Figure 12 depicts neuron VMM array 1200, which is particularly suited for memory cells 310 as shown in Figure 3 and is utilized as the synapses and parts of neurons between an input layer and the next layer. VMM array 1200 comprises a memory array 1203 of non-volatile memory cells, reference array 1201 of first non-volatile reference memory cells, and reference array 1202 of second non-volatile reference memory cells. Reference arrays 1201 and 1202 serve to convert current inputs flowing into terminals BLR0, BLR1, BLR2, and BLR3 into voltage inputs CG0, CG1, CG2, and CG3. In effect, the first and second non-volatile reference memory cells are diode-connected through multiplexors 1212 (only partially shown) with current inputs flowing into them through BLR0, BLR1, BLR2, and BLR3. Multiplexors 1212 each include a respective multiplexor 1205 and a cascoding transistor 1204 to ensure a constant voltage on the bitline (such as BLR0) of each of the first and second non-volatile reference memory cells during a read operation. The reference cells are tuned to target reference levels.

Memory array 1203 serves two purposes. First, it stores the weights that will be used by the VMM array 1200. Second, memory array 1203 effectively multiplies the inputs (current inputs provided to terminals BLR0, BLR1, BLR2, and BLR3, for which reference arrays 1201 and 1202 convert these current inputs into the input voltages to supply to the control gates (CGO, CG1, CG2, and CG3) by the weights stored in the memory array and then add all the results (cell currents) to produce the output, which appears on BL0 - BLN, and will be the input to the next layer or input to the final layer. By performing the multiplication and addition function, the memory array negates the need for separate multiplication and addition logic circuits and is also power efficient. Here, the inputs are provided on the control gate lines (CGO, CG1, CG2, and CG3), and the output emerges on the bitlines (BL0 - BLN) during a read operation. The current placed on each bitline performs a summing function of all the currents from the memory cells connected to that particular bitline.

VMM array 1200 implements uni-directional tuning for non-volatile memory cells in memory array 1203. That is, each non-volatile memory cell is erased and then partially programmed until the desired charge on the floating gate is reached. If too much charge is placed on the floating gate (such that the wrong value is stored in the cell), the cell is erased and the sequence of partial programming operations starts over. As shown, two rows sharing the same erase gate (such as EG0 or EG1) are erased together (which is known as a page erase), and thereafter, each cell is partially programmed until the desired charge on the floating gate is reached.

Table No. 7 depicts operating voltages and currents for VMM array 1200. The columns in the table indicate the voltages placed on word lines for selected cells, word lines for unselected cells, bit lines for selected cells, bit lines for unselected cells, control gates for selected cells, control gates for unselected cells in the same sector as the selected cells, control gates for unselected cells in a different sector than the selected cells, erase gates for selected cells, erase gates for unselected cells, source lines for selected cells, and source lines for unselected cells. The rows indicate the operations of read, erase, and program.

**Table No. 7: Operation of VMM Array 1200 of Figure 12**

| | WL | WL - unsel | BL | BL - unsel | CG | CG - unsel same sector | CG - unsel | EG | EG - unsel | SL | SL - unsel |
|---|---|---|---|---|---|---|---|---|---|---|---|
| **Read** | 1.0-2V | -0.5V/ 0V | 0.6-2V (Ineuron) | 0V | 0-2.6V | 0-2.6V | 0-2.6V | 0-2.6V | 0-2.6V | 0V | 0V |
| **Erase** | 0V | 0V | 0V | 0V | 0V | 0-2.6V | 0-2.6V | 5-12V | 0-2.6V | 0V | 0V |
| **Program** | 0.7-1V | -0.5V/ 0V | 0.1-1uA | Vinh (1-2V) | 4-11V | 0-2.6V | 0-2.6V | 4.5-5V | 0-2.6V | 4.5-5V | 0-1V |

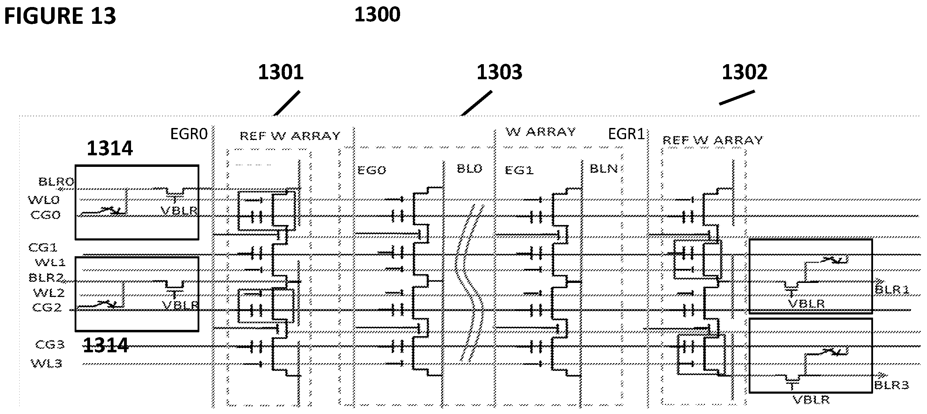

Figure 13 depicts neuron VMM array 1300, which is particularly suited for memory cells 310 as shown in Figure 3, and is utilized as the synapses and parts of neurons between an input layer and the next layer. VMM array 1300 comprises a memory array 1303 of non-volatile memory cells, reference array 1301 or first non-volatile reference memory cells, and reference array 1302 of second non-volatile reference memory cells. EG lines EGR0, EG0, EG1 and EGR1 are run vertically while CG lines CG0, CG1, CG2 and CG3 and SL lines WL0, WL1, WL2 and WL3 are run horizontally. VMM array 1300 is similar to VMM array 1400, except that VMM array 1300 implements bi-directional tuning, where each individual cell can be completely erased, partially programmed, and partially erased as needed to reach the desired amount of charge on the floating gate due to the use of separate EG lines. As shown, reference arrays 1301 and 1302 convert input current in the terminal BLR0, BLR1, BLR2, and BLR3 into control gate voltages CG0, CG1, CG2, and CG3 (through the action of diode-connected reference cells through multiplexors 1314) to be applied to the memory cells in the row direction. The current output (neuron) is in the bitlines BL0 - BLN, where each bit line sums all currents from the non-volatile memory cells connected to that particular bitline.

Table No. 8 depicts operating voltages and currents for VMM array 1300. The columns in the table indicate the voltages placed on word lines for selected cells, word lines for unselected cells, bit lines for selected cells, bit lines for unselected cells, control gates for selected cells, control gates for unselected cells in the same sector as the selected cells, control gates for unselected cells in a different sector than the selected cells, erase gates for selected cells, erase gates for unselected cells, source lines for selected cells, and source lines for unselected cells. The rows indicate the operations of read, erase, and program.

**Table No. 8: Operation of VMM Array 1300 of Figure 13**

| | WL | WL - unsel | BL | BL - unsel | CG | CG -unsel same sector | CG- unsel | EG | EG - unsel | SL | SL - unsel |
|---|---|---|---|---|---|---|---|---|---|---|---|
| **Read** | 1.0-2V | -0.5V/ 0V | 0.6-2V (Ineuron) | 0V | 0-2.6V | 0-2.6V | 0-2.6V | 0-2.6V | 0-2.6V | 0V | 0V |
| **Erase** | 0V | 0V | 0V | 0V | 0V | 4-9V | 0-2.6V | 5-12V | 0-2.6V | 0V | 0V |
| **Program** | 0.7-1V | -0.5V/ 0V | 0.1-1uA | Vinh (1-2V) | 4-11V | 0-2.6V | 0-2.6V | 4.5-5V | 0-2.6V | 4.5-5V | 0-1V |

Improved VMM Systems With Page or Word-Based Tuning

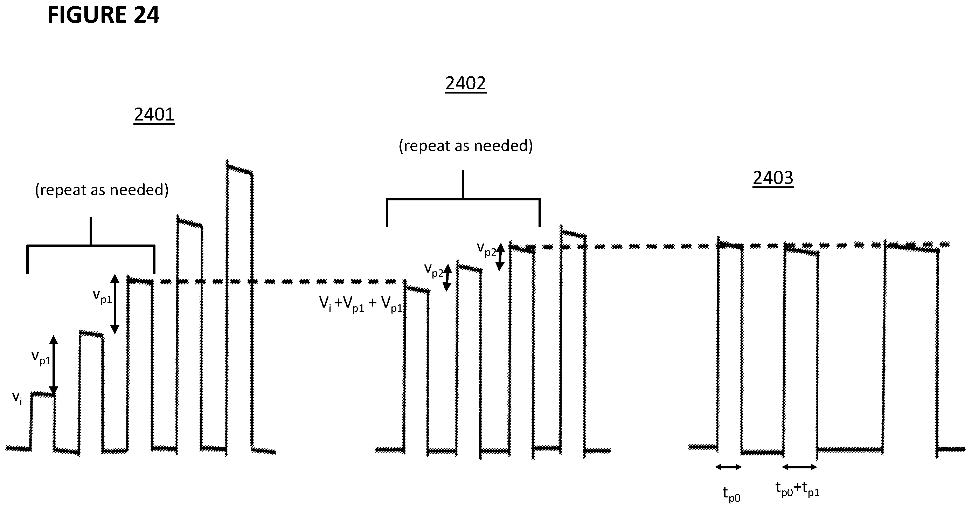

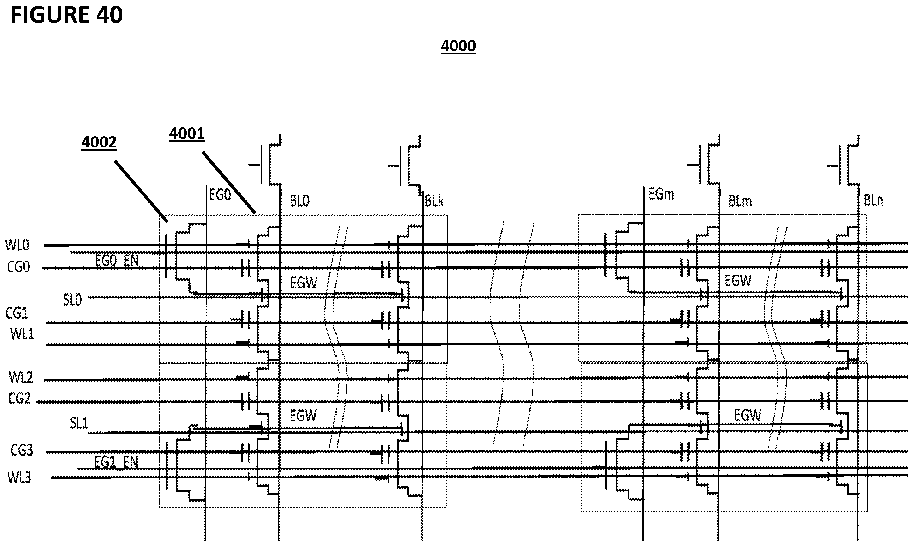

Figure 40 depicts VMM array 4000. VMM array 4000 implements uni-directional or bi-directional tuning for a page of non-volatile memory cells. Here, exemplary page 4001 comprises two words, each in a different row. A word includes a plurality of memory cells, e.g. 8-64. A special word may include just one cell or a few cells. Pairs of adjacent rows share a source line, such as SL0 or SL1. All cells in page 4001 share a common erase gate line that is controlled by erase gate enable transistor 4002, which controls the provision of a voltage to the erase gate terminals EGW of all cells in exemplary page set 4001. Here, all cells in page 4001 can be erased at the same time. Thereafter, cells in page 4001 can be uni-directionally or bi-directionally tuned through program (cellwise, meaning each cell in a word can be tuned at a time; wordwise, meaning all cells in a word can be tuned at the same times) and erase (wordwise, meaning all cells in a word can be tuned at same time) operations and some cells in page 4001 can be uni-directionally tuned through program operation. The program operations can include the precision programming techniques described below with reference to Figures 24-26. If too much electron charge is placed on a floating gate (which would cause an incorrect current value to be stored in the cell, i.e. a current value lower than the intended current value), the cell must be erased and the sequence of partial programming operations must start over.

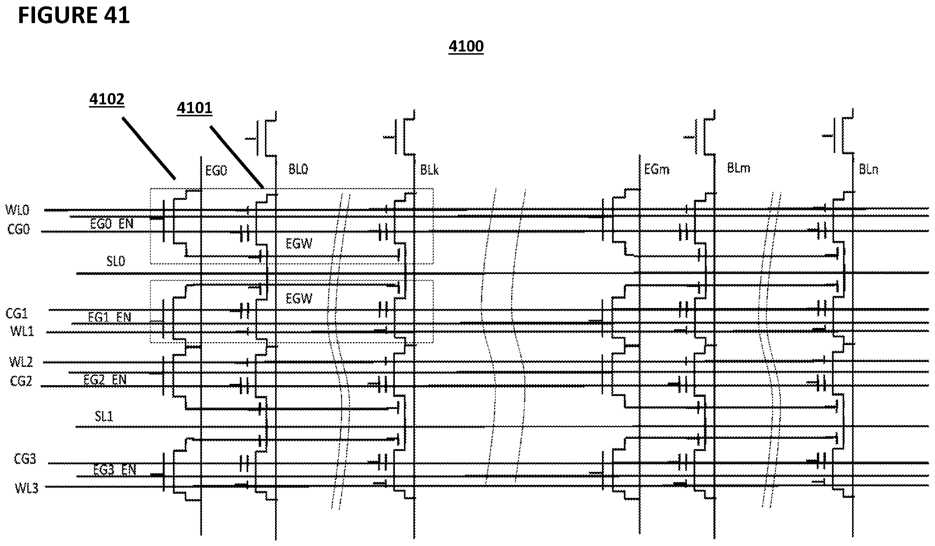

Figure 41 depicts VMM array 4100. VMM array 4100 implements uni-directional or bi-directional tuning for a word of non-volatile memory cells. Here, exemplary word 4101 comprises a plurality of cells in a row. All cells in word 4101 share a common erase gate line that is controlled by erase gate enable transistor 4102, which controls the provision of a voltage to the erase gate terminals of all cells in word 4101. Here, all cells in word 4101 can be erased at the same time. Thereafter, cells in word 4101 can be uni-directionally or bi-directionally tuned through program (cellwise, meaning each cell in a word can be tuned at a time; wordwise, meaning all cells in a word can be tuned at the same times) and erase (wordwise, meaning all cells in a word can be tuned at same time) operations. The program operations can include the precision programming techniques described below. If too much electron charge is placed on a floating gate (such that an incorrect current value is stored in the cell, i.e. a current value lower than the intended current value), the cell must be erased and the sequence of partial programming operations must start over.

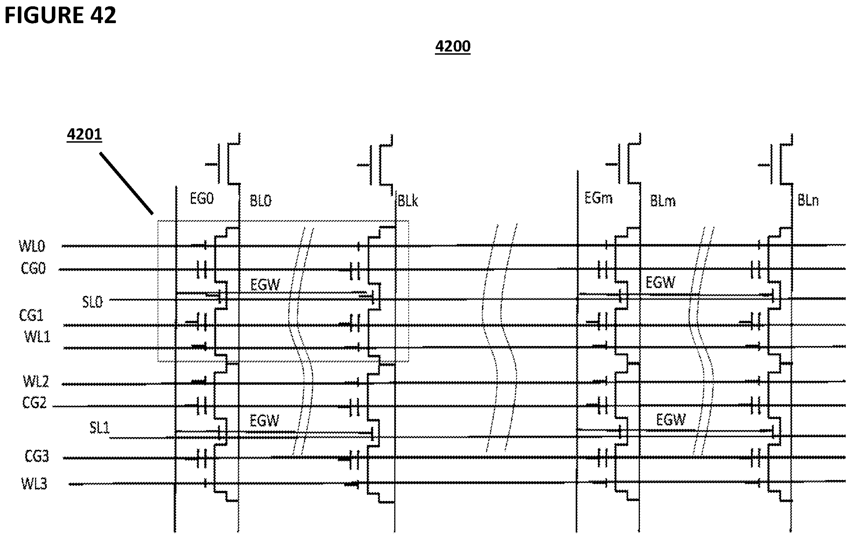

Figure 42 depicts VMM array 4200. VMM array 4200 implements uni-directional or bi-directional tuning for a word of non-volatile memory cells. Here, exemplary word 4201 comprises two half words of cells. Each half word belongs to a row that shares an erase gate. All cells in word 4201 share a common erase gate line connected to erase gate terminal EGW. Unlike in VMM array 1800 and 1700, there is no erase gate enable transistor. Here, all cells in word 4201 can be erased at the same time. Thereafter, cells in word 4201 can be uni-directionally or bi-directionally tuned through program (cellwise, meaning each cell in a word can be tuned at a time; wordwise, meaning all cells in a word can be tuned at the same times) and erase (wordwise, meaning all cells in a word can be tuned at same time) operations. The program operations can include the precision programming techniques described below. If too much electron charge is placed on a floating gate (such that an incorrect current value is stored in the cell, i.e. a current value lower than the intended current value), the cell must be erased and the sequence of partial programming operations must start over.

## Long Short-Term Memory

The prior art includes a concept known as long short-term memory (LSTM). LSTM units often are used in neural networks. LSTM allows a neural network to remember information over predetermined arbitrary time intervals and to use that information in subsequent operations. A conventional LSTM unit comprises a cell, an input gate, an output gate, and a forget gate. The three gates regulate the flow of information into and out of the cell and the time interval that the information is remembered in the LSTM. VMMs are particularly useful in LSTM units.

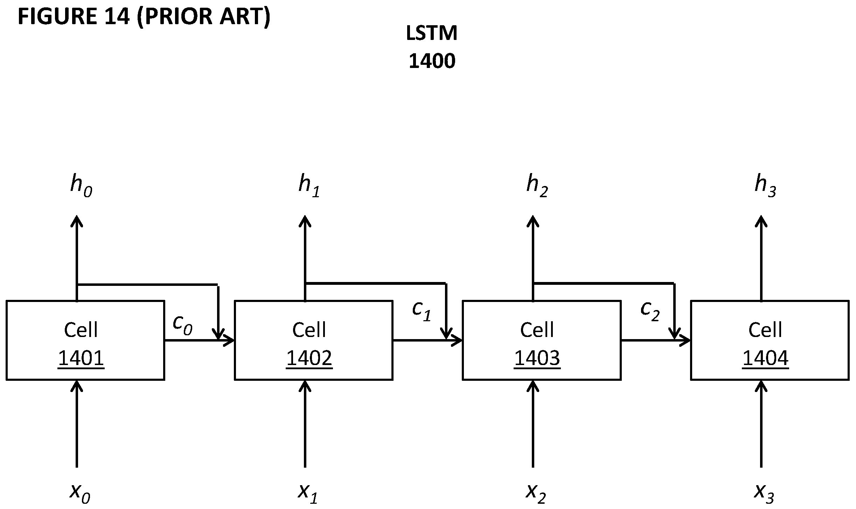

Figure 14 depicts an exemplary LSTM 1400. LSTM 1400 in this example comprises cells 1401, 1402, 1403, and 1404. Cell 1401 receives input vector $x_0$ and generates output vector $h_0$ and cell state vector $c_0$. Cell 1402 receives input vector $x_1$, the output vector (hidden state) $h_0$ from cell 1401, and cell state $c_0$ from cell 1401 and generates output vector $h_1$ and cell state vector $c_1$. Cell 1403 receives input vector $x_2$, the output vector (hidden state) $h_1$ from cell 1402, and cell state $c_1$ from cell 1402 and generates output vector $h_2$ and cell state vector $c_2$. Cell 1404 receives input vector $x_3$, the output vector (hidden state) $h_2$ from cell 1403, and cell state $c_2$ from cell 1403 and generates output vector $h_3$. Additional cells can be used, and an LSTM with four cells is merely an example.

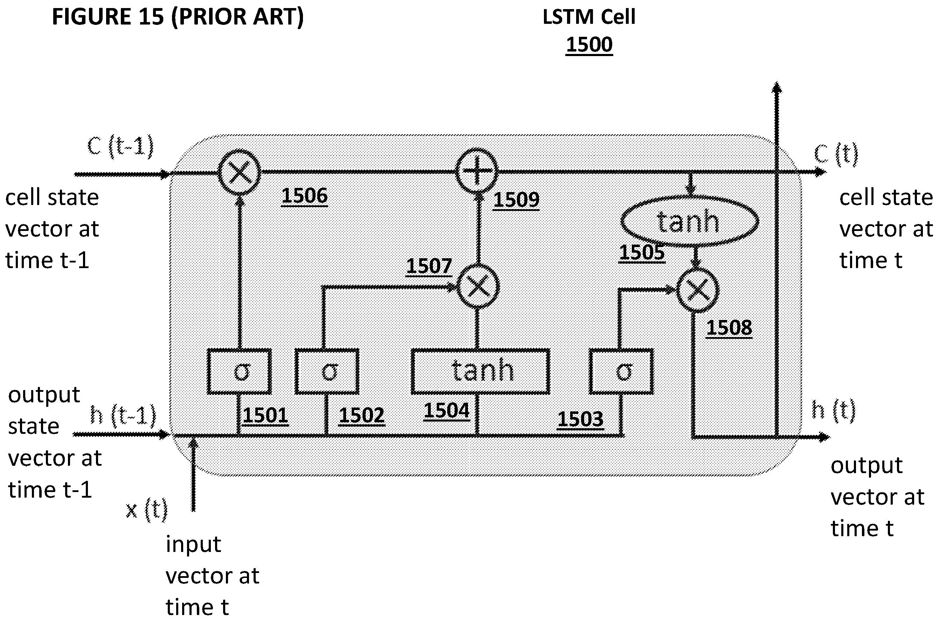

Figure 15 depicts an exemplary implementation of an LSTM cell 1500, which can be used for cells 1401, 1402, 1403, and 1404 in Figure 14. LSTM cell 1500 receives input vector x(t), cell state vector c(t-1) from a preceding cell, and output vector h(t-1) from a preceding cell, and generates cell state vector c(t) and output vector h(t).

LSTM cell 1500 comprises sigmoid function devices 1501, 1502, and 1503, each of which applies a number between 0 and 1 to control how much of each component in the input vector is allowed through to the output vector. LSTM cell 1500 also comprises tanh devices 1504 and 1505 to apply a hyperbolic tangent function to an input vector, multiplier devices 1506, 1507, and 1508 to multiply two vectors together, and addition device 1509 to add two vectors together. Output vector h(t) can be provided to the next LSTM cell in the system, or it can be accessed for other purposes.

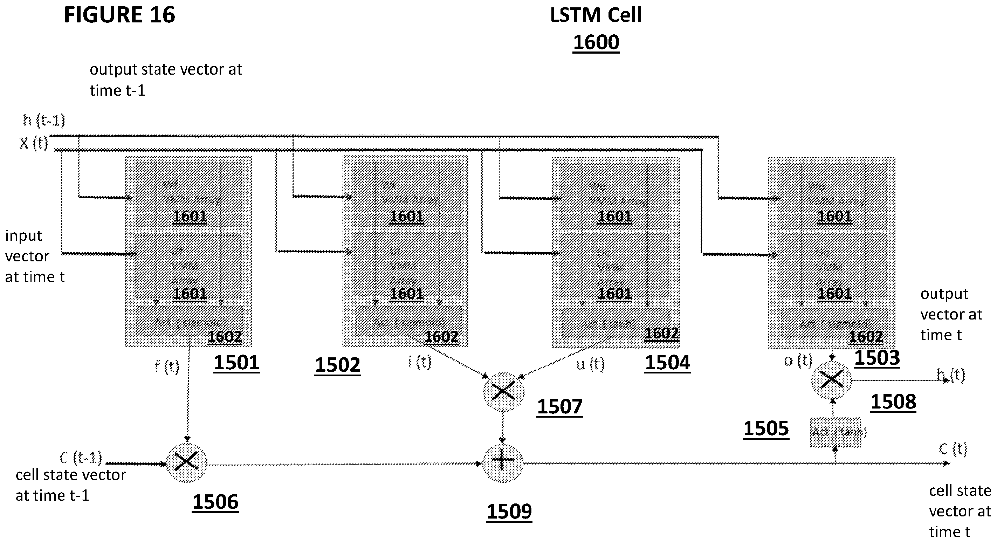

Figure 16 depicts an LSTM cell 1600, which is an example of an implementation of LSTM cell 1500. For the reader's convenience, the same numbering from LSTM cell 1500 is used in LSTM cell 1600. Sigmoid function devices 1501, 1502, and 1503 and tanh device 1504 each comprise multiple VMM arrays 1601 and activation circuit blocks 1602. Thus, it can be seen that VMM arrays are particular useful in LSTM cells used in certain neural network systems.

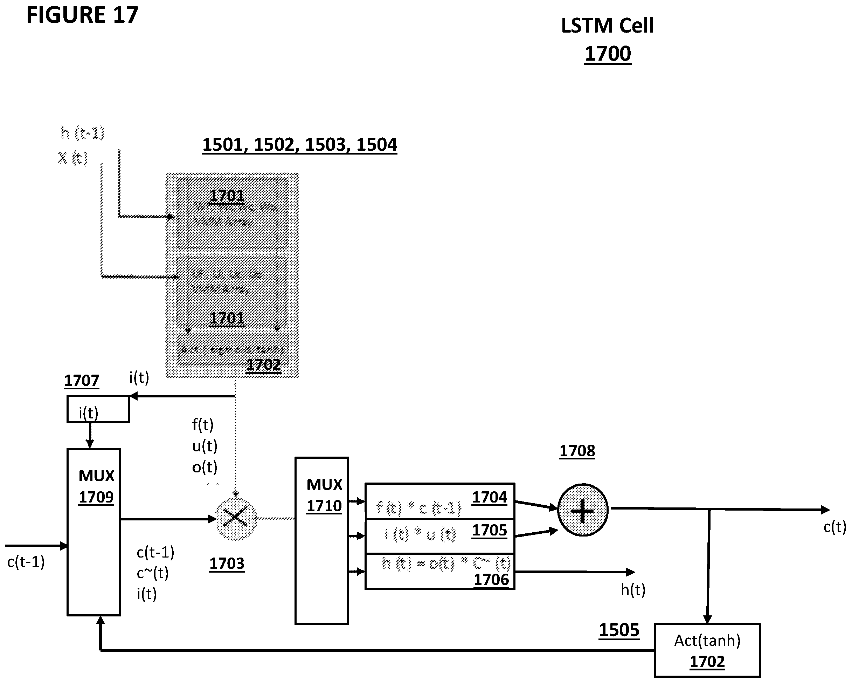

An alternative to LSTM cell 1600 (and another example of an implementation of LSTM cell 1500) is shown in Figure 17. In Figure 17, sigmoid function devices 1501, 1502, and 1503 and tanh device 1504 share the same physical hardware (VMM arrays 1701 and activation function block 1702) in a time-multiplexed fashion. LSTM cell 1700 also comprises multiplier device 1703 to multiply two vectors together, addition device 1708 to add two vectors together, tanh device 1505 (which comprises activation circuit block 1702), register 1707 to store the value i(t) when i(t) is output from sigmoid function block 1702, register 1704 to store the value f(t) * c(t-1) when that value is output from multiplier device 1703 through multiplexor 1710, register 1705 to store the value i(t) * u(t) when that value is output from multiplier device 1703 through multiplexor 1710, and register 1706 to store the value o(t) * c~(t) when that value is output from multiplier device 1703 through multiplexor 1710, and multiplexor 1709.

Whereas LSTM cell 1600 contains multiple sets of VMM arrays 1601 and respective activation function blocks 1602, LSTM cell 1700 contains only one set of VMM arrays 1701 and activation function block 1702, which are used to represent multiple layers in the embodiment of LSTM cell 1700. LSTM cell 1700 will require less space than LSTM 1600, as LSTM cell 1700 will require 1/4 as much space for VMMs and activation function blocks compared to LSTM cell 1600.

It can be further appreciated that LSTM units will typically comprise multiple VMM arrays, each of which requires functionality provided by certain circuit blocks outside of the VMM arrays, such as a summer and activation circuit block and high voltage generation blocks. Providing separate circuit blocks for each VMM array would require a significant amount of space within the semiconductor device and would be somewhat inefficient. The embodiments described below therefore attempt to minimize the circuitry required outside of the VMM arrays themselves.

Gated Recurrent Units

An analog VMM implementation can be utilized for a GRU (gated recurrent unit) system. GRUs are a gating mechanism in recurrent neural networks. GRUs are similar to LSTMs, except that GRU cells generally contain fewer components than an LSTM cell.

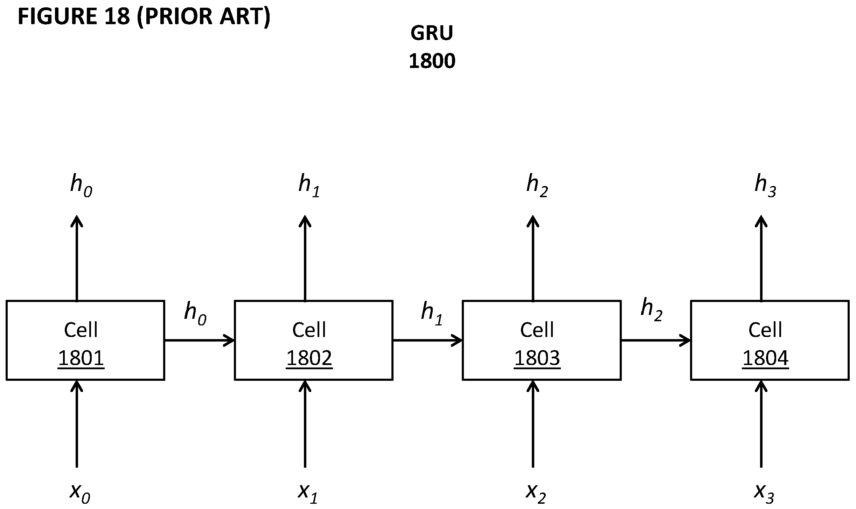

Figure 18 depicts an exemplary GRU 1800. GRU 1800 in this example comprises cells 1801, 1802, 1803, and 1804. Cell 1801 receives input vector $x_0$ and generates output vector $h_0$. Cell 1802 receives input vector $x_1$, the output vector $h_0$ from cell 1801 and generates output vector $h_1$. Cell 1803 receives input vector $x_2$ and the output vector (hidden state) $h_1$ from cell 1802 and generates output vector $h_2$. Cell 1804 receives input vector $x_3$ and the output vector (hidden state) $h_2$ from cell 1803 and generates output vector $h_3$. Additional cells can be used, and an GRU with four cells is merely an example.

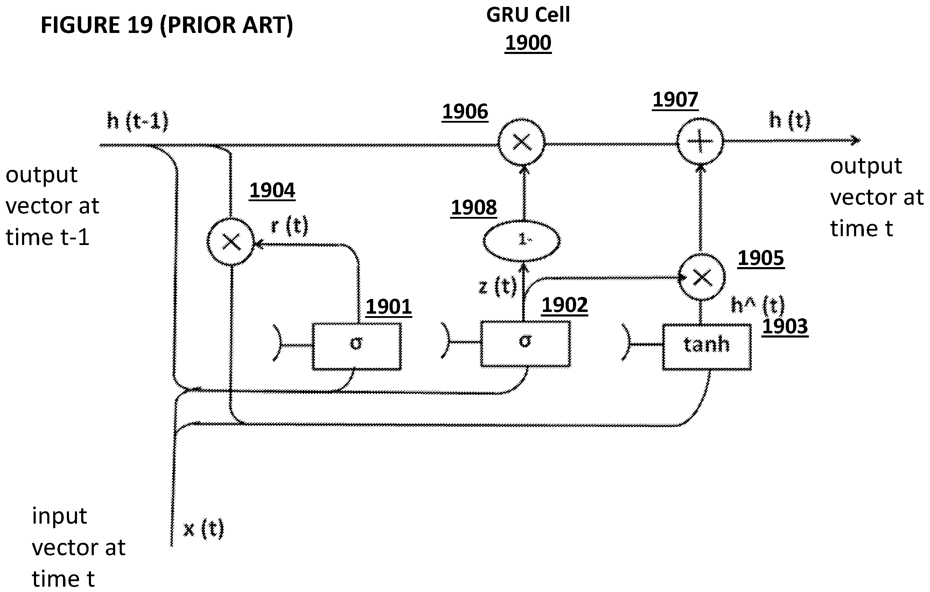

Figure 19 depicts an exemplary implementation of a GRU cell 1900, which can be used for cells 1801, 1802, 1803, and 1804 of Figure 18. GRU cell 1900 receives input vector x(t) and output vector h(t-1) from a preceding GRU cell and generates output vector h(t). GRU cell 1900 comprises sigmoid function devices 1901 and 1902, each of which applies a number between 0 and 1 to components from output vector h(t-1) and input vector x(t). GRU cell 1900 also comprises a tanh device 1903 to apply a hyperbolic tangent function to an input vector, a plurality of multiplier devices 1904, 1905, and 1906 to multiply two vectors together, an addition device 1907 to add two vectors together, and a complementary device 1908 to subtract an input from 1 to generate an output.

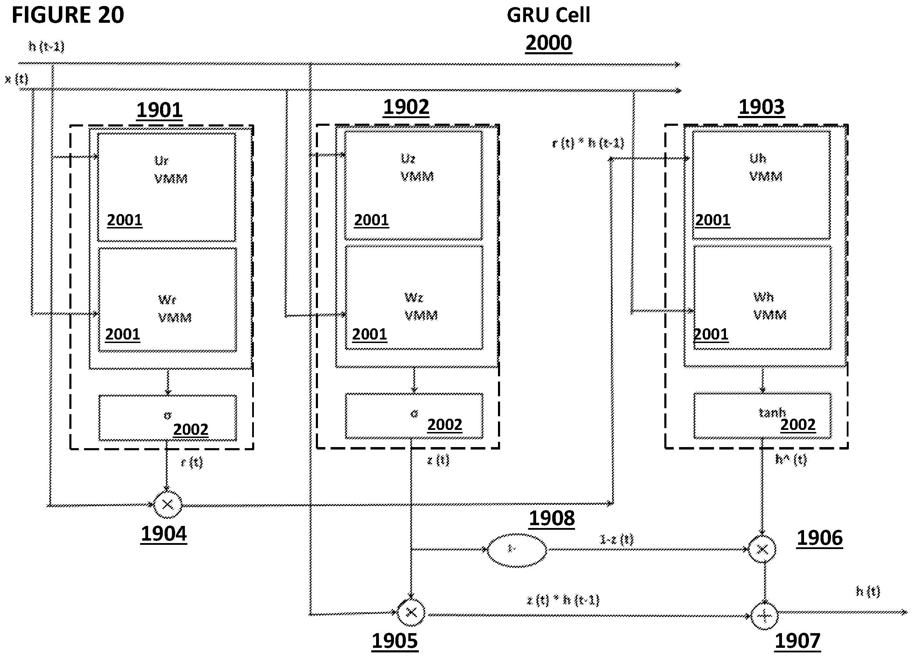

Figure 20 depicts a GRU cell 2000, which is an example of an implementation of GRU cell 1900. For the reader's convenience, the same numbering from GRU cell 1900 is used in GRU cell 2000. As can be seen in Figure 20, sigmoid function devices 1901 and 1902, and tanh device 1903 each comprise multiple VMM arrays 2001 and activation function blocks 2002. Thus, it can be seen that VMM arrays are of particular use in GRU cells used in certain neural network systems.

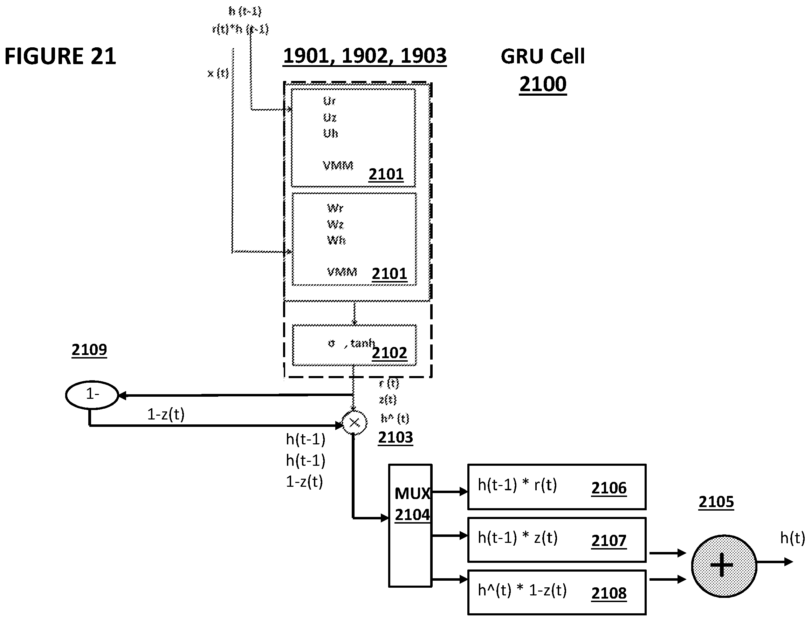

An alternative to GRU cell 2000 (and another example of an implementation of GRU cell 1900) is shown in Figure 21. In Figure 21, GRU cell 2100 utilizes VMM arrays 2101 and activation function block 2102, which when configured as a sigmoid function applies a number between 0 and 1 to control how much of each component in the input vector is allowed through to the output vector. In Figure 21, sigmoid function devices 1901 and 1902 and tanh device 1903 share the same physical hardware (VMM arrays 2101 and activation function block 2102) in a time-multiplexed fashion. GRU cell 2100 also comprises multiplier device 2103 to multiply two vectors together, addition device 2105 to add two vectors together, complementary device 2109 to subtract an input from 1 to generate an output, multiplexor 2104, register 2106 to hold the value h(t-1) * r(t) when that value is output from multiplier device 2103 through multiplexor 2104, register 2107 to hold the value h(t-1) *z(t) when that value is output from multiplier device 2103 through multiplexor 2104, and register 2108 to hold the value h^(t) * (1-z(t)) when that value is output from multiplier device 2103 through multiplexor 2104.

Whereas GRU cell 2000 contains multiple sets of VMM arrays 2001 and activation function blocks 2002, GRU cell 2100 contains only one set of VMM arrays 2101 and activation function block 2102, which are used to represent multiple layers in the embodiment of GRU cell 2100. GRU cell 2100 will require less space than GRU cell 2000, as GRU cell 2100 will require 1/3 as much space for VMMs and activation function blocks compared to GRU cell 2000.

It can be further appreciated that GRU systems will typically comprise multiple VMM arrays, each of which requires functionality provided by certain circuit blocks outside of the VMM arrays, such as a summer and activation circuit block and high voltage generation blocks. Providing separate circuit blocks for each VMM array would require a significant amount of space within the semiconductor device and would be somewhat inefficient. The embodiments described below therefore attempt to minimize the circuitry required outside of the VMM arrays themselves.

The input to the VMM arrays can be an analog level, a binary level, a pulse, a time modulated pulse, or digital bits (in this case a DAC is needed to convert digital bits to appropriate input analog level) and the output can be an analog level, a binary level, a timing pulse, pulses, or digital bits (in this case an output ADC is needed to convert output analog level into digital bits).

For each memory cell in a VMM array, each weight W can be implemented by a single memory cell or by a differential cell or by two blend memory cells (average of 2 cells). In the differential cell case, two memory cells are needed to implement a weight W as a differential weight (W = W+ - W-). In the two blend memory cells, two memory cells are needed to implement a weight W as an average of two cells.

VMM System Overview

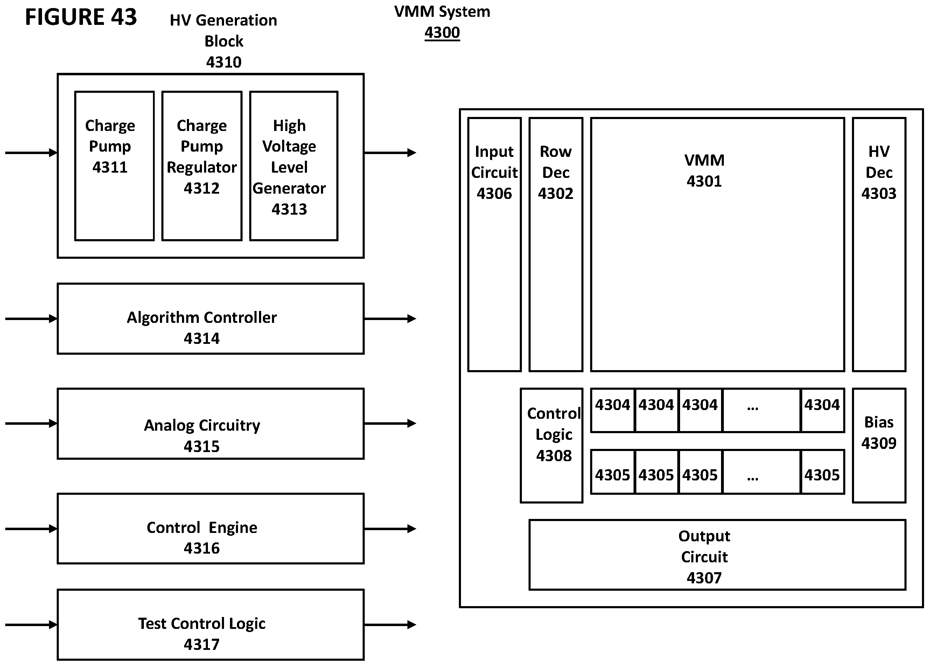

Figure 43 depicts a block diagram of VMM system 4300. VMM system 4300 comprises VMM array 4301, row decoders 4302, high voltage decoders 4303, column decoders 4304, bit line drivers 4305, input circuit 4306, output circuit 4307, control logic 4308, and bias generator 4309. VMM system 4300 further comprises high voltage generation block 4310, which comprises charge pump 4311, charge pump regulator 4312, and high voltage level generator 4313. VMM system 4300 further comprises (program/erase, or aka weight tuning) algorithm controller 4314, analog circuitry 4315, control engine 4316 (that may include special functions such as arithmetic functions, activation functions, embedded microcontroller logic, etc.), and test control logic 4317. The systems and methods described below can be implemented in VMM system 4300.

The input circuit 4306 may include circuits such as a DAC (digital to analog converter), DPC (digital to pulses converter, digital to time modulated pulse converter), AAC (analog to analog converter, such as a current to voltage converter, logarithmic converter ), PAC (pulse to analog level converter), or any other type of converters. The input circuit 4306 may implement normalization, linear or non-linear up/down scaling functions, or arithmetic functions. The input circuit 4306 may implement a temperature compensation function for input levels. The input circuit 4306 may implement an activation function such as ReLU or sigmoid. The output circuit 4307 may include circuits such as a ADC (analog to digital converter, to convert neuron analog output to digital bits), AAC (analog to analog converter, such as a current to voltage converter, logarithmic converter), APC (analog to pulse(s) converter, analog to time modulated pulse converter), or any other type of converters. The output circuit 4307 may implement an activation function such as ReLU or sigmoids. The output circuit 4307 may implement statistic normalization, regularization, up/down scaling/gain functions, statistical rounding, or arithmetic functions (e.g., add, subtract, divide, multiply, shift, log) for neuron outputs. The output circuit 4307 may implement a temperature compensation function for neuron outputs or array outputs (such as bitline output) so as to keep power consumption of the array approximately constant or to improve precision of the array (neuron) outputs such as by keeping the IV slope approximately the same.

Embodiments for Precise Programming of Cells in a VMM

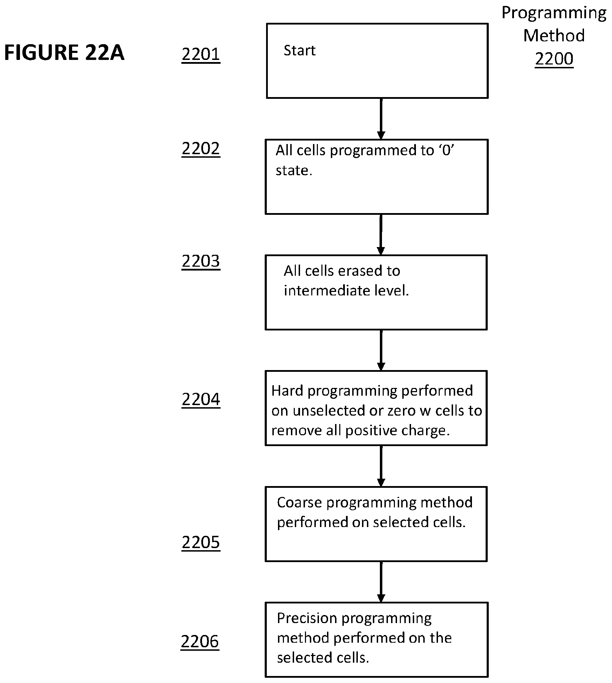

Figure 22A depicts programming method 2200. First, the method starts (step 2201), which typically occurs in response to a program command being received. Next, a mass program operation programs all cells to a '0' state (step 2202). Then a soft erase operation erases all cells to an intermediate level (achieved by weak erasing, i.e., a less than complete erasing) such that each cell draws current of approximately 3-5 $\mu$A during a read operation (step 2203). This is in contrast to a deeply erased level where each cell draws current of approximately ~ 20-30 $\mu$A during a read operation. Then, a hard program is performed on all unselected cells or zero weight cells (i.e. cells with weight = 0 or insignificant weight, i.e. weight within an insignificant threshold value) to a very deep programmed state to add electrons to the floating gates of the cells and to remove all positive charge (step 2204) to ensure that those cells are really "off," meaning that those cells will draw a negligible amount of current during a read operation.

A coarse programming method is then performed on selected cells (step 2205), followed by a precision programming method on the selected cells (step 2206) to program the precise value desired for each selected cell. Here, a selected cell is a cell that is identified as the subject of programming method 2200 and is selected by asserting the appropriate word line and bit line or by some other mechanism.

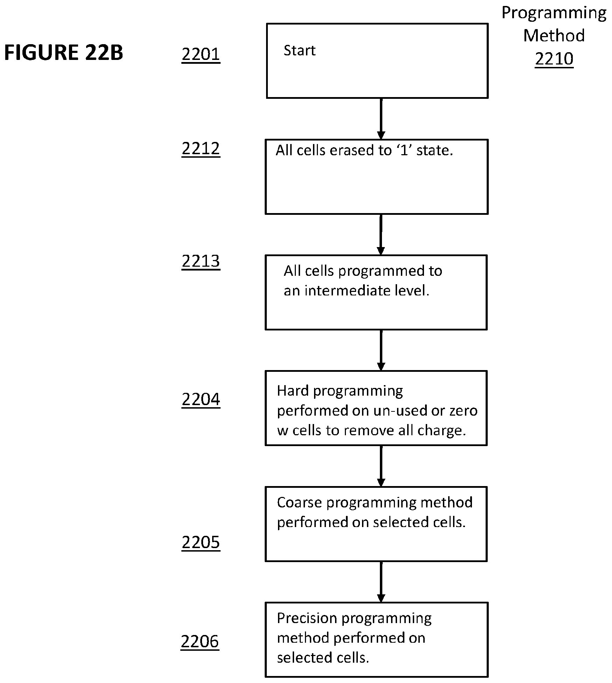

Figure 22B depicts another programming method 2210, which is similar to programming method 2200. However, instead of a program operation to program all cells to a '0' state as in step 2202 of Figure 22A, after the method start (step 2201), an erase operation is used to erase all cells to a '1' state (step 2212). Then a soft program operation (step 2213) is used to program all cells to an intermediate level (achieved by soft programming, i.e., a less than complete programming) such that each cell would draw current of approximately 3-5uA during a read operation. Afterward, hard programming of unselected cells (step 2204) and coarse and precision programming method follow (steps 2205 - 2206) as described above in relation to Figure 22A. A variation of the embodiment of Figure 22B removes the soft programing method (step 2213) altogether.

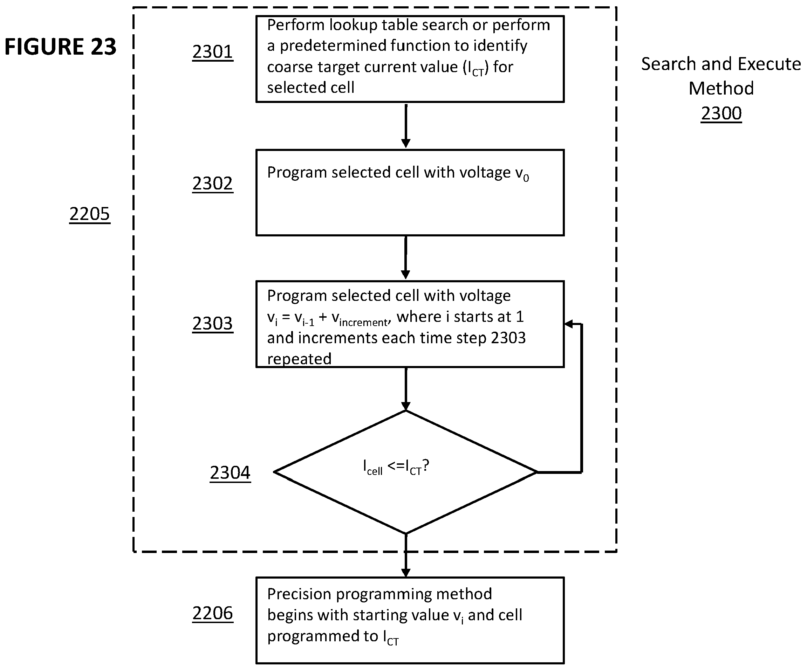

Figure 23 depicts a first embodiment of coarse programming method 2205, which is search and execute method 2300. First, a lookup table search, or a predetermined function is performed, to determine a coarse target current value ($I_{CT}$) for each of the selected cells based on the value that is intended to be stored in that selected cell (step 2301). The selected cell can be programmed to store one of N possible values (e.g., 128, 64, 32, without limitation). Each of the N values corresponds to a different desired current value ($I_D$) that is to be drawn by the selected cell during a read operation. In one embodiment, a look-up table or function (for example a function derived from curve fitting to data or based on the physics of memory behavior, where the function operates on variables such as the final target value and the existing value and calculates the expected or desired target for next operation) contains M possible current values to use as the coarse target current value $I_{CT}$ for the selected cell during search and execute method 2300, where M is an integer less than N. For example, if N is 8, then M might be 4, meaning that there are 8 possible values that the selected cell can store, and one of 4 coarse target current values $I_{CT}$ will be selected as the coarse target current value $I_{CT}$ for search and execute method 2300. That is, search and execute method 2300 is arranged to quickly program the selected cell to the coarse target current value ($I_{CT}$) that is somewhat close to the desired current value $I_D$, and then the precision programming method 2206 is more precisely programs the selected cell to be extremely close to the desired current value $I_D$.

Examples of cell values, desired current values, and coarse target current values are depicted in Tables 9 and 10 for the simple example of N=8 and M=4:

**Table No. 9: Example of N Desired Current Values for N=8**

| Value Stored in Selected Cell | Desired Current Value ($I_D$) |
|---|---|
| 000 | 100 pA |
| 001 | 200 pA |
| 010 | 300 pA |
| 011 | 400 pA |
| 100 | 500 pA |
| 101 | 600 pA |
| 110 | 700 pA |
| 111 | 800 pA |

**Table No. 10: Example of M Target Current Values for M=4**

| Coarse Target Current Value ($I_{CT}$) | Associated Cell Values |
|---|---|
| 200 pA+ $I_{CTOFFSET1}$ | 000, 001 |
| 400 pA+ $I_{CTOFFSET2}$ | 010, 011 |
| 600 pA+ $I_{CTOFFSET3}$ | 100, 101 |
| 800 pA+ $I_{CTOFFSET4}$ | 110, 111 |

The offset values $I_{CTOFFSETx}$ are used to prevent overshooting the desired current value during coarse programming.

Once the coarse target current value $I_{CT}$ is selected, the selected cell is programmed by applying a voltage $v_0$ to the appropriate terminal of selected cell based on the cell architecture type of the selected cell (e.g., memory cells 210, 310, 410, or 510) (step 2302). If the selected cell is of type memory cell 310 in Figure 3, then the voltage $v_0$ is applied to control gate terminal 28, and $v_0$ might be 5-7V depending on coarse target current value $I_{CT}$. The value of $v_0$ optionally can be determined from a voltage look up table that stores $v_0$ vs. coarse target current value $I_{CT}$.

Next, the selected cell is programmed by applying the voltage $v_i = v_{i-1}+v_{increment}$, where i starts at 1 and increments each time this step is repeated (step 2303), and where $v_{increment}$ is a small voltage that causes a degree of programming that is appropriate for the granularity of change desired. Thus, the first time step 2303 is performed, i=1, and $v_1$ will be $v_0 + v_{increment}$. Then a verify operation is performed (step 2304), wherein a read operation is performed on the selected cell and the current drawn through the selected cell ($I_{cell}$) is measured. If $I_{cell}$ is less than or equal to $I_{CT}$ (a first threshold value), then search and execute method 2300 is complete and precision programming method 2206 can begin. If $I_{cell}$ is not less than or equal to $I_{CT}$, then step 2303 is repeated, and i is incremented.

Thus, at the point when coarse programming method 2205 ends and precision programming method 2206 begins, the voltage $v_i$ will be the last voltage used to program the selected cell, and the selected cell stores a value associated with the coarse target current value $I_{CT}$. Precision programming method 2206 programs the selected cell to the point where during a read operation it draws desired current value $I_D$ (plus or minus an acceptable amount of deviation, such as 50 pA or less), which is the desired current value $I_D$ that is associated with the value that is intended to be stored in the selected cell.

Figure 24 depicts examples of different voltage progressions that can be applied to the control gate of a selected memory cell during precision program method 2206.

In a first embodiment, increasing voltages are progressively applied to the control gate to further program the selected memory cell. The starting point is $v_i$, which is the last voltage applied during coarse programming method 2205. An increment of $v_{p1}$ is added to $v_1$ and the voltage $v_1 + v_{p1}$ is then used to program the selected cell (indicated by the second pulse from the left in progression 2401). $v_{p1}$ is an increment that is smaller than $v_{increment}$ (the voltage increment used during coarse programming method 2205). After each programming voltage is applied, a verify step (similar to step 2304) is performed, where a determination is made if Icell is less than or equal to $I_{PT1}$ (which is the first precision target current value and here is a second threshold value), where $I_{PT1} = I_D + I_{PT1OFFSET}$, where $I_{PT1OFFSET}$ is an offset valued added to prevent program overshoot. If it is not less than or equal to $I_{PT1}$, then another increment $v_{p1}$ is added to the previously-applied programming voltage, and the process is repeated. At the point where $I_{cell}$ is less than or equal to $I_{PT1}$, then this portion of the programming sequence stops. Optionally, if $I_{PT1}$ is equal to $I_D$, or almost equal to $I_D$ with sufficient precision (meaning an acceptable amount of deviation), then the selected memory cell has been successfully programmed.

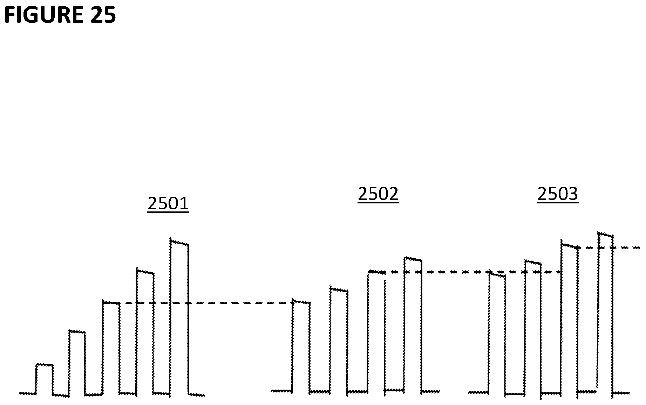

If $I_{PT1}$ is not equal to $I_D$, or almost equal to $I_D$ with sufficient precision, then further programming of a smaller granularity occurs. Here, progression 2402 is now used. The starting point for progression 2402 is the last voltage used for programming under progression 2401. An increment of $V_{p2}$ (which is smaller than $v_{p1}$) is added to that programming voltage, and the combined voltage is applied to program the selected memory cell. After each programming voltage is applied, a verify step (similar to step 2304) is performed, where a determination is made if $I_{cell}$ is less than or equal to $I_{PT2}$ (which is the second precision target current value and here is a third threshold value), where $I_{PT2} = ID + I_{PT2OFFSET}$, and where $I_{PT2OFFSET}$ is an offset value added to prevent program overshoot.. If $I_{cell}$ is not less than or equal to $I_{PT2}$, then another increment $V_{p2}$ is added to the previously-applied programming voltage, and the process is repeated. At the point where $I_{cell}$ is less than or equal to $I_{PT2}$, then this portion of the programming sequence stops. Here, it is assumed that $I_{PT2}$ is equal to $I_D$ or close enough to $I_D$ that the programming can stop, since the target value has been achieved with sufficient precision. One of ordinary skill in the art can appreciate that additional progressions can be applied with smaller and smaller programming increments used if $I_{PT2}$ is not equal to $I_D$ or close enough to $I_D$ that the programming can stop . For example, in Figure 25, three progressions (2501, 2502, and 2503) are applied instead of just two.

A second embodiment is shown in progression 2403. Here, instead of increasing the programming voltage applied during the programming of the selected memory cell, the same programming voltage is applied for durations of increasing period. Instead of adding an incremental voltage such as $v_{p1}$ in progression 2401 and $v_{p2}$ in progression 2403, an additional increment of time $t_{p1}$ is added to the programming pulse such that each applied pulse is longer than the previously-applied pulse by $t_{p1}$. In the example shown, the first pulse has a duration tp0, and the second pulse has a duration $t_{p0} + t_{p1}$. After each programming pulse is applied, the same verify step is performed as described previously for progression 2401. Optionally, additional progressions can be applied where the additional increment of time added to the programming pulse is of a smaller duration than the previous progression used. Although only one temporal progression is shown, one of ordinary skill in the art will appreciate that any number of different temporal progressions can be applied.

Additional detail will now be provided for two additional embodiments of coarse programming method 2205.

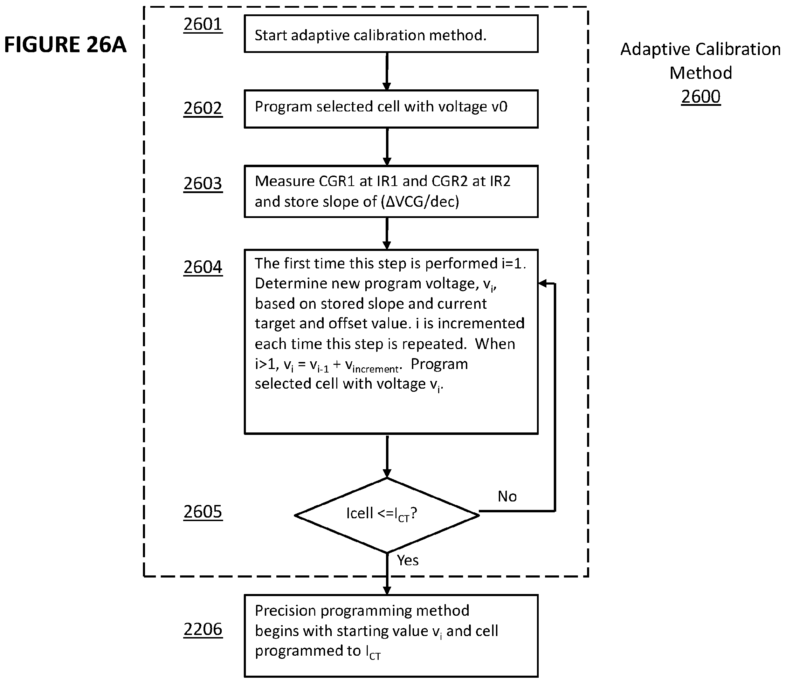

Figure 26A depicts a second embodiment of coarse programming method 2205 (shown in Figures 22A and 22B), which is adaptive calibration method 2600. The method starts (step 2601). The selected cell is programmed at a default start programming voltage value $v_0$ (step 2602). Unlike in search and execute method 2300, here programming voltage value $v_0$ is not derived from a lookup table, or from a function, and instead is a relatively small initial value. The control gate voltage (Vcg) of the cell is measured at a first current value IR1 (e.g., 100na) and at a second current value IR2 (e.g., 10na), and a slope is determined based on those measurements (e.g., 360mV/decade of current) and stored (step 2603).

A new programming voltage, $v_i$, is determined. The first time this step is performed, i=1, and $v_1$ is determined based on the stored slope and a current target value, such as coarse target current value $I_{CT}$, and an offset value using a sub-threshold equation, such as the following:

$$v_i = v_{i-1} + v_{increment},$$

$v_{increment}$ is proportional to slope of Vcg vs. log [Ids/wa*Io] with

$$Vcg = n*Vt*log [Ids/wa*Io]$$

Here, Vcg is the control gate voltage, wa is w of a memory cell, Ids is the current target plus offset value.

If the stored slope value is relatively steep, then a relatively small current offset value can be used. If the stored slope value is relatively flat, then a relatively high current offset value can be used. Thus, determining the slope information allows for a current offset value to be selected that is customized for the particular cell in question. This ultimately makes the programming process shorter. When this step is repeated, i is incremented, and $v_i = v_{i-1} + v_{increment}$. The cell is then programmed using $v_i$. $v_{increment}$ can be determined from a lookup table storing values of $v_{increment}$ vs. current target value, such as coarse target current value $I_{CT}$.

Next, a verify operation occurs, wherein a read operation is performed on the selected cell and the current drawn through the selected cell ($I_{cell}$) is compared with coarse target current value $I_{CT}$ (step 2605). If $I_{cell}$ is less than or equal to coarse target current value $I_{CT}$, where $I_{CT}$ is set = $I_D$ + $I_{CTOFFSET}$, where $I_{CTOFFSET}$ is an offset value added to prevent program overshoot, then adaptive calibration method 2600 is complete and precision programming method 2206 can begin. If $I_{cell}$ is not less than or equal to $I_{CT}$, then steps 2604-2605 are repeated, and i is incremented.

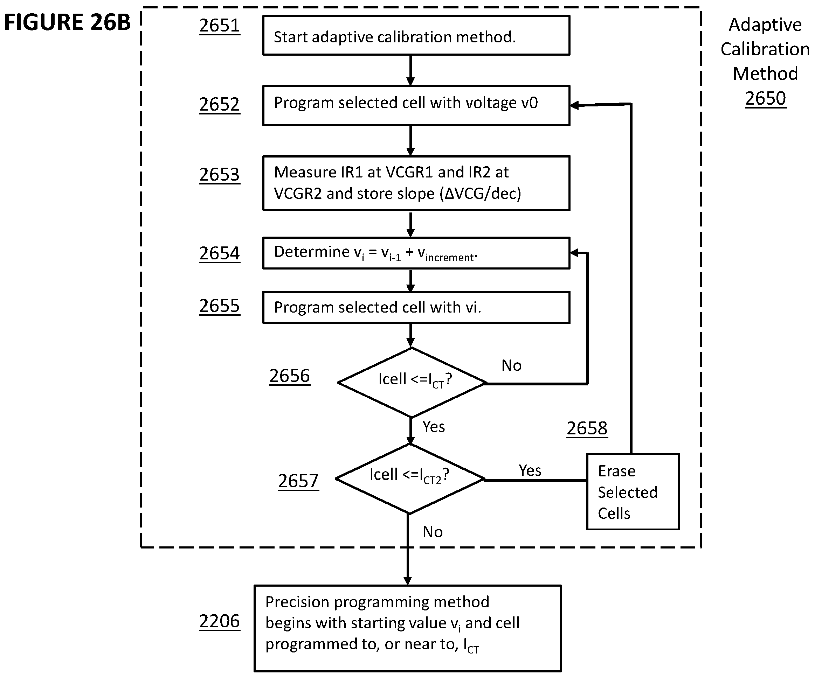

Figure 26B depicts a second embodiment of coarse programming method 2205, which is adaptive calibration method 2650. The method starts (step 2651). The cell is programmed at a default start value $v_0$ (step 2652). $v_0$ is derived from a lookup table created from silicon characterization, where the table value further provides an offset value $I_{CTOFFSET}$ so as not to overshoot the programmed target.

In step 2653 an I-V slope parameter is created which is used in determining the next programming voltage. A first control gate read voltage, $V_{CGR1}$, is applied to the selected cell, and the resulting cell current, $IR_1$, is measured. Then a second control gate read voltage, $V_{CGR2}$, is applied to the selected cell, and the resulting cell current, $IR_2$, is measured. A slope is determined based on those measurements and stored, for example as according to the equation in sub threshold region (cell operating in sub threshold):

$$slope = (V_{CGR1} - V_{CGR2}) / (LOG(IR_1) - LOG(IR_2))$$

(step 2653). Examples of values for $V_{CGR1}$ and $V_{CGR2}$ are 1.5V and 1.3V, respectively.

Determining the slope allows for a $v_{increment}$ value to be selected that is customized for each of the selected cells. This makes the programming process shorter.

When step 2654 is performed, i is incremented, and a new programming voltage, $v_i$, is determined based on the stored slope value and the coarse target current value $I_{CT}$ and an offset value using an equation such as the following:

$$V_i = V_{i-1} + V_{increment},$$

where

$$V_{increment} = alpha* \ slope * (LOG(IR_1) - LOG(I_{CT})),$$

where alpha is a pre-determined constant < 1 (programming offset value) to prevent overshoot, e.g., 0.9.

The cell is then programmed using programming voltage $v_i$ (step 2655). Here, $v_i$ can be applied to the source line terminal, control gate terminal, or erase gate terminal of the selected cell, depending on the programming scheme used.

Next, a verify operation occurs, wherein a read operation is performed on the selected cell and the current drawn through the selected cell ($I_{cell}$) is compared with the coarse target current value $I_{CT}$ (step 2656). If $I_{cell}$ is less than or equal to coarse target current value $I_{CT}$, where coarse target threshold value $I_{CT}$ is set = $I_D$ + $I_{CTOFFSET}$, where $I_{CTOFFSET}$ is an offset value added to prevent program overshoot, then the process proceeds to the step 2657. If not, then the process returns to step 2654 and i is incremented.

In step 2657, $I_{cell}$ is compared against a threshold value, $I_{CT2}$, that is smaller than coarse target current value $I_{CT}$, in order to determine if an overshoot has occurred. That is, although the steps 2654 - 2656 ensure that $I_{cell}$ is below coarse target current value $I_{CT}$, $I_{cell}$ may be too far below coarse target current value $I_{CT}$, i.e. an overshoot has occurred and $I_{cell}$ may represent a stored value that corresponds to the wrong value. If $I_{cell}$ is not less than or equal to $I_{CT2}$, then no overshoot has occurred, and adaptive calibration method 2650 has completed, as which point the process progresses to precision programming method 2206 with starting value $v_i$ and cell programmed to, or near to, coarse target threshold value $I_{CT}$. If $I_{cell}$ is less than or equal to $I_{CT2}$, then an overshoot has occurred and the selected cells are then erased (step 2658), and the programming process starts over at step 2652, this time with a smaller $V_{increment}$ to avoid overshooting again. Optionally, if step 2658 is performed more than a predetermined number of times, the selected cell can be deemed a bad cell that should not be used.

The precision program method 2206 consists of multiple verify and program cycles, in which the program voltage is incremented by a constant fine voltage with a fixed pulse width or in which the program voltage is fixed and the program pulse width is varied or constant for next pulses, as described above in relation to Figures 24 - 25.

Optionally, the step (2656) of determining if the current through the selected non-volatile memory cell during a read or verify operation is less than or equal to the coarse target current value, $I_{CT}$, can be performed by applying a fixed bias to a terminal of the non-volatile memory cell, measuring and digitizing the current drawn by the selected non-volatile memory cell to generate digital output bits, and comparing the digital output bits to digital bits representing the first threshold current value, $I_{CT}$.

Optionally, the step of determining if the current through the selected non-volatile memory cell during a read or verify operation is less than or equal to the coarse target current value, $I_{CT}$, can be performed by applying an input to a terminal of the non-volatile memory cell, modulating the current drawn by the non-volatile memory cell with an input pulse to generate a modulated output, digitizing the modulated output to generate digital output bits, and comparing the digital output bits to digital bits representing the first threshold current, $I_{CT}$.

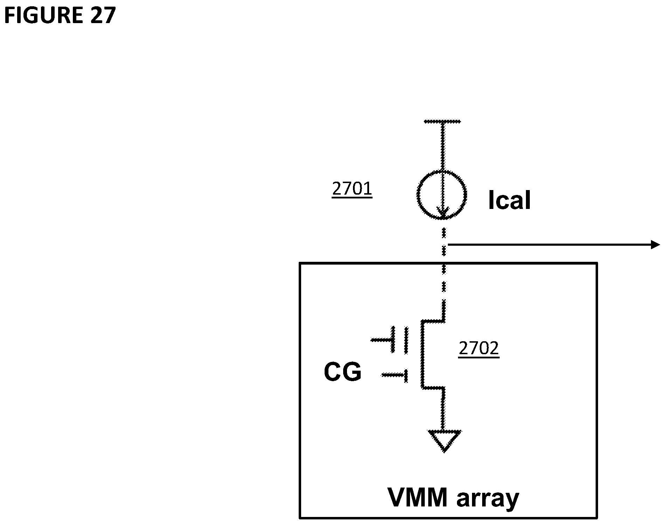

Figure 27 depicts an example circuit implementation for performing a portion of adaptive calibration method 2600. During step 2603, current source 2701 is used to apply the exemplary current values IR1 and IR2 to the selected cell (here, memory cell 2702), and the voltage (CGR1 for IR1 and CGR2 for IR2) at the control gate of memory cell 2702 is then measured. As indicate above, the slope is $(V_{CGR1} - V_{CGR2}) / (LOG(IR_1) - LOG(IR_2))$.

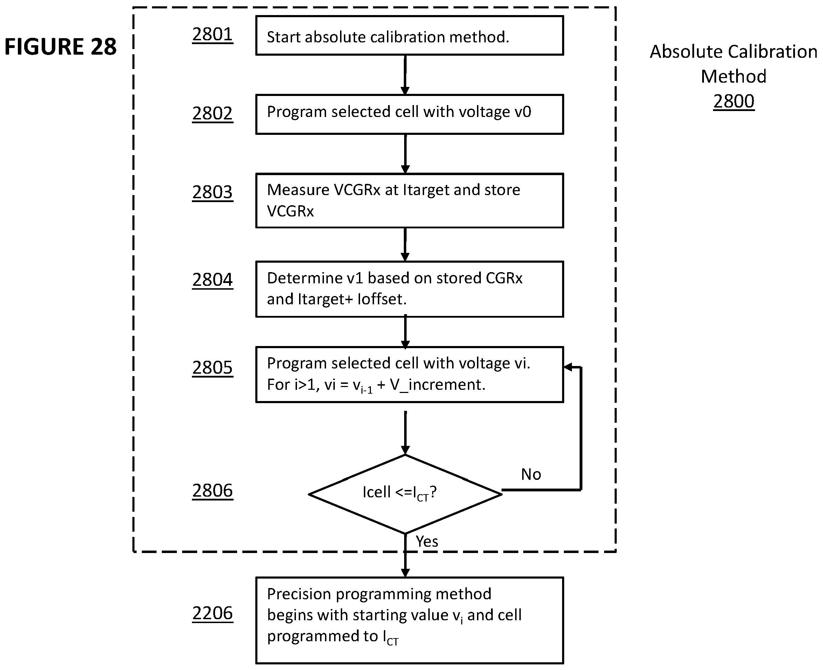

Figure 28 depicts another embodiment of coarse programming method 2205, which is absolute calibration method 2800. The method starts (step 2801). The cell is programmed at a default starting value $v_0$ (step 2802). The control gate voltage of the cell ($V_{CGRx}$) is measured at a current value Itarget (i.e. the final desired value of cell current) and stored (step 2803). A programming voltage, $v_1$, is determined based on the stored control gate voltage and the current value Itarget plus an offset value, Ioffset+Itarget (step 2804). For example, the new programming voltage, $v_1$, can be calculated as follows: $v_1 = v_0 + (V_{CGBIAS} - \text{stored } V_{CGR})$, where $V_{CGBIAS}$ is the default read control gate voltage at a maximum target current (which in one embodiment is ~ 1.5V) and stored $V_{CGR}$ is the measured read control gate voltage of step 2803.

The cell is then programmed using programming voltage $v_i$. When i=1, the voltage $v_1$ from step 2804 is used. When i>=2, the voltage $v_i = v_{i-1} + V_{increment}$ is used. $v_{increment}$ can be determined from a lookup table storing values of $v_{increment}$. vs. current value Itarget. Next, a verify operation occurs, wherein a read operation is performed on the selected cell and the current drawn through the selected cell ($I_{cell}$) is compared with coarse target current value $I_{CT}$ (step 2806). If $I_{cell}$ is less than or equal to coarse target current value $I_{CT}$, then absolute calibration method 2800 is complete and precision programming method 2206 can begin. If $I_{cell}$ is not less than or equal to coarse target current value $I_{CT}$, then steps 2805-2806 are repeated, and i is incremented.

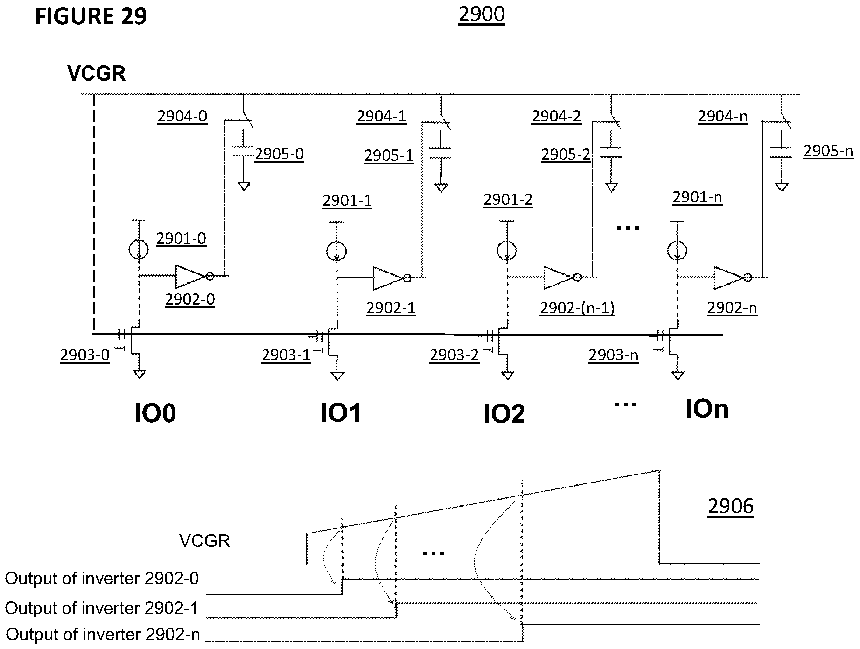

Figure 29 depicts circuit 2900 for implementing step 2803 of absolute calibration method 2800. A voltage source (not shown) generates $V_{CGR}$, which begins at an initial voltage and ramps upward. Here, n+1 different current sources 2901 (2901-0, 2901-1, 2901-2, ..., 2901-n) generate different currents IO0, IO1, IO2, ...IOn of increasing magnitude. Each current source 2901 is connected to a respective inverter 2902 (2902-0, 2902-1, 2902-2, ..., 2902-n) and memory cell 2903 (2903-0, 2903-1, 2903-2, ... 2903-n). As $V_{CGR}$ ramps upward, each memory cell 2903 draws increasing amounts of current, and the input voltage to each inverter 2902 decreases. Because IO0 < IO1 < IO2 <... < IOn, the output of inverter 2902-0 will switch from low to high first as $V_{CGR}$ increases. The output of inverter 2902-1 will switch from low to high next, then the output of inverter 2902-2, and so on, until the output of inverter 2902-n switches from low to high. Each inverter 2902 controls a respective switch 2904 (2904-0, 2904-1, 2904-2, .., 2904-n), such that when the output of inverter 2902 is low, switch 2904 is closed, and when the output of inverter 2902 is high, switch 2904 is open. When inverter 2902 switches from low to high, $V_{CGR}$, which was sampled when switch 2904 is low, is held by the respective capacitor 2905 (2905-0, 2905-1, 2905-2,..., 2905-n). Thus, each respective switch 2904 and capacitor 2905 form a sample-and-hold circuit. The values of IO0, IO1, IO2, ..., IOn are used as possible values of Itarget and the respective sampled voltage is used as the associated value $V_{CGRx}$ in absolute calibration method 2800 of Figure 28. Graph 2906 shows VCGR ramping upward over time, and the outputs of inverters 2902-0, 2902-1, and 2902-n switching from low to high at various times.

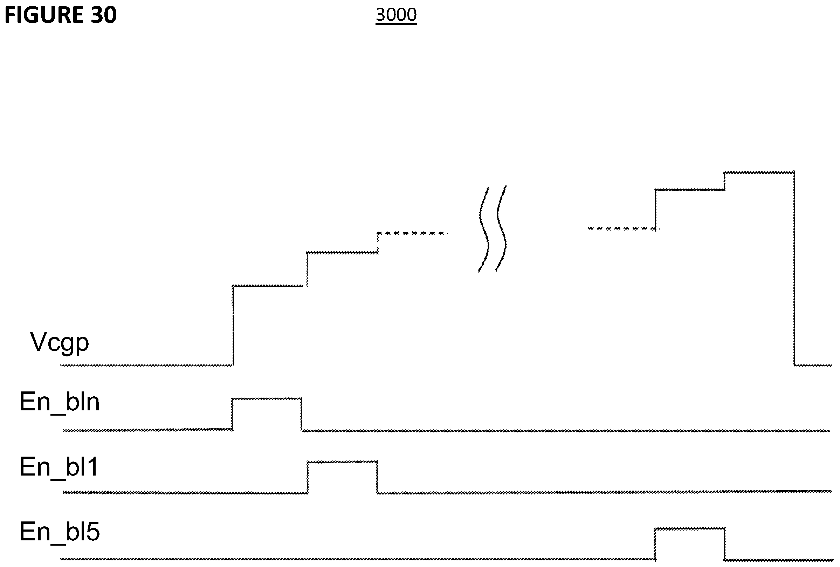

Figure 30 depicts example progression 3000 for programming a selected cell during adaptive calibration method 2600 or absolute calibration method 2800. In one embodiment, the voltage $v_{cgp}$ is applied to the control gates of a selected row of memory cells. The number of selected memory cells in the selected row is for example = 32 cells. Hence, up to 32 memory cells in a selected row can be programmed in parallel. Each memory cell is enabled to couple to a programming current Iprog by a bitline enable signal. If the bitline enable signal is inactive (meaning a positive voltage being applied to selected bitline), the memory cell is inhibited (not being programmed). As shown in Figure 30, bitline enabling signal En_blx (where x varies between 1 and n, where n is the number of bit lines) is enabled at different time with a $v_{cgp}$ voltage level desired for that bitline (hence for selected memory on said bitline). In another embodiment, the voltage applied to the control gate of the selected cell can be controlled using enable signals on the bitline. Each bitline enable signal causes a desired voltage (such as $v_i$ described in Figure 28) corresponding to that bitline to be applied as $v_{cgp}$. The bitline enable signal may also control the programming current flowing into the bitline. In this example, each subsequent control gate voltage $v_{cgp}$ is higher than the previous voltage. Alternatively, each subsequent control gate voltage can be lower or higher than the previous voltage. Each subsequent increment in $v_{cgp}$ can either be equal or not equal to the previous increment.

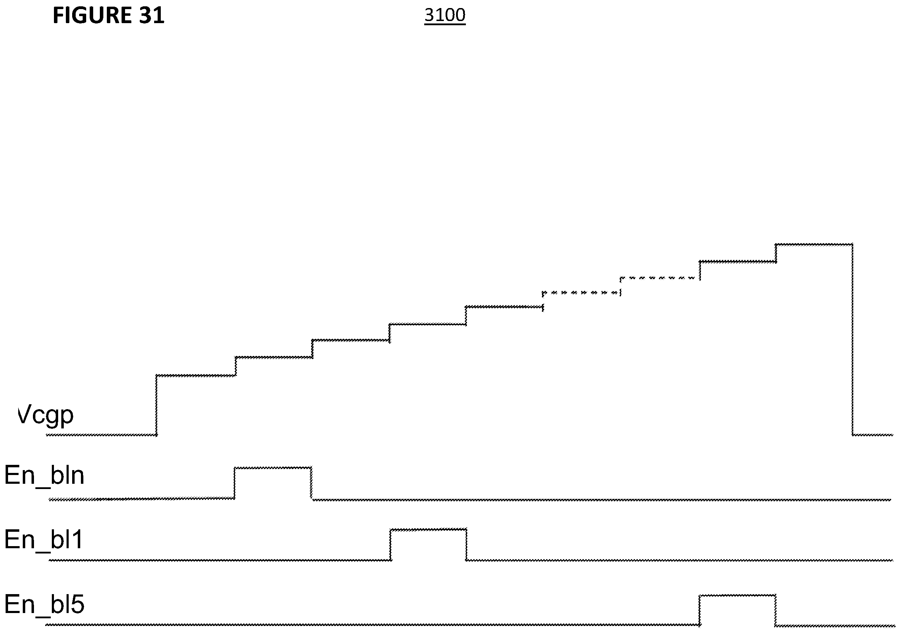

Figure 31 depicts example progression 3100 for programming a selected cell during adaptive calibration method 2600 or absolute calibration method 2800. In one embodiment, a bitline enable signal (e.g. EN_bin, EN_bl1, EN_bl5) _enables the selected bitline (that is, the bitline that is coupled to the selected memory cell) to be programmed with corresponding $V_{cgp}$ voltage level. In another embodiment, the voltage applied to the increment ramping control gate of the selected cell can be controlled using bitline enable signals. Each bitline enable signal causes a desired voltage (such as $v_i$ described in Figure 28) corresponding to that bitline to be applied to the control gate voltage. In this example, each subsequent increment is equal to the previous increment.

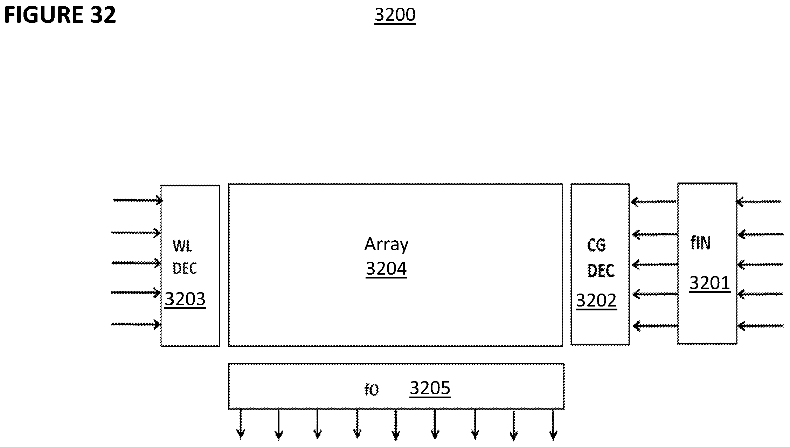

Figure 32 depicts a system for implementing the input and output method for reading or verifying with a VMM array. The input function circuit 3201 receives digital bit values and converts those digital values into an analog signal that is then used to apply a voltage to the control gate of a selected cell in array 3204 that is selected by control gate decoder 3202, word line decoder 3203, and a bit line (not shown) In the embodiments described below, an input is applied to the selected memory cell, which then generates an output current that represents a multiplication operation of the received input and the stored weight, W, in the selected cell. Output neuron circuit block 3205 performs an output action for each column (neuron) of cells in VMM array 3204. The output circuit block 3205 can be implemented using an integrating analog-to-digital converter (ADC), a successive approximation (SAR) ADC, or a Sigma-Delta ADC.

In one embodiment, the digital values provided to input function circuit 3201 comprise four bits (DIN3, DIN2, DIN1, and DINO), meaning that the input can be one of 16 different values. Each of the 16 different combinations of bit values corresponds to different numbers of input pulses to be applied to the control gate of the selected cell, which will then generate an output current representing the multiplication of the input value and the stored weight, W, in that cell. A greater number of pulses will cause a greater output value (current) of the cell. An example of input bit values, DIN[3:0] and the corresponding number of pulses applied to the control gate is shown in Table No. 11:

**Table No. 11: Digital Bit Inputs v. Pulses Generated**

| DIN3 | DIN2 | DIN1 | DIN0 | Pulses Generated |
|------|------|------|------|------------------|
| 0 | 0 | 0 | 0 | 0 |
| 0 | 0 | 0 | 1 | 1 |
| 0 | 0 | 1 | 0 | 2 |
| 0 | 0 | 1 | 1 | 3 |
| 0 | 1 | 0 | 0 | 4 |
| 0 | 1 | 0 | 1 | 5 |
| 0 | 1 | 1 | 0 | 6 |
| 0 | 1 | 1 | 1 | 7 |
| 1 | 0 | 0 | 0 | 8 |
| 1 | 0 | 0 | 1 | 9 |
| 1 | 0 | 1 | 0 | 10 |
| 1 | 0 | 1 | 1 | 11 |
| 1 | 1 | 0 | 0 | 12 |
| 1 | 1 | 0 | 1 | 13 |
| 1 | 1 | 1 | 0 | 14 |
| 1 | 1 | 1 | 1 | 15 |

In the above example, there are a maximum of 16 pulses for 4 bit digital values for reading out the cell value. Each pulse is equal to one unit cell value (current). For example, if Icell unit = 1nA, then for DIN[3-0] = 0001, Icell = 1*1nA = 1nA,; and for DIN[3-0] = 1111, Icell = 15*1nA = 15nA.

In another embodiment, the digital bit input uses digital bit position summation to read out the cell value as shown in Table 12. Here, only 4 pulses are needed to evaluate the 4 bit digital value. For example, a first pulse is used to evaluate DIN0, a second pulse is used to evaluate DIN1, a third pulse is used to evaluate DIN2, and a fourth pulse is used to evaluate DIN3. Then, the results from the four pulses are summed according to bit position. The digital bit summation equation realized is the following: Output =2^0*DIN0 + 2^1*DIN1 + 2^2*DIN2 + 2^3*DIN3)*Icell unit.

For example, if Icell unit = 1nA, then for DIN[3-0] = 0001, Icell total = 0+0+0+1*1nA = 1nA; and for DIN[3-0] = 1111, Icell total = 8*1nA + 4*1nA + 2*1nA + 1*1nA =15nA.

**Table No. 12: Digital Bit Input Summation**

| 2^3*DIN3 | 2^2*DIN2 | 2^1*DIN1 | 2^0*DIN0 | Total values |
|----------|----------|----------|----------|--------------|
| 0 | 0 | 0 | 0 | 0 |
| 0 | 0 | 0 | 1 | 1 |
| 0 | 0 | 2 | 0 | 2 |
| 0 | 0 | 2 | 1 | 3 |

(continued)

| 2^3*DIN3 | 2^2*DIN2 | 2^1*DIN1 | 2^0*DIN0 | Total values |
|---|---|---|---|---|
| 0 | 4 | 0 | 0 | 4 |
| 0 | 4 | 0 | 1 | 5 |
| 0 | 4 | 2 | 0 | 6 |
| 0 | 4 | 2 | 1 | 7 |
| 8 | 0 | 0 | 0 | 8 |
| 8 | 0 | 0 | 1 | 9 |
| 8 | 0 | 2 | 0 | 10 |
| 8 | 0 | 2 | 1 | 11 |
| 8 | 4 | 0 | 0 | 12 |
| 8 | 4 | 0 | 1 | 13 |
| 8 | 4 | 2 | 0 | 14 |
| 8 | 4 | 2 | 1 | 15 |

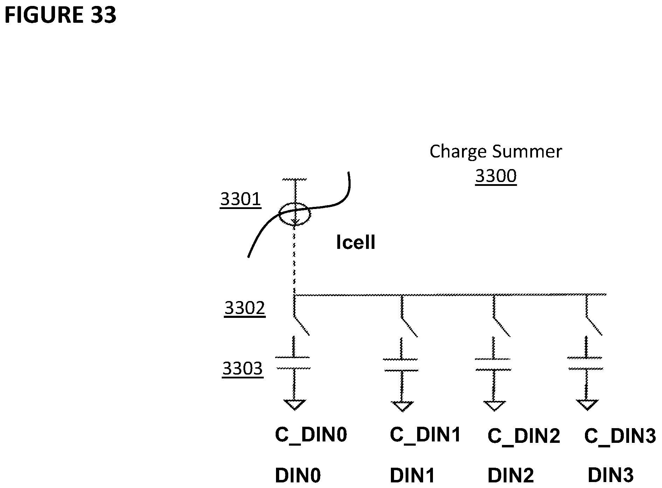

Figure 33 depicts an example of charge summer 3300 that can be used to sum the output of a VMM during a verify or read operation to obtain a single analog value that represents the output, and that can optionally be then converted into digital bit values. Charge summer 3300 comprises current source 3301 and an array of sample-and-hold circuits comprising switches 3302 and sample-and-hold (S/H) capacitors 3303. As shown for an example of a 4-bit digital value, there are 4 S/H circuits to hold the value from 4 evaluation pulses, where the values are summed up at the end of the process. S/H capacitors 3303 are selected with ratios that are associated with the 2^n*DINn bit position for that S/H capacitor; for example C_DIN3 = x8 Cu DIN3 (where Cu is a unit capacitor), C_DIN2 = x4 Cu for bit DIN2, C_DIN1 = x2 Cu for bit DIN1, DIN0 = x1 Cu for bit DIN9. The current source 3301 is also ratioed accordingly.

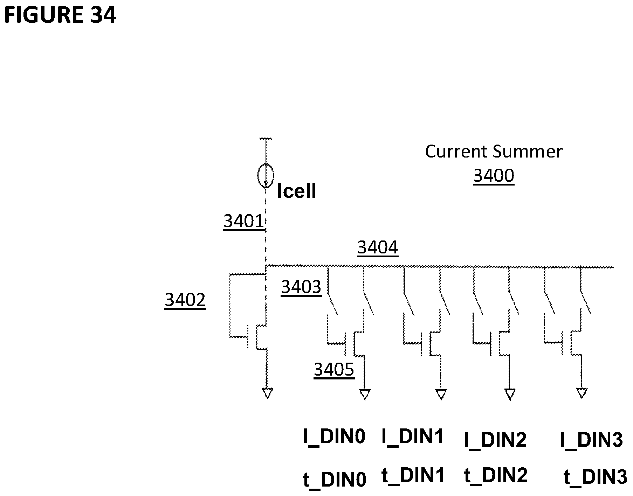

Figure 34 depicts current summer 3400 that can be used to sum the output of a VMM during a verify or read operation. Current summer 3400 comprises current source 3401 (which is Icell, the output of the VMM array), transistor 3402, switch 3403, node 3404, and transistor 3405. In this example, current summer 3400 outputs four digital values on node 3404 in a serial fashion, DIN0, DIN1, DIN2, and DIN3. Four evaluation pulses are input to the VMM array in sequence. During the first pulse, for time period t_DIN0, the switch 3403 corresponding to DIN0 is closed and the other switches 3403 are open. During the second pulse, for time period t_DIN1, the switch 3404 corresponding to DIN1 is closed and the other switches are open. During the third pulse, the switch 3404 corresponding to DIN2 is closed for time period t_DIN2, and the other switches are open. During the fourth pulse, the switch 3404 corresponding to DIN3 is closed, for time period t_DIN3, and the other switches are open. At the end of the process, the values are summed up to generate a digital output, where a weighting process is applied to the DIN values based on the relative bit position of DIN. For example, DOUT can equal 8* I_DIN3 + 4 * I_DIN2, + 2* I_DIN1 + 1*I_DIN0.

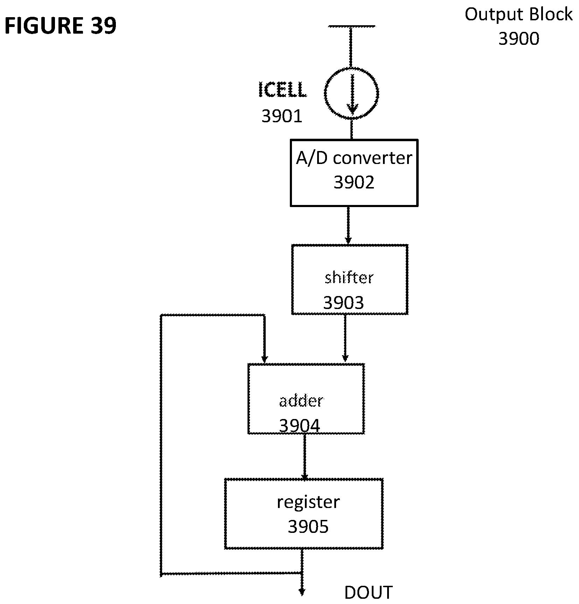

Figure 39 depicts output block 3900 (which is an embodiment of output block 3205 in Figure 32). Output block 3900 receives an output current from a VMM array (such as array 3204 in Figure 32), here shown as ICELL 3901. Output block 3900 comprises D/A converter 3902, shifter 3903, adder 3904, and output register 3905.

Here, it is assumed that the input to the input block (such as input block 3201 in Figure 32) of VMM is DIN[n:0], where n is an input bit binary index number and there are i bits total, where i can range from 1 to n+1. For example, if i= 4, then the input will be four input bits, DIN3, DIN2, DIN1, and DIN0. Each input bit, DINx , is applied to the input block 3201 of VMM 3204 one at a time.

Input block 3201 converts DINx into an input signal (using one of the embodiments described herein or other known techniques) that is applied to a terminal of the selected cell in array 3204 (where the selected cell is selected by word line decoder 3203 and a selected bit line, not shown). In one embodiment, the input signal is a single pulse of variable duration, as shown in Table 13 for an exemplary 4-bit input. The input signal (row input to VMM array) of the pulse TPULSE has a width proportional to the decimal value (0 to 15) of the datain DIN [3:0].

**Table 13. exemplary table for 4-bit input with pulses**

| DIN3 | DIN2 | DIN1 | DIN0 | TPULSE or PULSES |
|---|---|---|---|---|
| 0 | 0 | 0 | 0 | 0 |
| 0 | 0 | 0 | 1 | 1X |

(continued)

| DIN3 | DIN2 | DIN1 | DIN0 | TPULSE or PULSES |
|------|------|------|------|------------------|
| 0 | 0 | 1 | 0 | 2X |
| 0 | 0 | 1 | 1 | 3X |
| 0 | 1 | 0 | 0 | 4X |
| 0 | 1 | 0 | 1 | 5X |
| 0 | 1 | 1 | 0 | 6X |
| 0 | 1 | 1 | 1 | 7X |
| 1 | 0 | 0 | 0 | 8X |
| 1 | 0 | 0 | 1 | 9X |
| 1 | 0 | 1 | 0 | 10X |
| 1 | 0 | 1 | 1 | 11X |
| 1 | 1 | 0 | 0 | 12X |
| 1 | 1 | 0 | 1 | 13X |
| 1 | 1 | 1 | 0 | 14X |
| 1 | 1 | 1 | 1 | 15X |

In another embodiment, the input signal is an analog bias voltage, as shown in Table 14A for an exemplary 4-bit input. The input signal may have 16 voltage levels, for example, linearly spaced for cells operating in a linear region. Alternately, the input signal may be logarithmically spaced (meaning a voltage value is proportional to the log of the cell current) for cells operating in a sub-threshold region, for example $VCGINk = VCGIN(k-1) - (1/n*Vt)* LN \, 2$ for binary current values, VCGIN is the voltage on the corresponding CG terminal.

**Table 14A: Exemplary table for 4-bit input with analog bias level**

| DIN3 | DIN2 | DIN1 | DIN0 | VCGIN |
|------|------|------|------|--------|
| 0 | 0 | 0 | 0 | VCGIN0 |
| 0 | 0 | 0 | 1 | VCGIN1 |
| 0 | 0 | 1 | 0 | VCGIN2 |
| 0 | 0 | 1 | 1 | VCGIN3 |
| 0 | 1 | 0 | 0 | VCGIN4 |
| 0 | 1 | 0 | 1 | VCGIN5 |
| 0 | 1 | 1 | 0 | VCGIN6 |
| 0 | 1 | 1 | 1 | VCGIN7 |
| 1 | 0 | 0 | 0 | VCGIN8 |
| 1 | 0 | 0 | 1 | VCGIN9 |
| 1 | 0 | 1 | 0 | VCGIN10 |
| 1 | 0 | 1 | 1 | VCGIN11 |
| 1 | 1 | 0 | 0 | VCGIN12 |
| 1 | 1 | 0 | 1 | VCGIN13 |
| 1 | 1 | 1 | 0 | VCGIN14 |
| 1 | 1 | 1 | 1 | VCGIN15 |

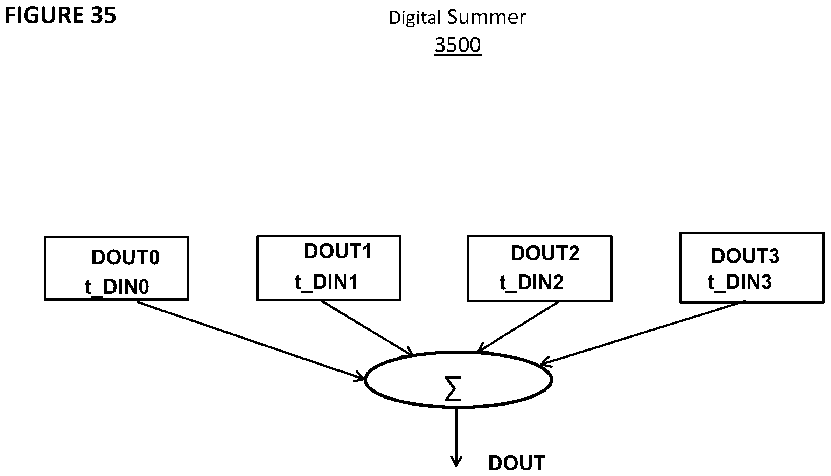

A 4-bit input DIN [3:0] for a particular row will cause one voltage level out of 16 levels (e.g., VCGIN0, ..., or VCGIN15) to be selected and applied to the row of the VMM array. In one embodiment, this operation operates on all four input data bits at the same time, meaning that the four input data bits will be converted into one of 16 possible voltage levels and applied to a row. In an alternative embodiment, the data input bits are applied one at a time in a sequential manner (input bitwise-operation), and the result for each data input is then added (summed) together in an analog domain (Fig 33, Fig 34) or in the digital domain (Fig. 35, Fig 39). Each data input bit can be weighted based on its bit position. For example a "1" in the least significant bit location might cause the voltage VCGIN1 to be applied as an input to a row of the VMM array while a "1" in the most significant bit location might cause the voltage VCGIN8 to be applied as an input to a row of the VMM array, such as by using output block 3900 in Figure 39.

In another embodiment, the input signal to the input block of the array is an exemplary 4-bit input shown in Table 14B for input bit-wise operation (e.g., operation is done for DIN0, then DIN1, then DIN2, then DIN3 input) with a constant analog bias voltage for cells operating in linear or sub-threshold or any regions.

**Table 14B: Exemplary table for 4-bit input with single analog bias level with input bit-wise operation**

| DIN3 | DIN2 | DIN1 | DIN0 | VCGIN |
|---|---|---|---|---|
| 0 | 0 | 0 | 0 | VCGIN1 |
| 0 | 0 | 0 | 1 | VCGIN1 |
| 0 | 0 | 1 | 0 | VCGIN1 |
| 0 | 0 | 1 | 1 | VCGIN1 |
| 0 | 1 | 0 | 0 | VCGIN1 |
| 0 | 1 | 0 | 1 | VCGIN1 |
| 0 | 1 | 1 | 0 | VCGIN1 |
| 0 | 1 | 1 | 1 | VCGIN1 |
| 1 | 0 | 0 | 0 | VCGIN1 |
| 1 | 0 | 0 | 1 | VCGIN1 |
| 1 | 0 | 1 | 0 | VCGIN1 |
| 1 | 0 | 1 | 1 | VCGIN1 |
| 1 | 1 | 0 | 0 | VCGIN1 |
| 1 | 1 | 0 | 1 | VCGIN1 |
| 1 | 1 | 1 | 0 | VCGIN1 |
| 1 | 1 | 1 | 1 | VCGIN1 |

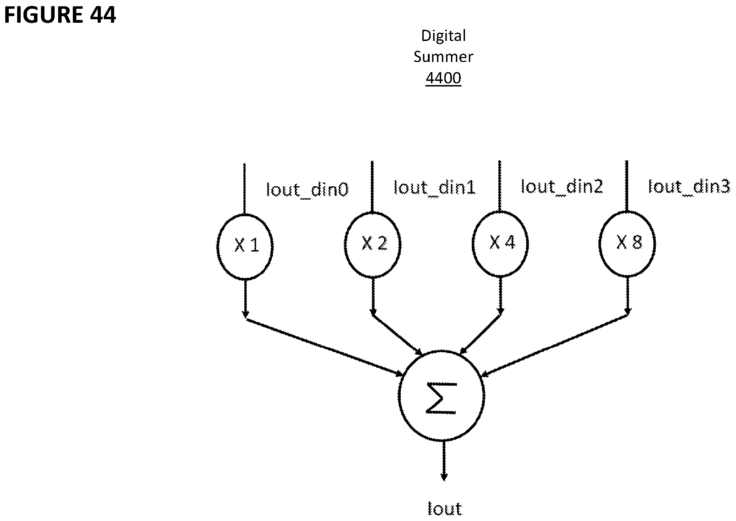

The binary weighted result per input bit DIN is summed together in the analog domain, such as by using a current summer such as the one shown in Figure 34, or in the digital domain, such as by using the embodiments of Figure 35 or Figure 44. Figure 44 depicts digital summer 4400, which the same as digital summer 3500 in Figure 35 except that specific weights have been assigned to each output stream generated in response to an input bit.

In another embodiment, the input signal to the input block of the array is an exemplary 4-bit input as shown in Table 14C for input multibit-wise operation (e.g., DIN3 and DIN2 together, and DIN1 and DIN0 together) with examples of four analog bias levels. In one embodiment four analog levels are linearly spaced for cells operating in linear region, e.g., 0V,.25V,0.5V,1.0 V to ensure linear equal scaling for the output cell currents. In another embodiment the levels are log spaced for cells operating in sub-threshold to ensure linearly scaling for the output cell currents, meaning for example the voltage value is proportional to a log of the current for cells operating in sub threshold region, for example VCGINk = VCGIN(k-1) - (1/n*Vt)* LN 2 for binary current values.

**Table 14C: Exemplary table for 4-bit input with analog bias level with input multibit-wise operation**

| DIN3 | DIN2 | DIN1 | DIN0 | VCGIN10 for DIN[1:0] | VCGIN32 for DIN[3:2] |
|---|---|---|---|---|---|
| 0 | 0 | 0 | 0 | VCGIN0 | VCGIN0 |
| 0 | 0 | 0 | 1 | VCGIN1 | VCGIN0 |
| 0 | 0 | 1 | 0 | VCGIN2 | VCGIN0 |
| 0 | 0 | 1 | 1 | VCGIN3 | VCGIN0 |

EP 4 272 122 B1

(continued)

| DIN3 | DIN2 | DIN1 | DIN0 | VCGIN10 for DIN[1:0] | VCGIN32 for DIN[3:2] |
|---|---|---|---|---|---|
| 0 | 1 | 0 | 0 | VCGIN0 | VCGIN1 |
| 0 | 1 | 0 | 1 | VCGIN1 | VCGIN1 |
| 0 | 1 | 1 | 0 | VCGIN2 | VCGIN1 |
| 0 | 1 | 1 | 1 | VCGIN3 | VCGIN1 |
| 1 | 0 | 0 | 0 | VCGIN0 | VCGIN2 |
| 1 | 0 | 0 | 1 | VCGIN1 | VCGIN2 |
| 1 | 0 | 1 | 0 | VCGIN2 | VCGIN2 |
| 1 | 0 | 1 | 1 | VCGIN3 | VCGIN2 |
| 1 | 1 | 0 | 0 | VCGIN0 | VCGIN3 |
| 1 | 1 | 0 | 1 | VCGIN1 | VCGIN3 |
| 1 | 1 | 1 | 0 | VCGIN2 | VCGIN3 |
| 1 | 1 | 1 | 1 | VCGIN3 | VCGIN3 |

The binary weighted result per multibit DIN [1:0] and DIN [3:2] are summed together in the analog domain (like current summer in Figure 34) or in the digital domain (Figure 35, Figure 39).

In another embodiment, the input signal is a hybrid signal comprising an analog bias voltage component added with a pulse component (analog bias supply modulated pulse), as shown in Table 15 for an exemplary 4-bit input with analog bias supply and pulses. The pulses may be modulated by length (TPULSE) or by number of pulses within a predetermined time period (PULSES):

Table 15: Exemplary table for hybrid input for 4-bit input with analog bias level and pulses

| DIN3 | DIN2 | DIN1 | DIN0 | VCGIN | TPULSE or PULSES |
|---|---|---|---|---|---|
| 0 | 0 | 0 | 0 | VCGIN1 | 0X |
| 0 | 0 | 0 | 1 | VCGIN1 | 1X |
| 0 | 0 | 1 | 0 | VCGIN1 | 2X |
| 0 | 0 | 1 | 1 | VCGIN1 | 3X |
| 0 | 1 | 0 | 0 | VCGIN1 | 4X |
| 0 | 1 | 0 | 1 | VCGIN1 | 5X |
| 0 | 1 | 1 | 0 | VCGIN1 | 6X |
| 0 | 1 | 1 | 1 | VCGIN1 | 7X |
| 1 | 0 | 0 | 0 | VCGIN2 | 4X |
| 1 | 0 | 0 | 1 | VCGIN2 | 4.5X |
| 1 | 0 | 1 | 0 | VCGIN2 | 5X |
| 1 | 0 | 1 | 1 | VCGIN2 | 5.5X |
| 1 | 1 | 0 | 0 | VCGIN2 | 6X |
| 1 | 1 | 0 | 1 | VCGIN2 | 6.5X |
| 1 | 1 | 1 | 0 | VCGIN2 | 7X |
| 1 | 1 | 1 | 1 | VCGIN2 | 7.5X |

In the above table, a value of "4.5X" means a pulse with a width equal to 4.5 times the width of a 1X pulse, or 4 1X pulses plus a pulse with half the width of a 1X pulse.

The input data is partitioned into multiple input data-in sets, with each data-in set being assigned to a particular voltage bias level For example for an 8-bit input DIN [7:0], a first row supply VCGIN1 is applied for input bits in the set DIN

25

[3:0], and a second row supply VCGIN2, different than VCGIN1, is applied for input bits in the set DIN [7:4]. In this exemplary embodiment of a two binary input set partition, the analog bias supply VCGIN2 (for the second data-in set DIN [7:4]) produces a cell current that is 2x the cell current that is produced by the analog bias supply VCGIN1 (for the first data-in set DIN [3:0]). For example, the ratio of VCGIN2/VCGIN1 can be 2x for cells operating in linear region. Because a different VCGIN voltage is applied for each data-in set, the same number of pulses with the same periods can be applied for a member of data-in set DIN[7:4] and a member of data-in set DIN[3:0], as the difference in VCGIN will differentiate the two members.

In a variation of this embodiment, two partitions can be used for each input data-in set, where each partition corresponds to a different analog bias voltage, meaning that four different voltages VCGIN1, VCGIN2, VCGIN3, and VCGIN4 are used. This can further reduce the number/period of pulses needed. That is, four different data-in values can use the same number/period of pulses, as the difference in VCGIN will differentiate the four different values. members.

With reference again to Figure 39, output block 3900 receives the output current, ICELL, from VMM in response to the input DINx. D/A converter 3902 converts ICELL into digital form, DOUT [m:0], that represents the digital value of the output generated in response to DINn, where each DOUT_n is a set of one or more output bits.

Shifter 3903, adder 3904, and register 3905 operate to apply a different weight to each output, DOUT[m:0]_n, that is generated in response to each input bit, DINn. In a simple example where n=4, shifter 3902, adder 3904, and register 3905 perform the following actions:

(1) in response to DIN0, shifter 3903 receives DOUT_0[m:0]0 and does not shift it, to yield the result of (1);
(2) in response to DIN1, shifter 3903 receives DOUT_1[m:0] and shifts it one bit to the left, and adder 3904 adds the shifted result to the result of (1) to yield the result of (2);
(3) in response to DIN2, shifter 3903 receives DOUT_2[m:0] and shift it two bits to the left, and adder 3904 adds the shifted result to the result of (2) to yield the result of (3);
(4) in response to DIN3, shifter 3903 receive DOUT_3[m:0] and shift it three bits to the left, and adder 3904 adds the shifted result to the result of (3) to yield the result of (4), the final result DOUT[m:0]

In the case the DIN [n:0] inputs are combined with an analog voltage level to represent for the binary weight of each data input, only adding is needed, without shifting for such a hybrid input bitwise-operation. Output register 3905 stores and outputs the result of (4) as DOUT.

Additional Input and Output Circuits

Figure 35 depicts digital summer 3500, which receives a plurality of digital values, sums them together, and generates an output DOUT representing the sum of the inputs. Digital summer 3500 can be used during a verify or read operation. Figure 35 depicts an example of a 4-bit digital value comprising bits DOUT0, DOUT1, DOUT2, and DOUT3. Each bit is generated from an evaluation input pulse. Each bit can be weighted based on its bit position, where a weight, t_DINn, of $2^n$ is applied to bit DINn. For example, DOUT3 can be multiplied by $2^3$ (=8), DOUT2 can be multiplied by $2^2$ (=4), DOUT1 can be multiplied by $2^1$ (=2), and DOUT0 can be multiplied by $2^0$ (=1).

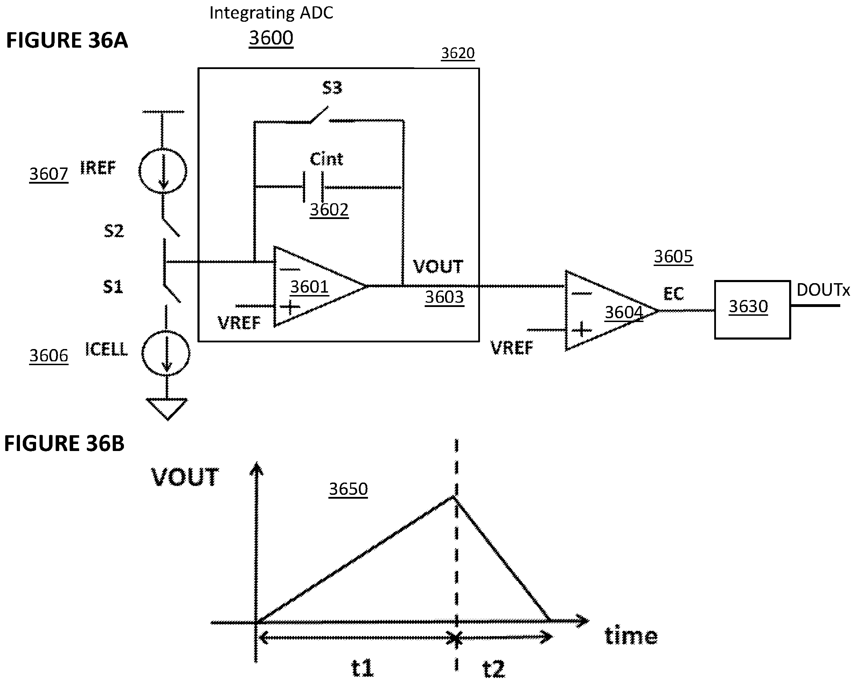

Figure 36A shows an integrating dual-slope ADC 3600 applied to an output neuron to convert the array cell current into digital output bits DOUTx. An integrator consisting of integrating op-amp 3601 and integrating capacitor 3602 integrates a cell current ICELL versus a reference current IREF. As shown in Figure 36B, during a fixed time t1 (integration time) , the cell current is up integrated (VOUT rises), and then a reference current is applied and down integrated for a time t2 (VOUT falls, de-integration time). The current Icell is = t2/t1* IREF. For example, for t1, for a 10 bit digital bits resolution, 1024 cycles are used, and the cycle number for t2 varies from 0 to 1024 cycles depending on the Icell value. Digital counter 3630, enabled by the signal EC, is used to generate digital output bits DOUTx during the t2 period.

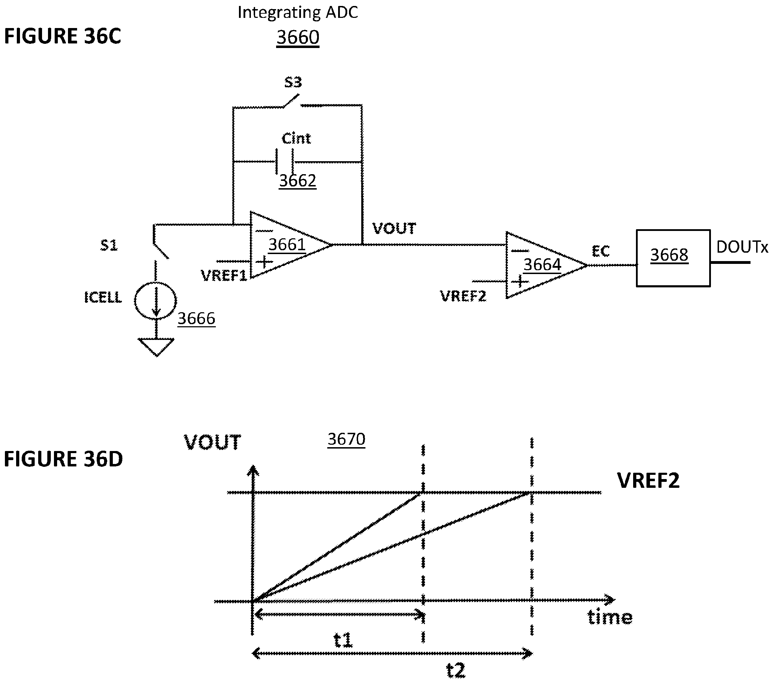

Figure 36C shows integrating single slope ADC 3660 applied to an output neuron to convert the array cell current into digital output bits. An integrator consisting of integrating op-amp 3661, integrating capacitor 3662, switch S3, and comparator 3664 integrates a array cell current ICELL 3666 and generates an output signal EC.

As shown in Figure 36D, graph 3670 shows that during a time t1, a cell current ICELL1 is up integrated (VOUT rises until it reaches VREF2, which corresponds to a change in value of EC in Figure 36C), and during time t2, another cell current ICELL2 is up integrated. The cell current ICELL = Cint*VREF2/t, where t is the time that elapses before EC changes value. Pulse counter 3668, enabled by the signal EC, is used to count the number of pulses during integration time t, and the number of pulses represents the digital output value DOUTx.

In the example shown, the digital output for t1 will be less than the digital output for t2 since the count for t1 will be less than the count for t2, which also means that the cell current ICELL1 during time period t1 was larger than the cell current ICELL2 during time period t2. . An initial calibration is done to calibrate the integrating capacitor 3662 value with a reference current Iref and a fixed time Tref, Cint = Tref*Iref/VREF2.

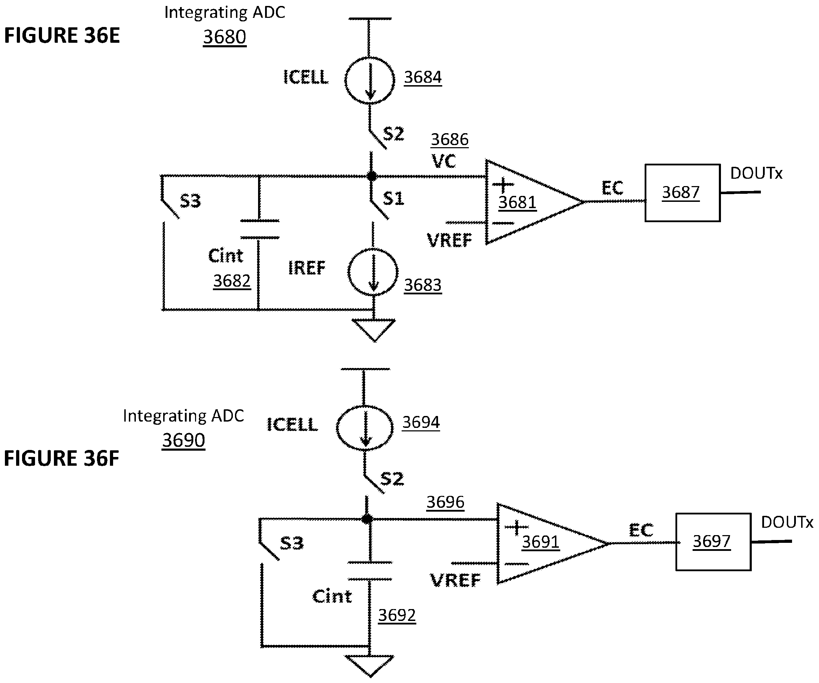

Figure 36E shows integrating dual slope ADC 3680 comprising ICELL 3684, comparator 3681, switch S1, switch S2, switch S3, capacitor 3682, and reference current source 3683. Integrating dual slope ADC 3680 receives output neuron current (ICELL 3684) and generates output EC. The integrating dual slope ADC 3680 does not utilize an integrating op-amp. The cell current or the reference current is integrated directly on the capacitor 3682. A pulse counter 3687, enabled by the signal EC, is used to count pulses during integration time, where the integration time ends when EC changes value. The output of the pulse counter is a digital output DOUTx representing ICELL. The current ICELL is = t2/t1* IREF.

Figure 36F shows integrating single slope ADC 3690 comprising ICELL 3694, comparator 3691, switch S2, switch S3, and capacitor 3692. Integrating single sloped ADC 3690 receives output neuron current (ICELL 3694) and generates output EC. The integrating single slope ADC 3690 does not utilize an integrating op-amp. The cell current is integrated directly on the capacitor 3692. A pulse counter 3697, enabled by the signal EC, is used to count digital output pulses during integration time, where the integration time ends when EC changes value. The output of the pulse counter is a digital output DOUTx representing ICELL. The cell current ICELL = Cint*VREF2/t.

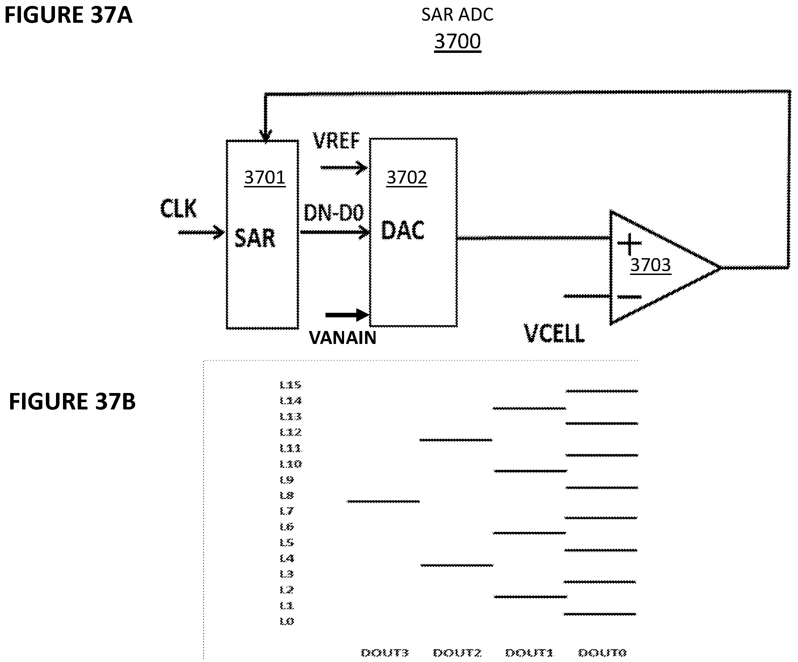

Figure 37A shows a SAR (Successive Approximation Register) ADC 3700 applied to an output neuron to convert a cell (array) current into digital output bits. Cell current can be dropped across a resistor to convert into a VCELL. Alternatively, the cell current can be used to charge up a S/H capacitor to convert into a VCELL. A binary search is used to compute the bit starting from MSB bit (most significant bit). Basing on the digital bits from SAR 3701, DAC 3702 is used to set an appropriate analog reference voltage to comparator 3703. The output of the comparator 3703 is fed back to SAR 3701 to choose the next analog level. As shown in Figure 37B, for the example of 4-bit digital output bits, there are 4 evaluation periods: a first pulse to evaluate DOUT3 by setting an analog level half-way, then a second pulse to evaluate DOUT2 by setting an analog level half-way of the top-half or half-way of the bottom-half. DOUT3 and DOUT4 similarly divide the ranges in half. Another embodiment can use SAR CDAC (charge re-distribution CDAC) to convert a neuron current into digital output bits.

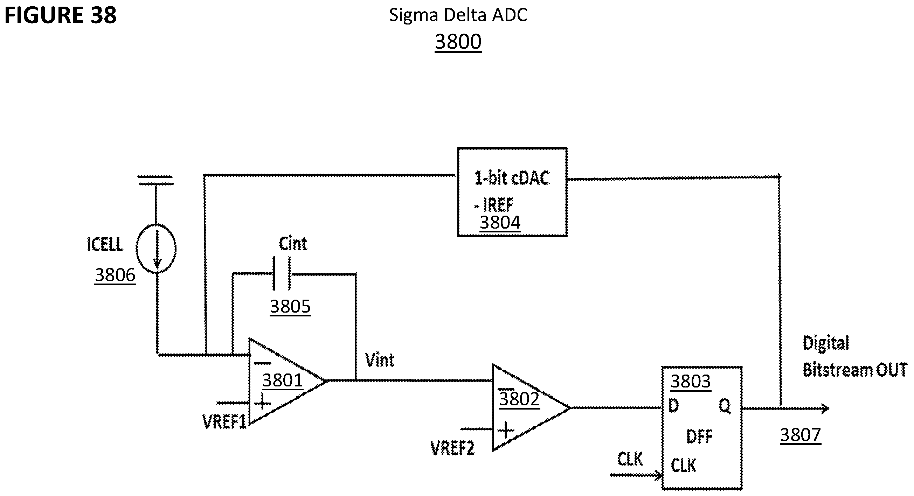

Figure 38 shows sigma delta ADC 3800 applied to an output neuron to convert a cell current into digital output bits. An integrator consisting of op-amp 3801 and capacitor 3805 integrates the summation of current from a selected cell current and a reference current resulting from 1-bit current DAC 3804. A comparator 3802 compares the integrated output voltage versus a reference voltage. The clocked DFF 3803 provides digital output streams depending on the output of the comparator 3802. The digital output stream typically goes to a digital filter before outputting digital output bits.

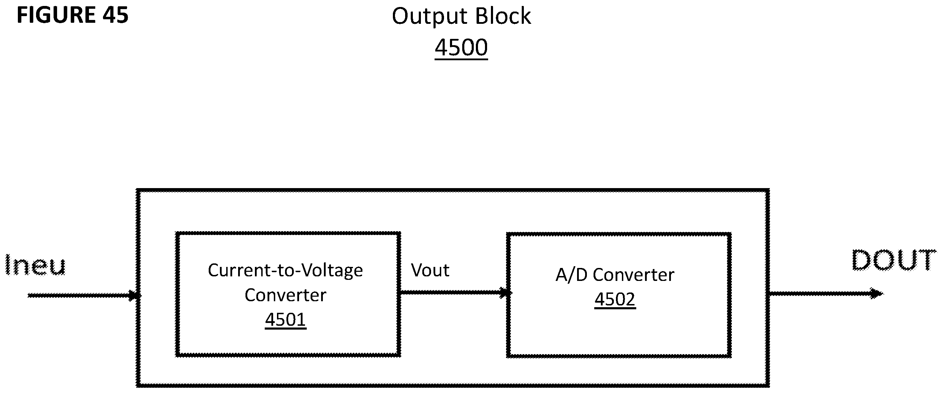

Figure 45 depicts output block 4500. Output block 4500 comprises current-to-voltage converter 4501 and analog-to-digital converter 4502. Output block 4500 receives output current from the VMM array, here shown as Ineu, where the output current represents the output value from the VMM array for the read or verify operation being performed. Current-to-voltage converter 4501 converts the output current Ineu into a voltage signal, here shown as VOUT, such that the voltage VOUT represents the output current Ineu from the VMM. A/D converter 4502 converts voltage VOUT into digital form and outputs a digital output, here shown as DOUT.

In one implementation of output block 4500, current-to-voltage converter 4501 receives a sequence of currents from one or more selected non-volatile memory cells in the array in response to a sequence of inputs and converts the sequence of currents into a sequence of voltages. A/D converter then converts a sequence of voltages received from current-to-voltage converter 4501 into a plurality of output bits, wherein the plurality of output bits is generated based upon a weighted sum of the sequence of voltages.

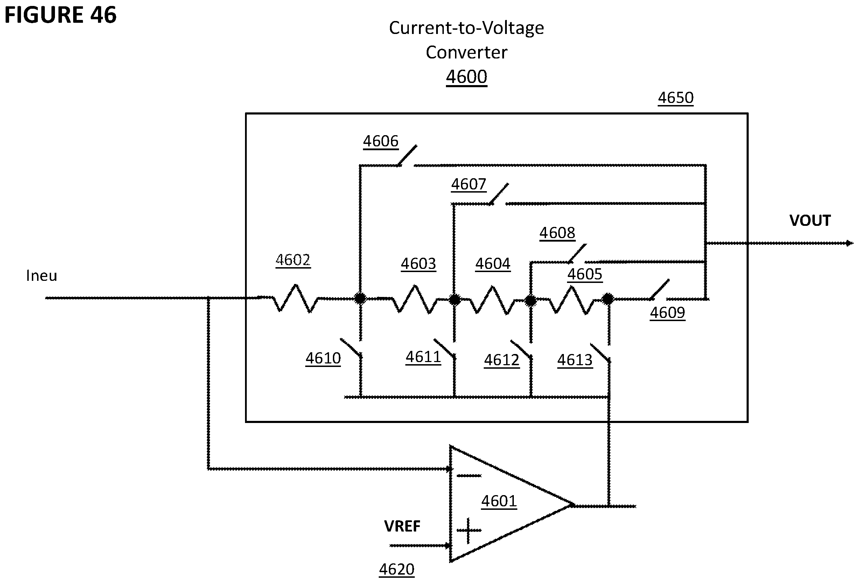

Figure 46 depicts a loss-less (no I*Rmux drop) current-to-voltage converter 4600, which is an embodiment of current-to-voltage converter 4501 in Figure 45. Current-to-voltage converter 4600 comprises operational amplifier 4601; resistors 4602, 4603, 4604, and 4605; and switches 4606, 4607, 4608, 4609, 4610, 4611, 4612, and 4613. A loss-less variable resistor unit consists of a resistor and two switches (mux), e.g., resistor 4602 and switches 4610 and 4606, where one switch carries current (switch 4610) and one switch does not carry current (switch 4606), and the output is taken from the switch that does not carry current.

Current-to-voltage converter 4600 receives current Ineu and outputs voltage VOUT. Notably, VOUT can be measured without suffering a voltage drop, due to muxing (I*R drop of the switches) in output voltage VOUT, meaning that the output voltage is sampled outside of the feedback loop or the current loop. For example, when switches 4613 and 4609 are closed (on) and the other switches are open (off), VOUT is equal to VREF + (R4602 + R4603 + R4604 + R4605)*(Ineu). As another example, when switches 4610 and 4606 are closed (on) and the other switches are open (off), VOUT is VREF + (R4602*Ineu). After the current Ineu is converted to a voltage VOUT, the voltage VOUT can be sampled and held by opening all switches. The voltage VOUT in this case references to reference level VREF.

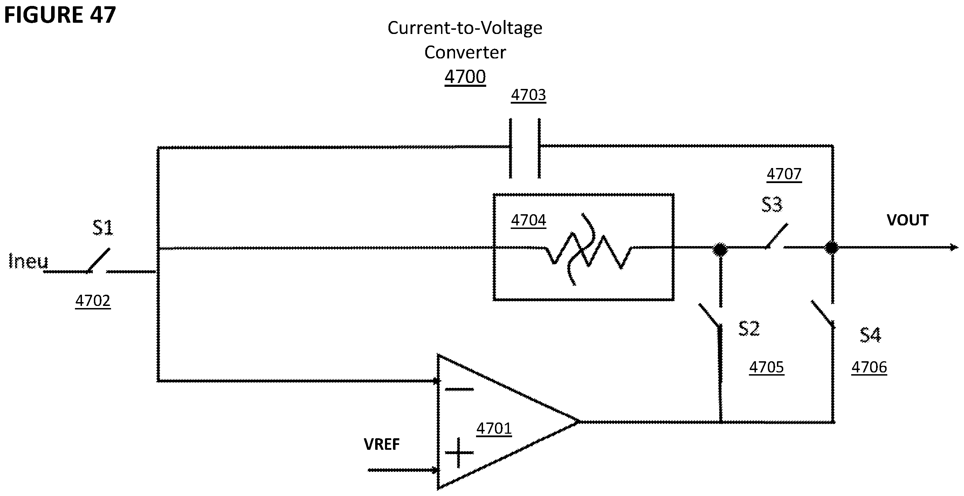

Figure 47 depicts current-to-voltage converter 4700, which is an embodiment of current-to-voltage converter 4501 in Figure 45. Current-to-voltage converter 4700 comprises comparator 4701; switches 4702, 4705, 4706 and 4707; S/H (sample and hold) capacitor 4703; and variable resistor 4704. Current-to-voltage converter 4700 receives current Ineu and outputs S/H voltage VOUT. Loss-less variable resistor 4704 is similar to resistor 4650 in Figure 46. During the current to voltage conversion, the current Ineu flows through the resistor 4704 to generate an output voltage = R4704*Ineu, the S1 (4702), S2 (4705) and S3 (4707) are closed (on) and S4 (4706) is open-ed (off), the output VOUT is = R4704*Ineu since S3 does not carry current. During the hold period, S4 is closed (on) and S1, S2 and S3 are open-ed (off), the VOUT is held on the capacitor 4703. Notably, VOUT can be measured without suffering a voltage drop because VOUT is measured (enabled) outside of the switches that carry current.

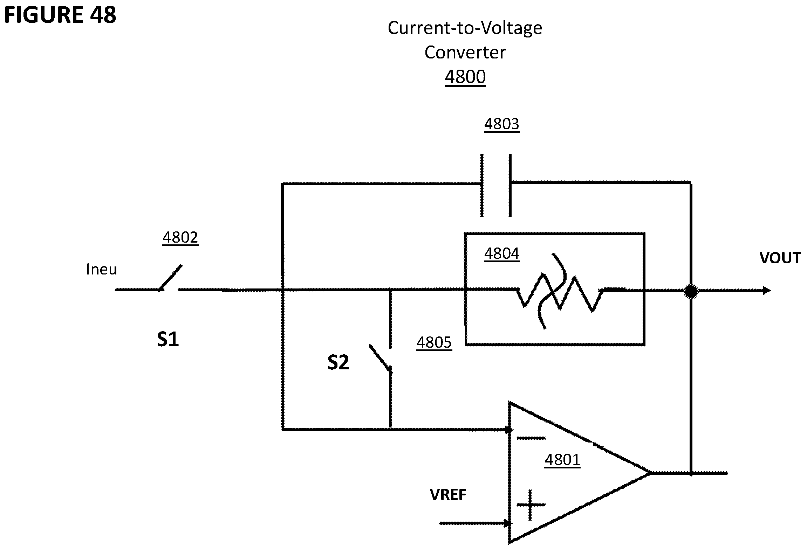

Figure 48 depicts current-to-voltage converter 4800, which is an embodiment of current-to-voltage converter 4501 in Figure 45. Current-to-voltage converter 4800 comprises operational amplifier 4801; switches 4802 and 4805; S/H capacitor 4803; and variable resistor 4804. Current-to-voltage converter 4800 receives current Ineu and outputs voltage VOUT. Notably, VOUT can be measured without voltage drop due to VOUT is measured (enabled) outside of the switches (muxes) that carry current.. During the current to voltage conversion, the current Ineu flows through the resistor 4804 to generate an output voltage = R4804*Ineu, the S1 (4802) and S2 (4805) are closed (on), the output VOUT is = R4804*Ineu since S2 does not carry current. During the hold period, S1 and S2 are open-ed (off), the VOUT is held on the capacitor 4803 The S/H voltage VOUT in this case references to ground level.

Alternatively, the current-to-voltage converter 4700 and 4800 does not contain variable resistor 4704 or 4804, in which case Ineu charges up S/H capacitor 4703 or 4803 by a variable signal pulse enabling switch 4702 or 4802 controlled by a pre-determined trimmable timing pulse value, where the timing pulse value is selected based on the Ineu dynamic current range. In this case the S/H capacitor can be a variable capacitor with trimmable capacitance values.

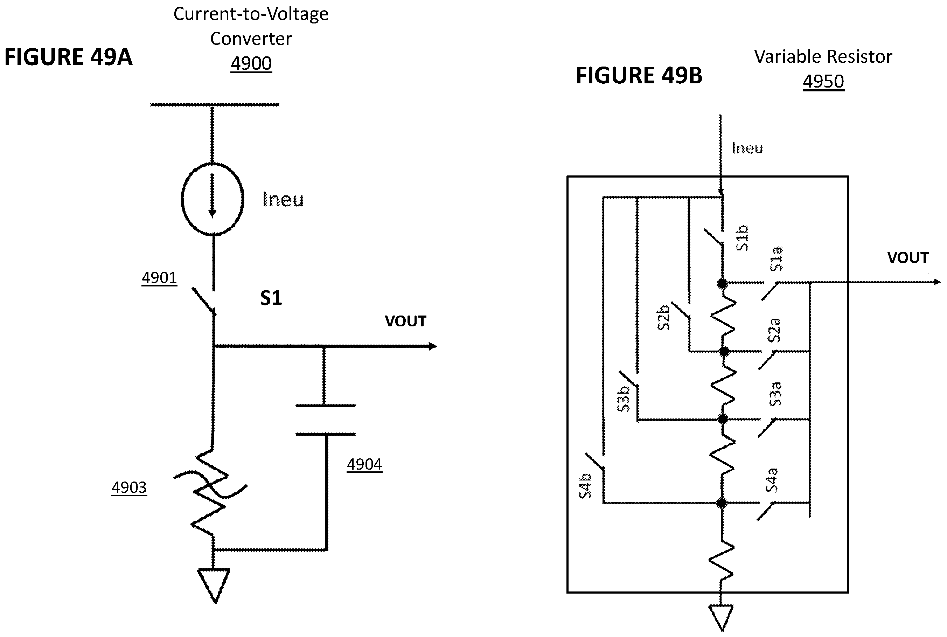

Figure 49A depicts current-to-voltage converter 4900, which is an embodiment of current-to-voltage converter 4501 in Figure 45. Current-to-voltage converter 4900 comprises switches 4901 and 4902; variable resistor 4903; and capacitor 4904. Current-to-voltage converter 4800 receives current Ineu and outputs voltage VOUT. During the current to voltage conversion, the current Ineu flows through the variable resistor 4903 to generate an output voltage = R4903*Ineu, the S1 (4901) closed (on), the output VOUT is = R4804*Ineu. During the hold period, S1 open-ed (off), the VOUT is held on the capacitor 4904, and the switches (muxes) inside the variable resistor 4903 (for example S1a/S2a/S3a/S4a in the variable resistor 4950 in Figure 49B) are also opened (off). Notably, VOUT can be measured without suffering voltage drop due to VOUT is measured (enabled ) outside of the switches (muxes) that carry current.

Figure 49B depicts variable resistor 4950 as used in 4903. Variable resistor 4950 comprises switches S1a, S2a, S3a, S4a, S1b, S2b, S3b, and S4b.

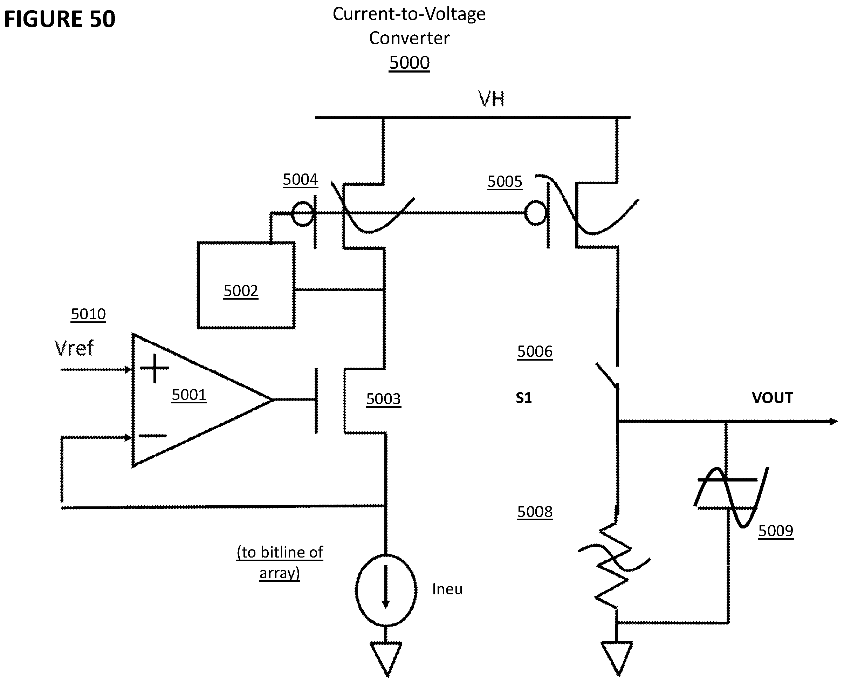

Figure 50 depicts current-to-voltage converter 5000, which is an embodiment of current-to-voltage converter 4501 in Figure 45. Current-to-voltage converter 5000 comprises operational amplifier (op amp) 5001; level shifter 5002 (gate of transistor 5004 = drain of transistor 5004 - Voffset); NMOS transistor 5003, PMOS transistors 5004 and 5005; switches 5006 and 5007; variable resistor 5008 (which may be implemented as described above in relation to Fig. 49B); capacitor 5009; and voltage source VH. Current-to-voltage converter 5000 receives current Ineu and outputs voltage VOUT. Notably, VOUT can be measured similarly (as in Figure 49) without suffering voltage drop. The S/H voltage VOUT in this case references to ground level. The op amp 5001 and transistor 5003 forces a fixed bias voltage VREF 5010 on the bitline of the array during read operation. The PMOS transistor 5004 and 5005 serves as a variable ratio current mirror to mirror the array output current (Ineu) into the variable resistor 5008 and S/H capacitor 5009. Alternatively current-to-voltage converter 5000 does not contain variable resistor 5008, in which case the mirrored Ineu charges up S/H capacitor 5009 by a variable signal pulse enabling switch 5006 controlled by a pre-determined trimmable timing pulse value, where the timing pulse value is selected based on the Ineu dynamic current range. In this case the S/H capacitor can be a variable capacitor with trimmable capacitance values.

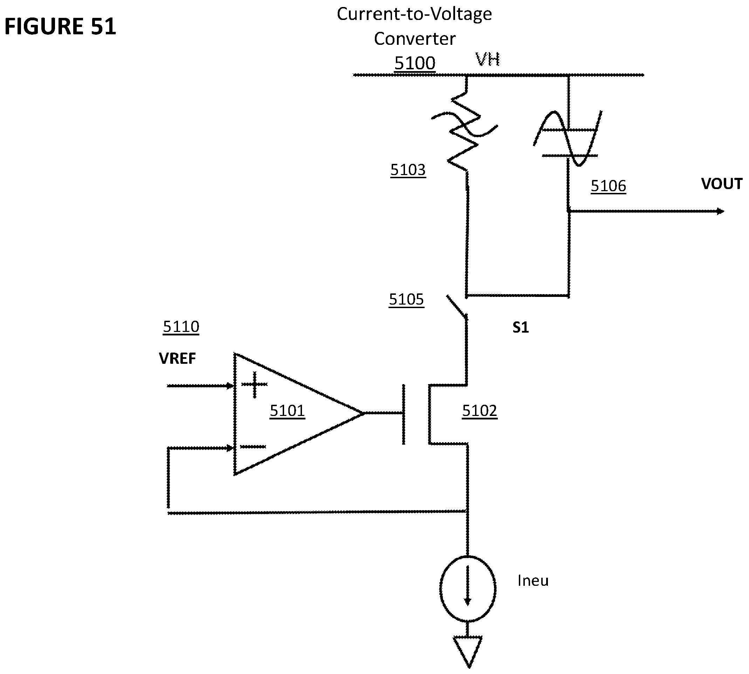

Figure 51 depicts current-to-voltage converter 5100, which is an embodiment of current-to-voltage converter 4501 in Figure 45. Current-to-voltage converter 5100 comprises operational amplifier 5101; NMOS transistor 5102, variable resistor 5103 (which may be implemented as described above in relation to Fig. 49B); switches 5104 and 5105; capacitor 5106; and voltage source VH. Current-to-voltage converter 5100 receives current Ineu and outputs voltage VOUT. Notably, VOUT can be measured without suffering voltage drop similarly as in Figure 50 The S/H voltage VOUT in this case references to a high power supply VH. The op amp 5101 and transistor 5102 serves to force a fixed bias VREF 5110 on the bitline during read operation. Alternatively, the current-to-voltage converter 5100 does not contain variable resistor 5103, in which case Ineu discharges S/H capacitor 5106 through a variable signal pulse enabling switch 5106 controlled by a pre-determined trimmable pulse timing value, where the timing value is selected based on the Ineu dynamic current range. In this case the S/H capacitor can be a variable capacitor with trimmable capacitance values.

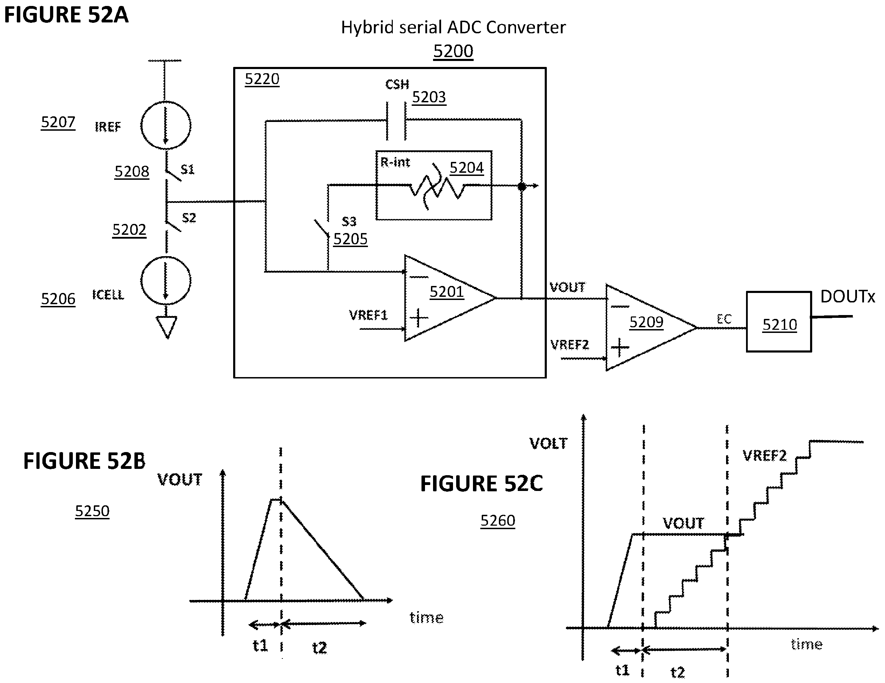

Figure 52A depicts hybrid serial analog-to-digital converter 5200 which utilizes the loss-less current to voltage converter 4800 described above in relation to Figure 48. It consists of current to voltage converter 5220, comparator 5209, current sources 5206 and 5207, and switches S1 and S2. Current to voltage converter 5220 may instead be implemented using any of the current to voltage converters described above in Fig. 46, 47,49, 50, and 51. Current to voltage converter 5220 comprises operational amplifier 5201, switch 5205, variable resistor 5204 and sample and hold capacitor 5203.

Figure 52B shows a timing diagram 5250 of an operation of the hybrid serial ADC converter 5200 in which during time period t1, the current ICELL 5206 is converted into voltage VOUT by closing switch 5202 (S2) while maintaining switch 5208 (S1) open and then held by the capacitor 5203 by opening switch 5202 (S2). During the period t2 IREF 5207 is enabled by closing switch 5208 (S1) to begin the de-integration period, meaning the counting period, during which time, denoted as t2, clock pulses (not shown) are counted by pulse counter 5210, as long a EC is high, which is translated into the digital bits DOUT, i.e. the number of counts. The digital counter and clock and control logic to convert the comparator output EC into digital bits is not shown.

Figure 52C shows another a timing diagram 5250 of an operation of the hybrid serial ADC converter 5200, in which t1 period is same as that of the Figure 52B. During time period t2, voltage VOUT is translated into digital bits DOUT by ramping the reference voltage VREF2 from a reference level such as VREF1 to its maximum level. During the time period t2, a digital counter (not shown) counts pluses, and the output of the digital counter is the output DOUT. The time period t2 ends when VREF2 exceeds VOUT, which will result in the value of EC changing in Figure 52A.

It should be noted that, as used herein, the terms "over" and "on" both inclusively include "directly on" (no intermediate materials, elements or space disposed therebetween) and "indirectly on" (intermediate materials, elements or space disposed therebetween). Likewise, the term "adjacent" includes "directly adjacent" (no intermediate materials, elements or space disposed therebetween) and "indirectly adjacent" (intermediate materials, elements or space disposed there between), "mounted to" includes "directly mounted to" (no intermediate materials, elements or space disposed there between) and "indirectly mounted to" (intermediate materials, elements or spaced disposed there between), and "electrically coupled" includes "directly electrically coupled to" (no intermediate materials or elements there between that electrically connect the elements together) and "indirectly electrically coupled to" (intermediate materials or elements there between that electrically connect the elements together). For example, forming an element "over a substrate" can include forming the element directly on the substrate with no intermediate materials/elements therebetween, as well as forming the element indirectly on the substrate with one or more intermediate materials/elements there between.

## Claims

1. A system (3200) comprising:

   a vector-by-matrix multiplication array (3204) in an artificial neural network, the array comprising a plurality of non-volatile memory cells;
   an input block (3201) to receive a digital input comprising n+1 bits (DIN[n:0]), to apply the digital input to the array one bit at a time by converting the bit into an analog input signal and applying the analog input signal to a row of non-volatile memory cells in the array, wherein a "1" for the bit is converted into an analog input signal with a voltage whose magnitude depends on the bit location of the bit in the digital input; and
   an output block (3205, 3900) to receive an output current from the array in response to each analog input signal applied to the array and to combine the output currents to form an output (DOUT[m:0]), the output block comprising:

      an analog-to-digital converter (3902) to generate a digital value (DOUT_n) in response to each analog input signal applied to the array; and
      an adder (3904) to add the digital values from the analog-to-digital converter to generate the output (DOUT[m:0]);
      a register (3905) to store the output (DOUT[m:0]).

2. The system of claim 1, wherein the non-volatile memory cells are split-gate flash memory cells.

3. The system of claim 1, wherein the non-volatile memory cells are stacked-gate flash memory cells.

## Patentansprüche

1. System (3200), umfassend:

   ein Vektor-mal-Matrix-Multiplikationsarray (3204) in einem künstlichen neuronalen Netzwerk, das Array umfassend eine Vielzahl von nichtflüchtigen Speicherzellen;
   einen Eingabeblock (3201), um eine digitale Eingabe zu empfangen, umfassend n+1 Bits (DIN[n:0]), um die digitale Eingabe an das Array Bit für Bit durch Umwandeln des Bits in ein analoges Eingabesignal und Anlegen des analogen Eingabesignals an eine Reihe von nichtflüchtigen Speicherzellen in dem Array anzulegen, wobei eine "1" für das Bit in ein analoges Eingabesignal mit einer Spannung umgewandelt wird, deren Größe von der Bitposition des Bits in der digitalen Eingabe abhängt; und
   einen Ausgabeblock (3205, 3900), um einen Ausgabestrom von dem Array als Reaktion auf jedes analoge Eingabesignal, das an das Array angelegt wird, zu empfangen und um die Ausgabeströme zu kombinieren, um eine Ausgabe (DOUT[m:0]) auszubilden, der Ausgabeblock umfassend:

einen Analog-Digital-Wandler (3902), um einen digitalen Wert (DOUT_n) als Reaktion auf jedes analoge Eingabesignal, das an das Array angelegt wird, zu erzeugen; und
einen Addierer (3904), um die digitalen Werte von dem Analog-Digital-Wandler zu addieren, um die Ausgabe (DOUT[m:0]) zu erzeugen;
ein Register (3905), um die Ausgabe (DOUT[m:0]) zu speichern.

2. System nach Anspruch 1, wobei die nichtflüchtigen Speicherzellen Split-Gate-Flash-Speicherzellen sind.

3. System nach Anspruch 1, wobei die nichtflüchtigen Speicherzellen Stacked-Gate-Flash-Speicherzellen sind.

**Revendications**

1. Système (3200) comprenant :

un réseau de multiplication vecteur-matrice (3204) dans un réseau neuronal artificiel, le réseau comprenant une pluralité de cellules de mémoire non volatile ;
un bloc d'entrée (3201) pour recevoir une entrée numérique comprenant n+1 bits (DIN[n:0]), pour appliquer l'entrée numérique à la matrice un bit à la fois en convertissant le bit en un signal d'entrée analogique et en appliquant le signal d'entrée analogique à une rangée de cellules de mémoire non volatile dans la matrice, dans lequel un "1" pour le bit est converti en un signal d'entrée analogique avec une tension dont l'ampleur dépend de l'emplacement du bit dans l'entrée numérique ; et
un bloc de sortie (3205, 3900) pour recevoir un courant de sortie de la matrice en réponse à chaque signal d'entrée analogique appliqué à la matrice et pour combiner les courants de sortie pour former une sortie (DOUT [m:0]), le bloc de sortie comprenant :

un convertisseur analogique-numérique (3902) pour générer une valeur numérique (DOUT_n) en réponse à chaque signal d'entrée analogique appliqué au réseau ; et
un additionneur (3904) pour ajouter les valeurs numériques du convertisseur analogique-numérique afin de générer la sortie (DOUT[m:0]) ;
un registre (3905) pour stocker la sortie (DOUT[m:0]).

2. Procédé selon la revendication 1, dans lequel les cellules de mémoire non volatile sont des cellules de mémoire flash à grille divisée.

3. Procédé selon la revendication 1, dans lequel les cellules de mémoire non volatile sont des cellules de mémoire flash à grille superposée.

FIG. 1
(Prior Art)

# FIGURE 2 (PRIOR ART)

Memory Cell
210

# FIGURE 3 (PRIOR ART)

Memory Cell
310

EP 4 272 122 B1

**FIGURE 4 (PRIOR ART)**

Memory Cell
410

EP 4 272 122 B1

# FIGURE 5 (PRIOR ART)

Memory Cell
510

EP 4 272 122 B1

# FIGURE 6

**CB1**

Different sets of weights

Activation function applied here.

**S1:**
16 15x15
Feature Maps

**Input (S0):**
32x32-pixel,
RGB
5 bit values

Shared weights

**C1:**
16 Feature Maps,
30x30 pixels each

**P1**

**CB2**

**CB2**
Scans maps in S1
With 4x4 filters,
Filter shift = 1 pixel

**C2:**
22 12x12
Feature Maps

**P2**

Activation function applied here:

**S2:**
22 6x6
Feature Maps

**C3**
64 neurons

**CB3**

**Output (S3):**
10 neurons,
highest output neuron
determines class

**CB4**

EP 4 272 122 B1

# FIGURE 7

EP 4 272 122 B1

# FIGURE 8

EP 4 272 122 B1

FIGURE 9

EP 4 272 122 B1

**FIGURE 10**

# FIGURE 11

**1100**

**1114**

**1101** REF W ARRAY

**1103** W ARRAY

**1102** REF W ARRAY

WLA0 WLB0  WLA1 WLB1  WLA2 WLB2  WLA3 WLB3

VBLR  BLAR  VBLR  BLAR  VBLR  BLAR2  VBLR  BLAR3

SLRA0

SL0

SL1

SLRB0

BLBR0  BLBR1  BLBR2  BLBR3

VBLR  VBLR  VBLR  VBLR

BL0  BL1  BL2  BL3

EP 4 272 122 B1

**FIGURE 12**

1200

1201   1203   1202

REF W ARRAY   W ARRAY   REF W ARRAY

1205 1204   1212   1108

1106
1107

1209

FIGURE 13

**1300**

**1301**

**1303**

**1302**

EP 4 272 122 B1

EP 4 272 122 B1

**FIGURE 14 (PRIOR ART)**

LSTM
1400

$h_0$      $h_1$      $h_2$      $h_3$

| Cell 1401 | $c_0$ | Cell 1402 | $c_1$ | Cell 1403 | $c_2$ | Cell 1404 |

$x_0$      $x_1$      $x_2$      $x_3$

**FIGURE 15 (PRIOR ART)**

LSTM Cell
1500

C (t-1)

cell state
vector at
time t-1

output
state
vector at
time t-1

h (t-1)

x (t)

input
vector at
time t

1506

1509

1507

tanh
1505

1508

σ
1501

σ
1502

tanh
1504

σ
1503

C (t)

cell state
vector at
time t

h (t)

output
vector at
time t

EP 4 272 122 B1

FIGURE 16

LSTM Cell
1600

# FIGURE 17

**LSTM Cell**
**1700**

**FIGURE 18 (PRIOR ART)**

GRU
1800

EP 4 272 122 B1

FIGURE 19 (PRIOR ART)

**GRU Cell**
**1900**

**1906**   **1907**

h (t-1)                                                                h (t)

output
vector at                                                           output
time t-1                                                            vector at
                                                                    time t

**1904**
r (t)                   **1908**

                        1.                **1905**

z (t)
                                          h^ (t)
**1901**   **1902**                        **1903**

σ          σ          tanh

input
vector at
time t

x (t)

EP 4 272 122 B1

FIGURE 20

GRU Cell

**2000**

r (t) * h (t-1)

**1901**

Ur
VMM

**2001**

Wr
VMM

**2001**

σ    **2002**

r (t)

**1902**

Uz
VMM

**2001**

Wz
VMM

**2001**

σ    **2002**

z (t)

**1903**

Uh
VMM

**2001**

Wh
VMM

**2001**

tanh    **2002**

h^ (t)

h (t-1)

x (t)

**1904**

**1908**

1-z (t)

**1906**

**1905**

z (t) * h (t-1)

**1907**

h (t)

EP 4 272 122 B1

50

FIGURE 21

**1901, 1902, 1903**

**GRU Cell**
**2100**

h (t-1)

r(t)*h (t-1)

x (t)

Ur
Uz
Uh

VMM **2101**

Wr
Wz
Wh

VMM **2101**

σ , tanh **2102**

**2109**

1-

1-z(t)

r (t)
z(t)
h^ (t)

×

**2103**

h(t-1)
h(t-1)
1-z(t)

**MUX**
**2104**

h(t-1) * r(t)        **2106**

h(t-1) * z(t)        **2107**

h^(t) * 1-z(t)       **2108**

**2105**

+        h(t)

EP 4 272 122 B1

**FIGURE 22A**

2201 — Start

Programming
Method
2200

2202 — All cells programmed to '0' state.

2203 — All cells erased to intermediate level.

2204 — Hard programming performed on unselected or zero w cells to remove all positive charge.

2205 — Coarse programming method performed on selected cells.

2206 — Precision programming method performed on the selected cells.

EP 4 272 122 B1

**FIGURE 22B**

Programming
Method
2210

2201 — Start

2212 — All cells erased to '1' state.

2213 — All cells programmed to an intermediate level.

2204 — Hard programming performed on un-used or zero w cells to remove all charge.

2205 — Coarse programming method performed on selected cells.

2206 — Precision programming method performed on selected cells.

EP 4 272 122 B1

**FIGURE 23**

2205

Search and Execute
Method
2300

2301 — Perform lookup table search or perform a predetermined function to identify coarse target current value ($I_{CT}$) for selected cell

2302 — Program selected cell with voltage $v_0$

2303 — Program selected cell with voltage $v_i = v_{i-1} + v_{increment}$, where i starts at 1 and increments each time step 2303 repeated

2304 — $I_{cell} <= I_{CT}$?

2206 — Precision programming method begins with starting value $v_i$ and cell programmed to $I_{CT}$

FIGURE 24

**FIGURE 25**

2501  2502  2503

**FIGURE 26A**

Adaptive Calibration
Method
2600

2601 — Start adaptive calibration method.

2602 — Program selected cell with voltage v0

2603 — Measure CGR1 at IR1 and CGR2 at IR2 and store slope of ($\Delta$VCG/dec)

2604 — The first time this step is performed i=1. Determine new program voltage, $v_i$, based on stored slope and current target and offset value. i is incremented each time this step is repeated. When i>1, $v_i = v_{i-1} + v_{increment}$. Program selected cell with voltage $v_i$.

2605 — Icell <=$I_{CT}$?  No  Yes

2206 — Precision programming method begins with starting value $v_i$ and cell programmed to $I_{CT}$

**FIGURE 26B**

Adaptive
Calibration
Method
2650

2651 — Start adaptive calibration method.

2652 — Program selected cell with voltage v0

2653 — Measure IR1 at VCGR1 and IR2 at VCGR2 and store slope ($\Delta$VCG/dec)

2654 — Determine $v_i = v_{i-1} + v_{increment}$.

2655 — Program selected cell with vi.

2656 — Icell $<= I_{CT}$?  No

Yes

2657 — Icell $<= I_{CT2}$?  Yes

No

2658 — Erase Selected Cells

2206 — Precision programming method begins with starting value $v_i$ and cell programmed to, or near to, $I_{CT}$

FIGURE 27

EP 4 272 122 B1

**FIGURE 28**

Absolute Calibration Method 2800

2801 Start absolute calibration method.

2802 Program selected cell with voltage v0

2803 Measure VCGRx at Itarget and store VCGRx

2804 Determine v1 based on stored CGRx and Itarget+ Ioffset.

2805 Program selected cell with voltage vi. For i>1, vi = $v_{i-1}$ + V_increment.

2806 Icell <=$I_{CT}$?   No

Yes

2206 Precision programming method begins with starting value $v_i$ and cell programmed to $I_{CT}$

EP 4 272 122 B1

FIGURE 29

2900

VCGR

IO0         IO1         IO2     ···    IOn

2906

VCGR

Output of inverter 2902-0

Output of inverter 2902-1

Output of inverter 2902-n

EP 4 272 122 B1

**FIGURE 30**

3000

Vcgp

En_bln

En_bl1

En_bl5

FIGURE 31

3100

Vcgp

En_bln

En_bl1

En_bl5

EP 4 272 122 B1

**FIGURE 32**

3200

fIN
3201

CG
DEC
3202

WL
DEC
3203

Array
3204

fO
3205

# FIGURE 33

Charge Summer
3300

3301

Icell

3302

3303

C_DIN0    C_DIN1    C_DIN2    C_DIN3

DIN0      DIN1      DIN2      DIN3

EP 4 272 122 B1

# FIGURE 34

Current Summer
3400

Icell

3401

3404

3402

3403

3405

I_DIN0   I_DIN1   I_DIN2   I_DIN3

t_DIN0   t_DIN1   t_DIN2   t_DIN3

EP 4 272 122 B1

**FIGURE 35**

Digital Summer
3500

EP 4 272 122 B1

**FIGURE 36A**

Integrating ADC
3600

3620

3607 IREF

S2

S1

3606 ICELL

S3

Cint
3602

3601

VREF

VOUT

3603

VREF

3604

3605

EC

3630

DOUTx

**FIGURE 36B**

VOUT

3650

t1

t2

time

**FIGURE 36C**

Integrating ADC
3660

S3

Cint
3662

S1

3661

VREF1

ICELL

3666

VOUT

3664

VREF2

EC

3668

DOUTx

**FIGURE 36D**

VOUT

3670

VREF2

t1

t2

time

EP 4 272 122 B1

**FIGURE 36E**

Integrating ADC
3680

ICELL 3684

S2

3686
VC

S3

Cint
3682

IREF

S1

3683

+
3681
−

VREF

EC

3687

DOUTx

Integrating ADC
3690

ICELL 3694

**FIGURE 36F**

S2

3696

S3

Cint
3692

+
3691
−

VREF

EC

3697

DOUTx

EP 4 272 122 B1

**FIGURE 37A**

**FIGURE 37B**

# FIGURE 38

Sigma Delta ADC
3800

**FIGURE 39**

Output Block
3900

ICELL
3901

A/D converter
3902

shifter
3903

adder
3904

register
3905

DOUT

EP 4 272 122 B1

73

FIGURE 40

**4000**

EP 4 272 122 B1

# FIGURE 41

EP 4 272 122 B1

# FIGURE 42

_4200_

# FIGURE 43

EP 4 272 122 B1

**FIGURE 44**

Digital
Summer
4400

Iout_din0   Iout_din1   Iout_din2   Iout_din3

( X 1 )   ( X 2 )   ( X 4 )   ( X 8 )

( Σ )

Iout

**FIGURE 45**

Output Block
4500

Ineu →

Current-to-Voltage
Converter
4501

Vout →

A/D Converter
4502

→ DOUT

**FIGURE 46**

Current-to-Voltage Converter
4600

4650

VOUT

Ineu

4602
4603
4604
4605

4606
4607
4608
4609

4610
4611
4612
4613

4601

VREF
4620

FIGURE 47

Current-to-Voltage Converter 4700

VOUT

S4 4706

S3 4707

S2 4705

4703

4704

4701

VREF

S1

Ineu 4702

**FIGURE 48**

Current-to-Voltage
Converter
4800

4803

4802

Ineu

S1

4804

VOUT

S2

4805

4801

VREF

EP 4 272 122 B1

## FIGURE 49B

Variable Resistor
4950

## FIGURE 49A

Current-to-Voltage
Converter
4900

FIGURE 50

Current-to-Voltage
Converter
5000

EP 4 272 122 B1

**FIGURE 51**

# FIGURE 52A

Hybrid serial ADC Converter
5200

5220

CSH
5203

R-int   5204

5207  IREF

5208   S1

5202   S2

S3
5205

5206  ICELL

5201

VOUT

VREF1

5209

VREF2

EC

5210

DOUTx

EP 4 272 122 B1

86

# FIGURE 52B

VOUT

5250

t1    t2

time

# FIGURE 52C

VOLT

VREF2

VOUT

5260

t1    t2

time

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 63133270
- US 21935221
- US 20200233482 A1
- US 20200349421 A1
- US 2005220185 A1

- US 594439
- US 5029130 A
- US 6747310 B
- US 826345

### Non-patent literature cited in the description

- MINT: Mixed-Precision RRAM-Based IN-Memory Training Architecture. **JIANG HONGWU et al.** 2019 IEEE INTERNATIONAL SYMPOSIUM ON CIRCUITS AND SYSTEMS (ISCAS). IEEE, 12 October 2020, 1-5